(19) Europäisches Patentamt
European Patent Office
Office européen des brevets

(11) **EP 4 411 782 A2**

(12) **EUROPEAN PATENT APPLICATION**

(43) Date of publication:
**07.08.2024 Bulletin 2024/32**

(51) International Patent Classification (IPC):
***H01J 37/20*** *(2006.01)*

(21) Application number: **24182655.1**

(22) Date of filing: **29.04.2021**

(52) Cooperative Patent Classification (CPC):
**H01J 37/28; H01J 37/20; H01J 37/265;**
H01J 2237/20285; H01J 2237/20292;
H01J 2237/2487; H01J 2237/31767

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.05.2020 DE 102020206739**

(62) Document number(s) of the earlier application(s) in accordance with Art. 76 EPC:
**21722823.8 / 4 158 674**

(71) Applicant: **Carl Zeiss MultiSEM GmbH**
**73447 Oberkochen (DE)**

(72) Inventors:
• **Zeidler, Dirk**
**73447 Oberkochen (DE)**
• **Bihr, Ulrich**
**73447 Oberkochen (DE)**

• **Adolf, Andreas**
**73447 Oberkochen (DE)**
• **Kaufmann, Nicolas**
**73447 Oberkochen (DE)**
• **Müller, Ingo**
**73447 Oberkochen (DE)**
• **Behnke, Michael**
**73447 Oberkochen (DE)**

(74) Representative: **Tesch-Biedermann, Carmen**
**Athene Patent**
**Hanns-Schwindt-Straße 11**
**81829 München (DE)**

Remarks:
This application was filed on 17.06.2024 as a divisional application to the application mentioned under INID code 62.

(54) **HIGH THROUGHPUT MULTI-BEAM CHARGED PARTICLE INSPECTION SYSTEM WITH DYNAMIC CONTROL**

(57) A multi-beam charged-particle beam system comprising: a movable stage configured to hold a sample; an object irradiation unit configured to illuminate a surface of the sample with a plurality of focus spots of a plurality of primary charge particle beamlets; a charged particle beam generator, configured for generating a plurality of primary charged-particle beamlets from a charged-particle source; a stage sensor configured for determining a lateral displacement or a rotation of the stage; an image sensor configured for determining a lateral displacement of a line of sight of the object irradiation unit; and a control unit configured for generating and applying at least an additional voltage signal to a first beam deflector in the object irradiation unit configured for generating during use an additional displacement or rotation of the plurality of primary charged particle beamlets for at least partly compensating the difference between a lateral displacement of the line of sight and the lateral displacement or rotation of the stage.

**FIG.3b**

## Description

The present invention relates to a multi-beam charged particle inspection system and a method of operating a multi-beam charged particle inspection system. More particular the present invention relates to a multi-beam charged particle beam inspection system for wafer inspection with high throughput, high resolution and high reliability and a related method and a computer program product. The method and the multi-beam charged particle beam inspection system are configured to extract from a plurality of sensor data a set of control signals to control the multi-beam charged particle beam inspection system.

Background of the invention

With the continuous development of ever smaller and more sophisticated microstructures such as semiconductor devices there is a need for further development and optimization of planar fabrication techniques and inspection systems for fabrication and inspection of the small dimensions of the microstructures. Development and fabrication of the semiconductor devices require for example design verification of test wafers, and the planar fabrication techniques involves process optimization for reliable high throughput fabrication. In addition, recently the analysis of semiconductor wafers for reverse engineering and customized, individual configuring of semiconductor devices is required. High throughput inspection tools for the examination of the microstructures on wafers with high accuracy are therefore demanded.

Typical silicon wafers used in manufacturing of semiconductor devices have diameters of up to 12 inches (300 mm). Each Wafer is segmented in 30 - 60 repetitive areas ("Dies") of about up to 800 sq mm size. A semiconductor comprises a plurality of semiconductor structures fabricated in layers on a surface of the wafer by planar integration techniques. Due to the fabrication processes involved, semiconductor wafers have typically a flat surface. The feature size of the integrated semiconductor structures extends between few $\mu$m down to the critical dimensions (CD) of 5nm, with even decreasing features sizes in near future, for example feature sizes or critical dimensions (CD) below 3nm, for example 2nm, or even below 1nm. With the small structure sizes mentioned above, defects of the size of the critical dimensions must be identified in a very large area in a short time.

Therefore, it is an object of the present invention to provide a charged particle system and operation method of a charged particle system that allow high throughput examination of integrated semiconductor features with the resolution of at least the critical dimension during the development or during manufacturing or for reverse engineering of semiconductor devices. It is also possible to acquire high resolution images for a set of specific locations on a wafer, for example for so called process control monitors PCMs or critical areas only.

A recent development in the field of charged particle microscopes CPM is the MSEM, a multi-beam scanning electron microscope. A multi beam charged particle beam microscope is disclosed, for example, in US7244949, in US20190355545 or in US20190355544. In multi beam charged particle microscope, such as a multi beam electron microscope or MSEM, sample is irradiated by an array of electron beamlets, comprising for example 4 up to 10000 electron beams, as primary radiation, whereby each electron beam is separated by a distance of 1 - 200 micrometers from its next neighboring electron beam. For example, a MSEM has about 100 separated electron beams or beamlets, arranged on a hexagonal array, with the electron beamlets separated by a distance of about 10$\mu$m. The plurality of primary charged particle beamlets is focused by a common objective lens on a surface of a sample under investigation, for example a semiconductor wafer fixed on a wafer chuck, which is mounted on a movable stage. During the illumination of the wafer surface with primary charged particle beamlets, interaction products, e.g. secondary electrons, originate from the plurality of intersection points formed by the focus points of the primary charged particle beamlets, while the amount and energy of interaction products depend on the material composition and topography of the wafer surface. The interaction products form a plurality of secondary charged particle beamlets, which is collected by the common objective lens and guided onto a detector arranged at a detector plane by a projection imaging system of the multi-beam inspection system. The detector comprises a plurality of detection areas with each comprising a plurality of detection pixels and detects an intensity distribution for each of the plurality of secondary charged particle beamlets and an image patch of for example 100$\mu$m x 100$\mu$m is obtained.

The Multi-beam charged particle microscope of the prior art comprises a sequence of electrostatic and magnetic elements. At least some of the electrostatic and magnetic elements are adjustable to adjust focus position and stigmation of the plurality of secondary charged particle beams. As an example, US10535494 proposes a re-adjustment of the charged particle microscope, if the detected intensity distribution of a focus of a secondary charged particle beamlet deviates from a predetermined intensity distribution. An adjustment is achieved, if the detected intensity distribution is in accordance with the predetermined intensity distribution. A global displacement or deformation of the intensity distributions of secondary charged particle beamlets allows to draw conclusions on topography effects, the geometry or a tilt of the sample, or charging effects of the sample. US9336982 discloses a secondary charged particle detector with a scintillator plate to convert secondary charged particles to light. To reduce a loss of conversion efficiency of the scintillator plate, the relative lateral position of the focus spots of the plurality of secondary charged particle beamlets and the scintillator plate is variable, for example by a charged particle beam deflector or an actuator for lateral displacement of the scintillator plate.

The Multi-beam charged particle microscope of the prior art comprises at least one cross over plane of the primary or of the secondary charged particle beamlets. The Multi-beam charged particle microscope of the prior art comprises detection systems and methods to facilitate the adjustment.

It is generally desirable to change the imaging settings of a charged particle microscope. A method of changing image acquisition settings of a multi-beam charged particle microscope from a first imaging setting to a different, second imaging setting is described by US9799485.

In charged particle microscopes for wafer inspection, however, it is desired to maintain imaging conditions stable, such that imaging can be performed with high reliability and high repeatability. The throughput depends on several parameters, for example speed of the stage and re-alignment at new measurement sites, as well es the measured area per acquisition time itself. The latter is determined by dwell time, resolution and the number of beamlets. Between the acquisition of two image patches, the wafer is laterally moved to the next point of interest by the wafer stage. The stage movement and precision alignment to the next position for image acquisition is one of the limiting factors for the throughput of the multi-beam inspection system. During image acquisition with high throughput, unwanted stage movements or drifts can deteriorate the image resolution. During image acquisition with high throughput, drifts and deviations of the predetermined primary and secondary charged particle beam paths have a negative influence on the image quality and reliability of the measurement result. For example, the plurality of primary charged particle beamlets can deteriorate from the raster configuration within the planar area segment, or the resolution of the multi-beam charged particle inspection system can be changing.

Single beam electron microscopes commonly use a so-called beam error function (BEF) for improving positioning accuracy of the electron beam as well as the stage movement. The BEF feeds back a (position) signal derived from the stage that holds the sample onto the beam deflection system to this end. A recent example is given in WO2020 / 136094 A2. Multi-beam charged particle microscopes however have higher complexity and the simple methods of single beam electron microscope are not enough. For example, a rotation of the plurality of focus points of the plurality of primary charged particle beamlets relative to the wafer stage cannot be compensated by means of the prior art. Further, multi-beam charged particle microscopes have an imaging projective system for imaging the plurality of secondary electron beamlets onto a detector, and a precise imaging of the plurality of secondary electron has to be maintained. In addition, aberrations of the secondary beam path have to be separated and considered as well.

US9530613 shows a method of focus control of a multi-beam charged particle microscope. A subset of the plurality of charged particle beamlets is shaped in astigmatic form and used for detection of a deviation of a focus position. From the respective elliptical shape of the beamlets of astigmatic shape, an error signal is generated and either a vertical position of a sample stage is adjusted or a current through one or more lenses of the charged particle microscope is altered. Thereby, the focus spots of the plurality of charged particle beamlets is optimized. The method works in parallel with normal operation of a scanning electron microscope. However, the method does only provide a feedback loop for focus control and does neither provide a predictive control, nor does it consider a sensor signal from the stage position sensor.

US20190355544 or US20190355545 disclose a multi-beam charged particle microscope with an adjustable projection system to compensate charging of a sample during scan. Therefore, the projection system is configured with fast, electrostatic elements to maintain a proper imaging of secondary charged particle beamlets from the sample to the detectors. Both references use an image detector to analyze the imaging quality of the secondary beamlets and compensate deteriorations due to sample charging in the secondary electron beam path. Both references describe methods and apparatuses for control of the secondary electron beam path, with secondary electron beamlets starting from the sample surface. However, it is a problem of the present invention that error sources are present also within the primary beam path, which are responsible for deteriorating the spot positions and spot shapes of the plurality of primary charged particle beamlets on the substrate surface. Furthermore, an additional source of error can be positioning errors or movement of the substrate table, leading to an aberration in the obtained digital image of the object without any deterioration of the primary of secondary beam path. These additional aberrations and errors can be variable over different time scales, for example slowly varying drift as for example due to thermal drift. Another example are rapidly varying dynamic aberrations such as for example due to acoustic vibrations. Those errors can not be compensated by means in the secondary beam path alone. It is a problem of the invention to provide a multi-beam charged particle inspection system with means to enable high precision and high-resolution image acquisition with high throughput and high reliability. It is one problem of the invention to provide a multi-beam charged particle inspection system with a fast stage with means to maintain the lateral position and the focus points of the plurality of primary charged particle beamlets within the predetermined raster configuration within the predefined position accuracy even with a reduced time for precision alignment of the stage. It is one problem of the invention to provide a multi-beam charged particle inspection system with means to maintain high resolution and high image contrast during image acquisition with high throughput and high reliability of a sequence of image patches. It is one problem of the invention to provide a multi-beam charged particle inspection system with high throughput and high reliability with a stage which moves the wafer from a first inspection site to a second inspection site. It is one problem of the invention to provide a multi-beam charged particle inspection system with means to compensate drifts of the predetermined primary and secondary charged particle beam paths as well as stage movements, for example parasitic stage movements.

The stage movement including acceleration, deceleration and ring-down of the stage is one of the limiting factors for the throughput of the multi-beam inspection system. Acceleration and deceleration of the stage in short time typically require a complex and expensive stage. It is a problem of the invention provide a multi-beam charged particle inspection system with means to enable high precision and high-resolution image acquisition with high throughput and high reliability with a stage of reduced technical complexity and reduced cost.

Generally, it is a problem of the invention to provide a multi-beam charged particle inspection system for wafer inspection with means to enable high precision and high-resolution image acquisition with high reliability and high throughput.

Summary of the Invention

The embodiments of the invention solve the objectives of the invention by a multi-beam charged particle microscope comprising a set of compensators for a compensation of a change of error amplitudes during an image acquisition of an image patch. The multi-beam charged particle microscope comprises a plurality of detectors or sensors to provide a plurality of sensor data and extract from the plurality of sensor data a set of actual error amplitudes of a predefined set of normalized error vectors. By deriving the normalized error vectors, contributions from different error sources can be separated. The different error sources are comprising error sources within the primary charged particle beam path, the secondary electron beam path and the position of the stage. The multi-beam charged particle microscope is comprising a control unit, which derives a drive signal for driving the set of compensators to compensate the set of error amplitudes corresponding to a set of imaging aberrations and thereby keep the actual error amplitudes below a predetermined threshold during an image acquisition of a digital image of an image patch. From the normalized error vectors, which are representing contributions from the different error sources, drive signals of a set of compensators are derived, comprising at least one of a first compensator within the primary charged particle beam path and a second compensator within the secondary electron beam path. Further compensators can comprise a computational image postprocessing of the obtained digital image, or a compensator within the wafer stage.

In an example, the multi-beam charged particle microscope is configured to predict a change of at least one error amplitude of the set of error amplitudes and provide corresponding drive signals to the set of compensators accordingly. In an example, the plurality of sensor data includes data from stage position sensor or stage acceleration sensors. In an example, the set of compensators comprise a first and a second deflection system or deflection scanner of the multi-beam charged particle microscope. In a further example, the set of compensators comprise a third deflection system in a detection unit of the multi-beam charged particle microscope. In an example, the set of compensators further comprise at least a fast, electrostatic compensator or a multi-aperture active array element.

According an embodiment of the invention, a multi-beam charged particle inspection system is provided with means to enable high precision and high-resolution image acquisition with high throughput and high reliability. A wafer stage and means to control the wafer stage position are provided, wherein the wafer stage is configured to hold a sample such as a wafer and is movable in at least one of an x-direction, a y-direction or a z-direction. The stage typically comprises a stage motion controller, comprising a plurality of motors or actuators, which can be independently actuated or controlled. The motors or actuators can comprise at least one of a piezoelectric motor, piezoelectric actuator, or an ultrasonic piezomotor. It further comprises a position sensing system configured to determine a lateral and vertical displacement or rotation of the stage. The position sensing system is using any of a laser interferometer, a capacitive sensor, a confocal sensor array, a grating interferometer or a combination thereof.

The multi-beam charged particle inspection system is provided with means to maintain the lateral positions of the focus points of the plurality of primary charged particle beamlets on a wafer surface and means to maintain the lateral positions of the focus points of the plurality of secondary electron beamlets, each within the predetermined raster configuration and each within the predefined position accuracy below a set of thresholds. Thereby, in an example, a reduced time for precision alignment of the stage is achieved. In a further example, throughput is further enhanced by overlapping the time intervals required for image acquisition and wafer stage movement. The additional means comprise a first deflection units for scanning deflection of the plurality of primary charged particle beamlets and at least a second deflection unit for scanning deflection of the plurality of secondary electron beamlets.

According an embodiment of the invention, a multi-beam charged particle inspection system is provided with means to maintain high resolution and high image contrast during image acquisition with high throughput and high reliability of a sequence of image patches. During a first and a second image acquisition, a plurality of sensor data is generated, including sensor data from an image sensor and a stage position sensor. The multi-beam charged particle inspection system comprises a control unit configured to generate a set of control signals from the plurality of sensor data. The set of control signals is provided to control modules to control a set of compensators. According an embodiment of the invention, a multi-beam charged particle inspection system is provided with means to compensate drifts of the predetermined primary and secondary charged particle beam paths as well as stage movements.

According an example, a multi-beam charged-particle beam system is comprising a controller or control unit configured to apply a first signal to deflect a plurality of primary charged-particle beamlets incident on the sample to at least partly compensate for the lateral displacement of the stage; and apply a second signal to deflect a plurality of secondary electron beamlets to at least partially compensate the displacement of the plurality of secondary electron beamlets originating from the deflected primary charged-particle beamlet position on the sample. The first signal comprises an electrical signal affecting how the plurality of primary charged-particle beamlets is deflected in the at least one of X- or Y-axes. The controller is further configured to dynamically adjust at least one of the first signal or the second signal during scanning of the plurality of primary charged-particle beamlets on the sample. The controller is connected to a stage motion controller, and each of the plurality of motors is independently controlled to adjust a tilt of the stage, such that the stage is substantially perpendicular to an optical axis of the primary charged-particle beam.According an embodiment of the invention, the multi-beam charged particle microscope system comprises a charged particle source configured to generate during use a first charged particle beam, and a multi beam generator configured to generate during use a plurality of primary charged particle beamlets from the incoming first charged particle beam, wherein each individual beamlet of the plurality of primary charged particle beamlets is spatially separated from all other beamlets of the plurality of charged particle beamlets. The multi-beam charged particle microscope system further comprises an object irradiation unit including an objective lens configured to focus incoming primary charged particle beamlets in an object plane, in which a wafer surface is provided, in a manner that a first image subfield in which a first individual primary beamlet of the plurality of charged particle beamlets impinges in the object plane is spatially separated from a second image subfield in which a second individual primary beamlet of the plurality of primary charged particle beamlets impinges in the object plane. The multi-beam charged particle microscope system further comprises a detection unit including a projection system and an image sensor comprising a plurality of individual detectors. The projection system is configured to image secondary electrons leaving the wafer in the first image subfield within the object plane due to impinging primary charged particles onto a first one, or a first group, of the plurality of individual detectors and to image secondary electrons leaving the wafer in the second image subfield in the object plane due to impinging primary charged particles onto a second one, or a second group, of the plurality of individual detectors.

In an embodiment of the multi-beam charged particle microscope system comprises a subset of fast compensators providing a fast compensation of dynamic changes of error amplitudes. The subset of fast compensators comprises at least one of an electrostatic lens, electrostatic deflector, electrostatic stigmator, electrostatic micro-lens array, electrostatic stigmator array, or an electrostatic deflector array. Electrostatic elements such as electrostatic deflectors and/or electrostatic stigmators provide the advantage of no eddy currents, no inductivity and provide adjustment times in the range of below 10 $\mu$s for compensation of a dynamic change of an error amplitude.

The subcomponent providing fast compensation of dynamic changes can provide an adjustment frequency that is comparable to the scanning frequency with which the primary charged particle beamlets are scanned, i.e. the fast compensation of dynamic changes can be performed several times, i.e. more than once, while an image acquisition of an image patch on the wafer surface is performed with the plurality of primary charged particle beamlets. Typical line scanning frequencies are in the order of 1kHz to 5kHz, the frequency bandwidth of an electrical driving signals of a dynamic compensation element can be within a range of 0.1kHz and 10kHz, thus providing for example a compensation between every $50^{th}$ scanning line or 10 times every single scanning line.

In an embodiment of the multi-beam charged particle microscope system comprises a subset of slowly acting compensators providing a compensation of a slow change or drift of error amplitudes. The subset of slowly acting compensators comprises at least one of a magnetic lens, or a magnetic deflector, a magnetic stigmator or a magnetic beam splitter.

In an embodiment, a multi-beam charged particle microscope for wafer inspection is provided. The multi-beam charged particle microscope for wafer inspection comprises a charged-particle multi-beamlet generator for generating a plurality of primary charged particle beamlets and an object irradiation unit comprising a first deflection system for scanning an area of a wafer surface arranged in an object plane with the plurality of primary charged particle beamlets for the generation of a plurality of secondary electron beamlets emitting from the wafer surface. The multi-beam charged particle microscope for wafer inspection further comprises a detection unit with a projection system, a second deflection system and an image sensor for imaging the plurality of secondary electron beamlets onto the image sensor, and for acquisition during use a digital image of a first image patch of the wafer surface. The multi-beam charged particle microscope for wafer inspection further comprises a sample stage with a stage position sensor for positioning and holding the wafer surface in the object plane during the acquisition of the digital image of the first image patch. The first deflection system scans the plurality of the primary charged particle beamlets along predetermined scan paths over the wafer surface while the wafer is held by the wafer stage, and the second deflection unit scans the plurality of secondary electron beamlets along predetermined scan paths in order to keep the image points of the plurality of secondary electron beamlets fixed and constant at the image sensor of the detection unit. The multi-beam charged particle microscope for wafer inspection further comprises a control unit and a plurality of detectors comprising the stage position sensor and the image sensor, configured to generate during use a plurality of sensor data, the sensor data including position and orientation data of the sample stage. The multi-beam charged particle microscope for wafer inspection further comprises a set of compensators comprising at least the first and the second deflection system. The control unit is configured to generate a set of P control signals $C_p$ from the plurality of sensor data to control the set of compensators during the acquisition of the digital image of the first image patch. The set of compensators can further comprise at least one of the compensators of the charged-particle multi-beamlet generator and a compensator of the detection unit. In an example, the control unit comprises a sensor data analysis system configured to analyze during use the plurality of sensor data and to compute during use a set of K amplitudes $A_k$ of K error vectors. In an embodiment, the control unit further comprises an image data acquisition unit which is configured to reduce during use the image sensor data from the image sensor to an image sensor data fraction representing less than 10%, preferably less than 2% of the image sensor data and to provide the image sensor data fraction to the sensor data analysis system. In an example, the image sensor data fraction is comprising digital image data of a plurality of secondary electron beamlets at a reduced sampling rate. In an example, the image sensor data fraction is comprising digital image data of a reduced set of secondary electron beamlets (9).

In an example, the sensor data analysis system is further configured to derive or predict a temporal development of at least one amplitude $A_n$ of the set of amplitudes $A_k$ of error vectors.

In an example, the control unit further comprises a control operation processor for computing the set of control signals $C_p$ from the set of amplitudes $A_k$ of error vectors. In an example, the extraction of at least one of the plurality or set of control signals is further based on a predictive model of an actuation output of the stage.

In an example, the sensor data analysis system is configured to derive a sensor data vector DV of length L from the plurality of sensor data, with L >= K.

In an example, the control unit is configured to compensate a change of a position or an orientation of the sample stage by computing and providing at least one of the control signals of the first set of control signals $C_p$ to the first and the second deflection units. A change of a position or an orientation of the sample stage is given by a lateral displacement of the stage, corresponding to a difference between a current position and rotation of the stage and a target position and rotation of the stage in the at least one of X-Y axes.

The control unit is configured to derive from the plurality of sensor data a driving signal for the first compensator in the object irradiation unit to achieve an additional displacement of the scanning spot positions of the plurality of primary charged particle beamlets synchronized with a lateral displacement of the wafer surface. In an example, the additional displacement comprises a rotation of the raster configuration of the plurality of primary charged particle beamlets. The control unit is further configured to compensate the additional displacement of the spot positions on the displaced wafer surface by the second compensator in the projection system, wherein the second compensator in the projection system is configured to operate synchronized with the first compensator in the object irradiation unit, thereby keeping constant the spot positions of the plurality of secondary electron beamlets on the image detector. In an example, the first compensator in the object irradiation unit is the first deflection system, and the control unit is configured to compensate a displacement or a rotation of the sample stage by computing and providing a control signal for an additional displacement or rotation of the scanning spot positions of the plurality of primary charged particle beamlets to the first deflection system. In an example, the second compensator the projection system is the second deflection system, and the control unit is configured to compensate the additional displacement or rotation of the scanning spot positions of the plurality of primary charged particle beamlets on the displaced wafer surface by computing and providing a control signal to the second deflection system. Thereby, the spot positions of the secondary electron beamlets are kept constant at an image sensor irrespective of the modified scan path according a displacement or movement of the wafer stage.

In an embodiment, the charged-particle multi-beamlet generator of the multi-beam charged particle microscope further comprises a fast compensator, and the control unit is configured to compensate a rotation of the sample stage by computing and providing at least one of the control signals of the first set of control signals $C_p$ to the fast compensator to induce a rotation of the plurality of primary charged particle beamlets. In an embodiment, the control unit of the multi-beam charged particle microscope is further configured to generate a third control signal for moving the wafer surface by the wafer stage to a second center position of a second image patch in the object plane for image acquisition of a digital image of a second image patch. In an embodiment, the control unit is further configured to compute a second set of P

control signals $C_p$ from the plurality of sensor data to control the set of compensators during the time interval Tr of movement of the wafer stage to the second center position of the second image patch. In an embodiment, the control unit is further configured to compute a start time of the image acquisition of the second image patch during time interval Tr and to start the image acquisition of the second image patch during a deceleration time interval Td of the wafer stage, and wherein the control unit is further configured to provide at least an offset signal of a predicted offset position of the wafer stage during time interval Td to the first and second deflection systems.

In an embodiment, a method of wafer inspection with a multi-beam charged particle microscope is provided. The multi-beam charged particle microscope of the method comprises a plurality of detectors comprising an image sensor and a stage position sensor, and a set of compensators comprising at least a first and a second deflection system. The method is comprising the steps of

a. positioning and aligning a wafer surface of a wafer with a position of a local wafer coordinate system with a line of sight of the multi-beam charged particle microscope;

b. performing an image acquisition to acquire a digital image of a first image patch of the wafer surface;

c. collecting, during the step of image acquisition, a plurality of sensor data from the plurality of detectors;

d. deriving a set of K error amplitudes $A_k$ from the plurality of sensor data and

e. deriving a set of P control signals $C_p$ from the set of error amplitudes $A_k$.

f. providing the set of control signals $C_p$ during step b of image acquisition to a set of compensators.

In an embodiment, the method of wafer inspection is further comprising the step (g) of deriving a sensor data vector DV of length L from the plurality of sensor data, with L >= K. In an embodiment, the method of wafer inspection is further comprising the step (h) of deriving a temporal development of at least one amplitude $A_n$ of the set of amplitudes $A_k$ of error vectors. In an embodiment, the method of wafer inspection is further comprising the step (i) of compensating a change of a position or an orientation of the sample stage by providing control signals Cp to the first and the second deflection unit. In an embodiment, the method of wafer inspection is further comprising the step (j) of deriving a second set of control signals Cp from the set of error amplitudes Ak and providing the second set of control signals during step a) of positioning and aligning a wafer surface of the wafer.

In an embodiment of the invention, a charged particle microscope and a method of operating a charged particle microscope with high throughput and high resolution according the imaging specification requirements of a wafer inspection task is provided, wherein a sequence of image patches is imaged in a sequence of image acquisition steps, comprising a first image acquisition of a first image patch in a first time interval Ts1 and a second image acquisition of a second image patch in a second time interval Ts2, and further comprising a third time interval Tr for moving a sample stage from a first center position of the first image patch to a second center position of the second image patch, such that at least one of the first and second time interval Ts1 or Ts2 has an overlap with the third time interval Tr. The total time interval from start of the first time interval Ts1 to the end of the second time interval Ts2 is shorter than the sum of the three time intervals Ts1, Tr and Ts2 and a fast wafer inspection with high throughput is achieved. In an example, the second image acquisition of the second image patch is initiated before the end of the third time interval Tr, when the sample stage has completely stopped. In an example, the third time interval Tr of sample movement is initiated before the end of the time interval Ts1, when the image acquisition of the first image patch is finalized. In an example of the method, the computation of a start time of the third time interval Tr of sample movement is performed during the first time interval Ts1 of image acquisition of the first image patch, such that a position deviation of the first center position of the first image patch from a line of sight of the multi-beam charged particle microscope or a movement velocity of the sample stage are below a predetermined threshold. In an example of the method, the computation of a start time of the second time interval Ts2 of the second image acquisition is performed during the time interval Tr of sample stage movement, such that a position deviation of the second center position of the second image patch from a line of sight of the multi-beam charged particle microscope or a movement velocity of the sample stage are below a predetermined threshold.

In an example of the method of operating a multi-beam charged particle microscope, the method comprises the further steps of

- predicting a sequence of sample stage positions during the time interval Tr of movement of the wafer stage;
- computing at least a first and a second control signal from the predicted sample stage positions;
- providing the first control signal to a first deflection system in the primary beam path and the second control signal to a second deflection system in the secondary beam path of the multi-beam charged particle microscope.

In an example, a charged particle microscope comprises a control unit which is configured to compute a start time of sample stage movement from a first to a second image patch during a first image acquisition of the first image patch. In an example of the invention, a charged particle microscope comprises a control unit which is configured to compute a start time of a second image acquisition of a second image patch during a sample stage movement from a first image patch to the second image patch.

In an embodiment, a method of operating a multi-beam charged particle microscope configured for wafer inspection is described, comprising the preparatory steps of

- defining a set of image qualities and a set of predetermined, normalized error vectors describing deviations from the set of image qualities;
- determining a set of thresholds for the amplitudes of the set or normalized error vectors;
- selecting a set of compensators of the multi-beam charged particle microscope;
- determining a sensitivity matrix according a linear and/or nonlinear perturbation model by variation of at least a drive signal for each of the compensators of the set of compensators;
- deriving a set of normalized drive signals for compensating each of the set of normalized error vectors; and
- storing the normalized drive signals and the set of thresholds in a memory of a control unit of the multi-beam charged particle microscope.

In an example, the set of compensators comprise a first deflection unit of the multi-beam charged particle microscope for scanning and deflecting the plurality of primary charged particles and a second deflection unit for scanning and deflecting the plurality of secondary electrons generated during use of the multi-beam charged particle microscope.

The sensitivity matrix is analyzed for example by singular value decomposition or similar algorithms. In an example, the sensitivity matrix is decomposed by splitting the into two, three or more kernels or independent subsets of image qualities. Thereby, complexity of computation is reduced, and nonlinear effects or higher order effects are reduced.

During use, for example during a wafer inspection, the method of operation comprises using the normalized error vectors, normalized drive signals and the set of thresholds, which are stored in a memory of a control unit of the multi-beam charged particle microscope. A method of operating the multi-beam charged particle microscope comprises

- a step of receiving during use a plurality of sensor data from a plurality of sensors of the multi-beam charged particle microscope forming a sensor data vector;
- a step of expanding the sensor data vector in a set of normalized error vectors stored in the memory of a control unit, and determining a set of actual amplitudes of normalized error vectors from the sensor data vector;

  - a step of comparing the set of actual amplitudes with a set of thresholds stored in the memory of the control unit; and based on the result of the comparison,
- a step of deriving a set of control signals from the set of actual amplitudes;
- a step of deriving a set of actual drive signals from a set of normalized drive signals, stored in the memory of the control unit, from the set of control signals;
- a step of providing the set of actual drive signals to a set of compensators of the multi-beam charged particle microscope, thereby reducing during operation of the multi-beam charged particle microscope the set of actual amplitudes of the set of normalized error vectors below the set of thresholds.

In an example, the plurality of sensor data comprises at least one of a position or speed information of the actual position and actual velocity of a wafer stage for holding a wafer during inspection with the multi-beam charged particle microscope. The set of actual amplitudes of normalized error vectors from the sensor data vector represent an actual state of the set of image qualities of the multi-beam charged particle microscope. By comparison to predetermined and stored thresholds, a set of control signals is derived. From the control signals, a set of actual drive signals is computed, for example by multiplication of a control signals with the predetermined set of normalized drive signals. During an image scan or an image acquisition of at least one image patch, the set of actual drive signals is provided to the set of compensators, thereby reducing during operation of the multi-beam charged particle microscope the subset of actual amplitudes below the subset of predetermined thresholds, stored in the memory of the control unit. The method steps are repeated at least twice, at least ten times, preferably every scanning line during acquisition of each image patch.

In an example, the method is further comprising the step of predicting during a wafer inspection a subset of development amplitudes of at least a subset of the set of actual amplitudes according an expected development of the multi-beam charged particle microscope in a prediction time interval. The method can further comprise a step of recording during use at least a subset of the set of actual amplitudes of the multi-beam charged particle microscope for generating a history of the subset of the set of actual amplitudes. The method of operating the multi-beam charged particle microscope con further comprise the step of deriving during a wafer inspection a set of predictive control signals from the set of development amplitudes and a set of predictive drive signals from the set of predictive control signals, and step of providing during a wafer inspection the set of predictive drive signals to the set of compensators in time sequential manner, thereby reducing during operation of the multi-beam charged particle microscope in the prediction time interval the subset of actual amplitudes below the set of thresholds.

The expected development of the multi-beam charged particle microscope in the prediction time interval is determined according to one of a prediction model function or a linear, second order or higher order extrapolation of the history of a set of actual amplitudes. In an example, the method is further comprising the step of recording during use at least a subset of the set of actual amplitudes of the multi-beam charged particle microscope for generating a history of the subset of the set of actual amplitudes. The method is further comprising the step of deriving during a wafer inspection a set of predictive control signals from the set of development amplitudes and a set of predictive drive signals from the set of predictive control signals, and step of providing during a wafer inspection the set of predictive drive signals to the set of compensators in time sequential manner, thereby reducing during operation of the multi-beam charged particle microscope in the prediction time interval the subset of actual amplitudes below the subset of thresholds. The embodiment includes a multi-beam charged particle microscope configured to apply during use the method steps described above.

In the embodiments, the error amplitudes derived from the sensor data are representing image performance specification of a wafer inspection task, such as at least one of a relative position and orientation of the wafer stage with respect to the line of sight of the multi-beam charged particle microscope and an image coordinate system of the multi-beam charged particle microscope, a magnification or pitch of the multi-beam charged particle microscope, a telecentricity condition, a contrast condition, an absolute position accuracy of the plurality of charged particle beamlets, and higher order aberrations such as distortion of the plurality of charged particle beamlets, astigmatism and chromatic aberrations.

In an embodiment, a multi-beam charged particle microscope and a software code is disclosed. A multi-beam charged particle microscope comprises a set of compensators including deflectors, a control unit and software code installed, configured for application of any of the methods according any of the method steps described above.

In an embodiment, a non-transitory computer readable medium is disclosed, comprising a set of instructions that is executable by one or more processors of a multi-beam charged particle apparatus to cause the apparatus to perform a method, wherein the apparatus includes a charged-particle source to generate a plurality of primary charged-particle beamlets and the method comprising:

- determining a lateral displacement of a stage, wherein the stage is movable in at least one of X-Y axes; and

instructing a controller to apply a first signal to deflect the plurality of primary charged-particle beamlets incident on the sample to at least partly compensate for the lateral displacement. In an example, the set of instructions comprise the performance of a method including instructing a controller to apply a second signal to deflect the plurality of secondary electron beamlets emitted from the sample to at least partly compensate for the lateral displacement of the sample stage.

More details will be disclosed with reference to the attached drawings. Thereby shows:

Fig. 1: An illustration of a multi-beam charged particle microscope system according an embodiment.

Fig. 2: A first inspection site comprising a first and a second image patch and a second inspection site.

Fig. 3a: A sketch of a displaced and rotated image coordinate system with respect to a local wafer coordinate system.

Fig. 3b: A sketch of a rotated image patch, rotated with respect to a local wafer coordinate system.

Fig. 4: An illustration of a slowly varying drift component of an error amplitude (a) before and (b) after compensation according to the invention.

Fig. 5: An illustration of a rapid varying component or dynamic change of an error amplitude (a) before and (b) after compensation according to the invention.

Fig. 6: A block diagram of multi-beam charged particle microscope system including a detailed illustration of control unit 800 according an embodiment of the invention.

Fig.7: A block diagram of a method of operation of multi-beam charged particle microscope system for wafer inspection according an embodiment of the invention.

Fig. 8: An illustration of an active multi aperture plate.

In the exemplary embodiments described below, components similar in function and structure are indicated as far as possible by similar or identical reference numerals.

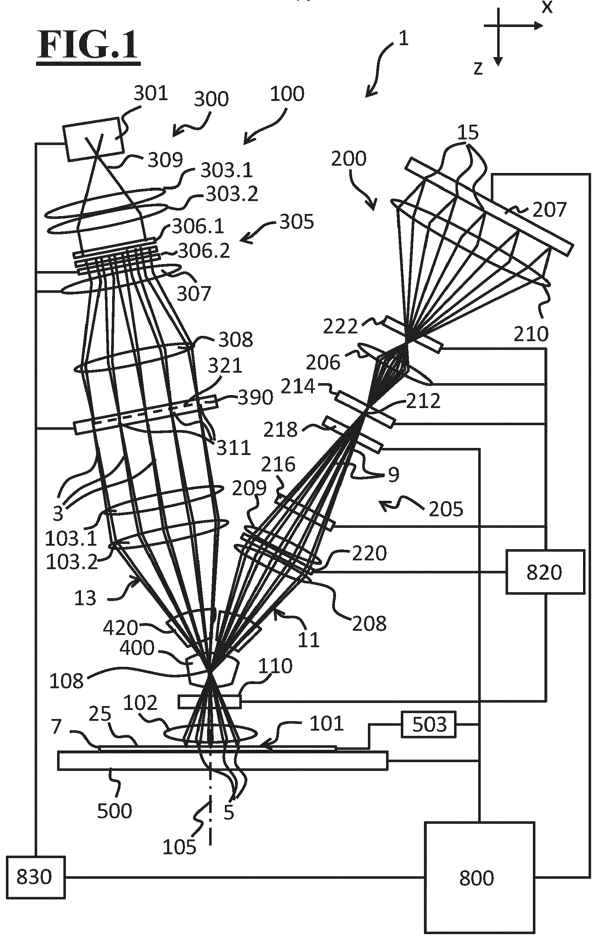

The schematic representation of **figure 1** illustrates basic features and functions of a multi-beamlet charged-particle microscopy system 1 according the embodiments of the invention. It is to be noted that the symbols used in the figure do not represent physical configurations of the illustrated components but have been chosen to symbolize their respective functionality. The type of system shown is that of a scanning electron microscope (SEM) using a plurality of primary electron beamlets 3 for generating a plurality of primary charged particle beam spots 5 on a surface of an object 7, such as a wafer located in an object plane 101 of an objective lens 102. For simplicity, only five primary charged particle beamlets 3 and five primary charged particle beam spots 5 are illustrated. The features and functions of multi-beamlet charged-particle microscopy system 1 can be implemented using electrons or other types of primary charged particles such as ions and in particular helium ions.

The microscopy system 1 comprises an object irradiation unit 100 and a detection unit 200 and a beam splitter unit 400 for separating the secondary charged-particle beam path 11 from the primary charged-particle beam path 13. Object irradiation unit 100 comprises a charged-particle multi-beamlet generator 300 for generating the plurality of primary charged-particle beamlets 3 and is adapted to focus the primary charged-particle beamlets 3 in the object plane 101, in which the surface 25 of a wafer 7 is placed by a sample stage 500. The sample stage 500 comprises a stage motion controller, wherein the stage motion controller comprises a plurality of motors configured to be independently controlled by control signals. The stage motion controller is connected to a control unit 800.

The primary beamlet generator 300 produces a plurality of primary charged particle beamlet spots 311 in an intermediate image plane 321, which is typically a spherically curved surface to compensate a field curvature of the object irradiation unit 100. The primary beamlet generator 300 comprises a source 301 of primary charged particles, for example electrons. The primary charged particle source 301, for example, emits a diverging primary charged particle beam 309, which is collimated by collimating lenses 303.1 and 303.2 to form a collimated beam. The collimating lenses 303.1 and 303.2 are usually consisting of one or more electrostatic or magnetic lenses, or by a combination of electrostatic and magnetic lenses. The collimated primary charged particle beam is incident on the primary multi-beamlet-forming unit 305. The multi-beamlet forming unit 305 basically comprises a first multi-aperture plate 306.1 illuminated by the primary charged particle beam 309. The first multi-aperture plate 306.1 comprises a plurality of apertures in a raster configuration for generation of the plurality of primary charged particle beamlets 3, which are generated by transmission of the collimated primary charged particle beam 309 through the plurality of apertures. The multi-beamlet forming unit 305 comprises at least a further multi-aperture plates 306.2 located, with respect to the direction of movement of the electrons in beam 309, downstream of the first multi-aperture plate 306.1. For example, a second multi-aperture plate 306.2 has the function of a micro lens array and is preferably set to a defined potential so that a focus position of the plurality of primary beamlets 3 in intermediate image plane 321 is adjusted. A third, active multi-aperture plate arrangement 306.3 (not illustrated) comprises individual electrostatic elements for each of the plurality of apertures to influence each of the plurality of beamlets individually. The active multi-aperture plate arrangement 306.3 consists of one or more multi-aperture plates with electrostatic elements such as circular electrodes for micro lenses, multi-pole electrodes or sequences of multipole electrodes to form deflector arrays, micro lens arrays or stigmator arrays. The multi-beamlet forming unit 305 is configured with an adjacent first electrostatic field lenses 307, and together with a second field lens 308 and the second multi-aperture plate 306.2, the plurality of primary charged particle beamlets 3 is focused in or in proximity of the intermediate image plane 321.

In or in proximity of the intermediate image plane 321, a beam steering multi aperture plate 390 is arranged with a plurality of apertures with electrostatic elements, for example deflectors, to manipulate individually each of the plurality of charged particle beamlets 3. The apertures of the beam steering multi aperture plate 390 are configured with larger diameter to allow the passage of the plurality of primary charged particle beamlets 3 even in case the focus spots of the primary charged particle beamlets 3 deviate from their design position.

The plurality of focus points of primary charged particle beamlets 3 passing the intermediate image plane 321 is imaged by field lens group 103.1 and 103.2 and objective lens 102 in the image plane 101, in which the investigated surface of the wafer 7 is positioned by an object mount on sample stage 500. The object irradiation system 100 further comprises a deflection system 110 in proximity to a first beam cross over 108 by which the plurality of charged-particle beamlets 3 can be deflected in a direction perpendicular to the direction of beam propagation direction (here the z-direction). Deflection system 110 is connected to control unit 800. Objective lens 102 and deflection system 110 are centered at an optical axis 105 of the multi-beamlet charged-particle microscopy system 1, which is perpendicular to wafer surface 25. The wafer surface 25 arranged in the image plane 101 is then raster scanned with deflection system 110. Thereby the plurality of primary charged particle beamlets 3, forming the plurality of beam spots 5 arranged in the raster configuration, is scanned synchronously over the wafer surface 101. In an example, the raster configuration of the focus spots 5 of the plurality of primary charged particle 3 is a hexagonal raster of about hundred or more primary charged particle beamlets 3. The primary beam spots 5 have a distance about 6$\mu$m to 15$\mu$m and a diameter of below 5nm, for example 3nm, 2nm or even below. In an example, the beam spot size is about 1.5nm, and the distance between two adjacent beam spots is 8$\mu$m. At each scan position of each of the plurality of primary beam spots 5, a plurality of secondary electrons is generated, respectively, forming the plurality of secondary electron beamlets 9 in the same raster configuration as the primary beam spots 5. The plurality or intensity of secondary charged particles generated at each beam spot 5 depends on the intensity of the impinging primary charged particle beamlet, illuminating the corresponding spot, the material composition and topography of the object under the beam spot. Secondary charged particle beamlets 9 are accelerated by an electrostatic field generated by a sample charging unit 503, and collected by objective lens 102, directed by beam splitter 400 to the detection unit 200. Detection unit 200 images the secondary electron beamlets 9 onto the image sensor 207 to form there a plurality of secondary charged particle image spots 15. The detector comprises a plurality of detector pixels or individual detectors. For each of the plurality of secondary charged particle beam spots 15, the intensity is detected separately, and the material composition of the wafer surface is detected with high resolution for a large image patch with high throughput. For example, with a raster of 10 x 10 beamlets with $8\mu m$ pitch, an image patch of approximately $88\mu m$ x $88\mu m$ is generated with one image scan with deflection system 110, with an image resolution of for example 2nm. The image patch is sampled with half of the beam spot size of for example 2nm, thus with a pixel number of 8000 pixels per image line for each beamlet, such that the image patch generated by 100 beamlets comprises 6.4 gigapixel. The image data is collected by control unit 800. Details of the image data collection and processing, using for example parallel processing, are described in German patent application 102019000470.1, which is hereby incorporated by reference and in US-Patent US 9.536.702, mentioned above.

The plurality of secondary electron beamlets 9 passes the first deflection system 110 and is scanning deflected by the first scanning system 110 and guided by beam splitter unit 400 to follow the secondary beam path 11 of the detection unit 200. The plurality of secondary electron beamlets 9 are travelling in opposite direction from the primary charged particle beamlets 3, and the beam splitter unit 400 is configured to separate the secondary beam path 11 from the primary beam path 13 usually by means of magnetic fields or a combination of magnetic and electrostatic fields. Optionally, additional magnetic correction elements 420 are present in the primary as well as in the secondary beam paths. Projection system 205 further comprises at least a second deflection system 222, which is connected to projection system control unit 820. Control unit 800 is configured to compensate a residual difference in position of the plurality of focus points 15 of the plurality of secondary electron beamlets 9, such that the position of the plurality secondary electron focus spots 15 are kept constant at image sensor 207.

The projection system 205 of detection unit 200 comprises at least a second cross over 212 of the plurality of secondary electron beamlets 9, in which an aperture 214 is located. In an example, the aperture 214 further comprises a detector (not shown), which is connected to projection system control unit 820. Projection system control unit 820 is further connected to at least one electrostatic lens 206 of projection system 205, which comprises further electrostatic or magnetic lenses 208, 209, 210, and is further connected to a third deflection unit 218. The projection system 205 further comprises at least a first multi-aperture corrector 220, with apertures and electrodes for individual influencing each of the plurality of secondary electron beamlets 9, and an optional further active element 216, connected to control unit 800.

The image sensor 207 is configured by an array of sensing areas in a pattern compatible to the raster arrangement of the secondary electron beamlets 9 focused by the projecting lens 205 onto the image sensor 207. This enables a detection of each individual secondary electron beamlet 9 independent of the other secondary electron beamlets 9 incident on the image sensor 207. A plurality of electrical signals is created and converted in digital image data and processed to control unit 800. During an image scan, the control unit 800 is configured to trigger the image sensor 207 to detect in predetermined time intervals a plurality of timely resolved intensity signals from the plurality of secondary electron beamlets 9, and the digital image of an image patch is accumulated and stitched together from all scan positions of the plurality of primary charged particle beamlets 3.

The image sensor 207 illustrated in figure 1 can be an electron sensitive detector array such as a CMOS or a CCD sensor. Such an electron sensitive detector array can comprise an electron to photon conversion unit, such as a scintillator element or an array of scintillator elements. In another embodiment, the image sensor 207 can be configured as electron to photon conversion unit or scintillator plate arranged in the focal plane of the plurality of secondary electron particle image spots 15. In this embodiment, the image sensor 207 can further comprise a relay optical system for imaging and guiding the photons generated by the electron to photon conversion unit at the secondary charged particle image spots 15 on dedicated photon detection elements, such as a plurality of photomultipliers or avalanche photodiodes (not shown). Such an image sensor is disclosed in US 9,536,702, which is incorporated here by reference. In an example, the relay optical system further comprises a beamsplitter for splitting and guiding the light to a first, slow light detector and a second, fast light detector. The second, fast light detector is configured for example by an array of photodiodes, such as avalanche photodiodes, which are fast enough to resolve the image signal of the plurality of secondary electron beamlets according the scanning speed of the plurality of primary charged particle beamlets. The first, slow light detector is preferably a CMOS or CCD sensor, providing a high-resolution sensor data signal for monitoring the focus spots 15 or the plurality of secondary electron beamlets 9 and for control of the operation of the multi-beam charged particle microscope as described below in more detail.

In the illustrated in the example, the primary charged particle source is implemented in form of an electron source 301 featuring an emitter tip and an extraction electrode. When using primary charged particles other than electrons, like for example helium ions, the configuration of the primary charged-particle source 301 may be different to that shown. Primary charged-particle source 301 and active multi-aperture plate arrangement 306.1...306.3 and beam steering multi aperture plate 390 are controlled by primary beamlet control module 830, which is connected to control unit 800.

During an acquisition of an image patch by scanning the plurality of primary charged particle beamlets 3, the stage 500 is preferably not moved, and after the acquisition of an image patch, the stage 500 is moved to the next image patch to be acquired. Stage movement and stage position is monitored and controlled by sensors known in the art, such as Laser interferometers, grating interferometers, confocal micro lens arrays, or similar. For example, a position sensing system determines the lateral and vertical displacement and rotation of the stage using any of a laser interferometer, a capacitive sensor, a confocal sensor array, a grating interferometer or a combination thereof. As will be shown below in an embodiment of the invention, the movement of stage 500 from a first to a next image patch overlaps with the acquisition of an image patch and throughput is increased.

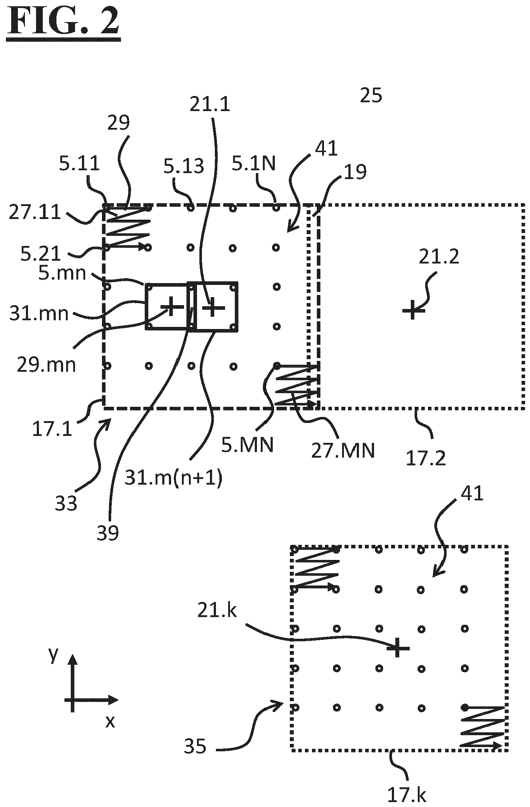

An embodiment of the method of wafer inspection by acquisition of image patches is explained in more detail in **Figure 2.** The wafer is placed with its wafer surface 25 in the focus plane of the plurality of primary charged particle beamlets 3, with the center 21.1 of a first image patch 17.1. The predefined position of the image patches 17.1...k corresponds to inspection sites of the wafer for inspection of semiconductor features. The predefined positions of the first inspection site 33 and second inspection site 35 are loaded from an inspection file in a standard file format. The predefined first inspection site 33 is divided into several image patches, for example a first image patch 17.1 and a second image patch 17.2, and the first center position 21.1 of the first image patch 17.1 is aligned under the optical axis of the multi-beam charged-particle microscopy system for the first image acquisition step of the inspection task. The first center of a first image patch 21.1 is selected as the origin of a first local wafer coordinate system for acquisition of the first image patch 17.1. Methods to align the wafer, such that the wafer surface 25 is registered and a coordinate system of wafer coordinates is generated, are well known in the art.

The plurality of primary beamlets is distributed in a regular raster configuration 41 in each image patch and is scanned by a scanning mechanism to generate a digital image of the image patch. In this example, the plurality of primary charged particle beamlets 3 is arranged in a rectangular raster configuration 41 with n primary beam spots 5.11, 5.12 to 5.1N in the first line with N beam spots, and M lines with beam spots 5.11 to beam spot 5.MN. Only M=five times N=five beam spots are illustrated for simplicity, but the number of beam spots M times N can be larger, and the plurality of beam spots 5.11 to 5.MN can have different raster configurations 41 such as a hexagonal or a circular raster.

Each of the primary charged particle beamlet is scanned over the wafer surface 25, as illustrated at the example of primary charged particle beamlet with beam spot 5.11 to 5.MN with scan path 27.11 to scan path 27.MN of the plurality of primary charged particle beamlets. Scanning of each of the plurality of primary charged particles is performed for example in a back-and forth movement with scan paths 27.11...27.MN, and each focus point 5.11...5.MN of each primary charged particle beamlet is moved by scanning deflector 110 in x-direction from a start position of an image line, which is in the example the most left image point of for example image subfield 31.mn. Each focus point is then scanned by scanning the primary charged particle beamlet to the right position, and then the scanning deflector 110 moves each of the plurality of charged particle beamlets in parallel to line start positions of the next lines in each respective subfield 31.11...31.MN. The movement back to line start position of a subsequent scanning line is called flyback. The plurality of primary charged particle beamlets follow in parallel scan paths 27.11 to 27.MN, and thereby a plurality scanning images of the respective subfields 31.11 to 31.MN is obtained in parallel. For the image acquisition, as described above, a plurality of secondary electrons is emitted at the focus points 5.11 to 5.MN, and a plurality of secondary electron beamlets 9 is generated. The plurality of secondary electron beamlets 9 are collected by the objective lens 102, pass the first deflection system 110 and are guided to the detection unit 200 and detected by image sensor 207. A sequential stream of data of each of the plurality of secondary electron beamlets 9 is transformed synchronously with the scanning paths 27.11...27.MN in a plurality of 2D dataset, forming the digital image data of each subfield. According a preselected scan program, the plurality of primary charged particle beamlets follow predetermined scan paths 27.11 to 27.MN. The plurality of digital images of the plurality of subfields is finally stitched together by an image stitching unit to form the digital image of the first image patch 17.1. Each image subfield is configured with small overlap area with adjacent image subfield, as illustrated by overlap area 39 of subfield 31.mn and subfield 31.m(n+1). The pitches between the plurality of primary charged particle beam spots 5.11 to 5.MN of the prior art are typically varying due to drifts, lens distortions and other aberrations. Therefore, the overlap areas 39 of the prior art are typically configured large enough to cover the entire image patch with one image scan, irrespective of fluctuations of the beam spot positions.

In an embodiment of the method of wafer inspection, the throughput of a multi-beam charged particle microscopy system for wafer inspection is increased by reduction of the size of the overlap areas 39. Thereby the size of each image patch is increased, and the throughput is increased. In an example, the beam pitch of the focus points 5 of the plurality of primary charged

particle beamlets is 10μm. If the width of each overlap area 39 of 200nm is reduced for example by 25%, the image patch size is increased by approximately 1% and the throughput is increased by approximately 1%. With an even further reduction by 65% of the width of the overlap areas, throughput is increased by 2.5%. The reduction of the overlap areas 39 is achieved by a control of the pitches of the plurality of primary charged particle beamlets 3. With a compensator such as an active multi aperture plate 306.3 of figure 1, such as a multi-beam multi-pole deflector device, the positions of the beams spots 5 formed by the plurality of primary charged particle beamlets 3 are controlled with high precision. For the control operation, a detector, for example image sensor 207 of the detection unit 200 for detecting the plurality of a secondary electron beamlets 9, is configured to provide a sensor signal representing the positions of the plurality of beam spots 5. Deviations of the beam positions of the plurality of primary beam spots 5 are then corrected, and the overlap area is reduced. With a precision control of each of the primary charged particle beam spots 5 of the plurality of primary charged particle beamlets 3 at the corresponding raster positions with an accuracy below 70nm, an increase of throughput of 2% is achieved. With an even further precision control of the primary charged particle beam spot positions below 30nm, throughput can be increased by more than 3.5%. In a next step, after the digital image of a first image patch is acquired, the wafer is moved by the wafer stage under sensor control to an adjacent, predefined center position 21.2 and a new local wafer coordinate system is defined with center at predefined center position 21.2. The second image patch 17.2 is obtained, such that the two adjacent image patches 17.1 and 17.2 are obtained with an overlap area 19. Again, the size of the overlap area 19 is reduced in analogy to the reduction of the overlap areas 39 as described above and the throughput is increased. The two image patches 17.1 and 17.2 are stitched together to form an image of a predefined wafer area. After acquisition of the digital images of the first inspection site 33, the wafer stage moves the wafer to predefined center position 21.k for image acquisition of a next, second inspection site 35, for example to inspect a process control monitor (PCM) at the predefined wafer area. The scan operation is performed (not illustrated), and image patch 17.k is obtained. As illustrated in this simplified example, by this method several inspection sites of the wafer are inspected in sequence.

Next, the requirements or specifications of a wafer inspection task are illustrated. For a high throughput wafer inspection, the image acquisition of image patches 17.1...k as well as the stage movement between image patches 17.1...k must be fast. On the other hand, tight specifications of image qualities such as the image resolution, image accuracy and repeatability must be maintained. For example, the requirement for image resolution is typically 2nm or below, and with high repeatability. Image accuracy is also called image fidelity. For example, the edge position of features, in general the absolute position accuracy of features is to be determined with high absolute precision. For example, an absolute lateral position accuracy of each of the plurality of primary charged particle beamlets must be below 10nm, and the absolute lateral position of each of the plurality of primary charged particle beamlets must be known with an accuracy below 1nm. Typically, the requirement for the position accuracy is about 50% of the resolution requirement or less. Next, a high image uniformity must be obtained. Image uniformity error is defined by dU = (Imax - Imin) / (Imax + Imin), with maximum and minimum image intensity Imax and Imin of a homogeneous object under image acquisition. Typically, the image uniformity error dU must be below 5%. Image contrast and dynamic range must be enough such that a precise representation of the semiconductor features and material composition of the semiconductor wafer under inspection is obtained. Typically, a dynamic range must be better than 6 or 8 bit, and the image contrast must be better than 80%.

Under high image repeatability it is understood that under repeated image acquisition of the same area, a first and a second, repeated digital image are generated, and that the difference between the first and second, repeated digital image is below a predetermined threshold. For example, the difference in image distortion between first and second, repeated digital image must be below 1nm, preferably below 0.5nm, and the image contrast difference must be below 10%. In this way a similar image result is obtained even by repetition of imaging operations. This is important for example for an image acquisition and comparison of similar semiconductor structures in different wafer dies or for comparison of obtained images to representative images obtained from an image simulation from CAD data or from a database or reference images.

One of the requirements or specifications of a wafer inspection task is throughput. The throughput depends on several parameters, for example speed of the sample stage, the time required for accelerating and decelerating the stage, and the number of iterations required for alignment of the stage at each new measurement site, as well es the measured area per acquisition time itself. An example of enhancement of throughput by increasing the image patch size by reduction of overlap areas is illustrated above. The measured area per acquisition time is determined by the dwell time, resolution and the number of beamlets. Typical examples of dwell times are between 20ns and 80ns. The pixel rate at the fast image sensor 207 is therefore in a range between 12Mhz and 50MHz and each minute, about 20 image patches or frames could be obtained. However, between the acquisition of two image patches, the wafer is laterally moved to the next point of interest by the wafer stage. In an example, the time interval Tr for movement of the wafer from a first image patch to a second image patch is about 1 second, and the frame rate is reduced to about 15 frames per minute. A typical time interval Tr for movement of the wafer with a standard stage from a first image patch to a second image patch, including a time interval for precision adjustment at the second image patch exceeds 1s and can be in the order of 3s or even more, for example 5s. For 100 beamlets, typical examples of throughput in a high-resolution mode with a pixel size of 0.5nm is about 0.045 sqmm/min (square-millimeter per minute), and with larger number of beamlets and lower resolution, for example 10000 beamlets and 25ns dwell time, a throughput of more than 7 sqmm/min is possible. The stage movement including acceleration and deceleration of the stage is one of the limiting factors for the throughput of the multi-beam inspection system. A faster acceleration and deceleration of the stage in short time typically require a complex and expensive stage or induces dynamical vibrations in the multi-beam charged particle system. The embodiments of the invention enable the high throughput of a wafer inspection task while maintaining the image performance specification well within the requirements as for example described above.

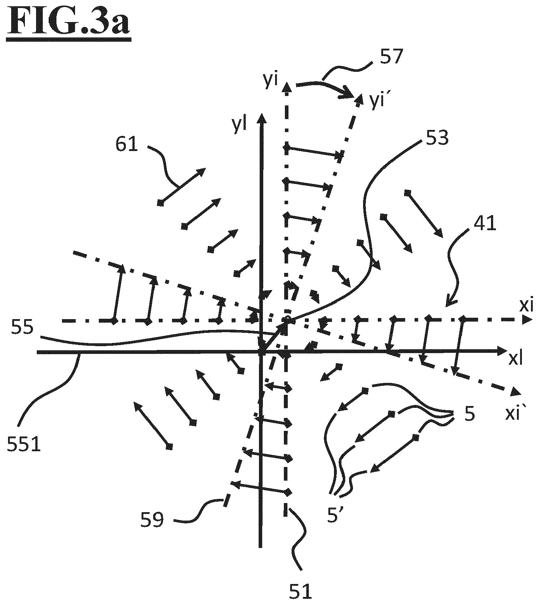

Typically, fast and high throughput image acquisition without control is deteriorated due to drifts and dynamic effects including residual and unwanted stage movements. In general, deviations from ideal image acquisition conditions are described by error functions. An example of an error function in which the plurality of image spots 5 is rotated and displaced with respect to the wafer 7 is illustrated in **Figure 3a** at the example of a circular arrangement of the plurality of beam spots 5. An image coordinate system 51 with image coordinates xi and yi is defined by the virtual coordinate system at the center of an image patch as to be obtained by scanning the set of primary charged particle beamlets with beam spots 5 (three indicated). The center line of the set of primary charged particle beamlets at a predefined center scan position is called the line of sight 53, such that the line of sight 53 and the z-axis of the image coordinate system are identical. In an ideal situation and after proper calibration of the multi-beamlet charged-particle microscopy system, the line of sight 53 and the optical axis 105 of the multi-beamlet charged-particle microscopy system 1 are identical. In a real imaging situation, the line of sight 53 deviates from the optical axis 105 of the multi-beamlet charged-particle microscopy system 1. The deviation for example arises from a drift of the object irradiation unit 100, aberrations in first scanning deflector 110, or of other electrostatic and magnetic elements in primary charged particle beam path 13, such as any of the multi-beamlet generator active elements 330 or beam splitter 400. In a real imaging situation, the deviation of the line of sight 53 changes over time, including over the image acquisition time of one image scan of each image patch 17.1...k.

A local wafer coordinate system 551 is defined at the inspection site of the wafer with local wafer coordinates xl and yl. In a real imaging situation, the local wafer coordinate system 551 deviates from the image coordinate system 51 with the line of sight 53. The displacement vector 55 for example arises from a misalignment of the wafer stage, a drift of the wafer stage or a drift of the image coordinate system 51 or both. In a real imaging situation, the deviation of the local wafer coordinate system 551 changes over time, including over the image acquisition time of one image scan. Displacement vector 55 is in general described as a time dependent vector D(t) = [Dx, Dy, Dz] (t). In a real imaging situation, the displacement vector 55 comprises a difference of the deviation of the line of sight 53 and the drift of the wafer stage 500, both changing independently over time, including over the image acquisition time of one image scan of each image patch 17.1...k.

Image coordinate system 51 can be rotated relative to local wafer coordinate system 551 by rotation angle Rz, indicated by arrow 57, around the z-axis or the line of sight 53, and the image of the image patch 17 from wafer surface 25 is obtained in rotated image coordinate system 59 with coordinates (xi', yi'). Rotation angles can occur at any axis and can be time dependent to form rotation angle vector R(t) = [Rx, Ry, Rz](t). By rotation around z-axis, all image spots 5 are rotated to image spots 5' (the spots indicated), illustrated by displacement vectors 61 between unrotated image spots 5 and rotated image spots 5'. The deviation by image rotation arises either by a rotation of the image spots 5 or by a rotation of the stage around the vertical or z-axis, or both.

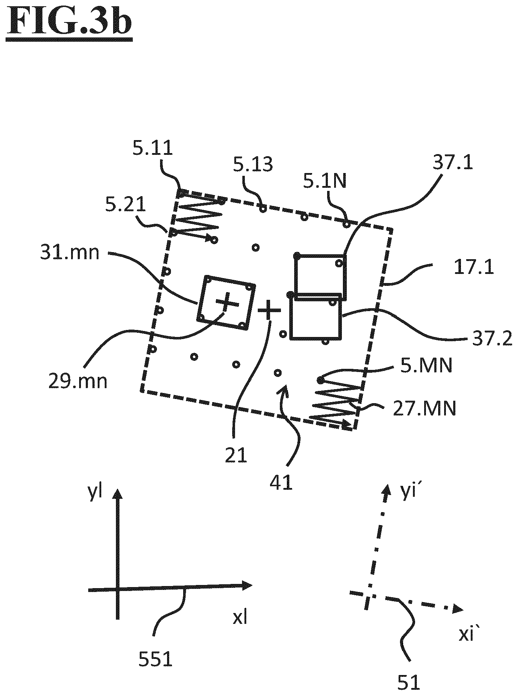

**Figure 3b** illustrates the situation of image rotation at the example of an image patch 17.1 of Figure 2. Same reference numbers are used as in Figure 2, but the imaging coordinate system 51 is rotated with respect to the wafer coordinate system 551. The plurality of focus points 5, arranged in a raster configuration, is rotated, image patches 31 are rotated, and each of the scan paths 27 is rotated. In an embodiment of the invention, illustrated below in more detail, an image rotation is compensated by a rotation of the raster configuration of the plurality of focus points 5. This is different to single beam charged particle microscopes, where an image rotation can be compensated by a dynamic scan rotation, i.e. by a change of the single scanning path to effectively achieve a rotation of the single scanning path. The effect of the scan rotation is illustrated at subfields 37.1 and 37.2 as examples of the effect of scan rotation to the plurality of primary charged particle beamlets at the example of two primary charged particle beamlets. A rotation of scanning paths 27 by the scanning beam deflectors of the multi-beam charged particle microscope is possible, but the raster configuration of the plurality of spots 5 cannot be rotated by the scanning deflectors. To compensate a rotation, including a dynamic change of the rotation of the raster configuration of the plurality of spots 5, additional means are required, as provided in some embodiments of the invention.

The multi-beamlet charged-particle microscopy system according the embodiments of the invention comprises several sensors which provide sensors signals during image acquisition. Sensors are for example a stage position sensor of stage 500, sensors arranged at apertures such as aperture 214, or the image sensor 207. The control unit 800 is configured to extract error functions from the sensor signals, such as image displacement vector D(t), image rotation R(t), including a change of focus position or an image plane tilt. In general, control unit 800 is configured to analyze sensor signals and decompose the sensor signals into a set of individual model error functions by known methods in the art, for example by a fit operation of a set of predefined model error functions with error amplitudes to the sensor data. Such a fit operation can for example be a least-square fitting operation or a singular-value decomposition, and a plurality of error amplitudes for each model error function of the set of model error functions is computed. By computation of error amplitudes, the data amount for control of the plurality of primary and secondary charged particle beamlets 3 and 9 and stage 500 is significantly reduced to for example six error amplitudes. However, in an embodiment of the invention, a larger number of error amplitudes such as magnification error, different higher order distortions and individual field dependent image aberration patterns are considered in the same way. The normalized error amplitudes can describe for example a displacement of a line of sight in both lateral directions, a displacement of a wafer stage in both lateral and axial directions, rotation of a wafer stage, rotation of a line of sight, a magnification error, a focus error, an astigmatism error, or a distortion error. By decomposition of the sensor signals in a limited set of error amplitudes, speed of computation and control of correction signals is significantly improved.

In an example of the embodiments, control unit 800 is configured to analyze the development of error amplitudes over time. A history of the change of error amplitudes over time is recorded and the control unit is configured to expand the change of error amplitudes into time dependent model functions. Control unit 800 is configured to predict a change of at least a subset of error amplitudes for a short period of time, for example during a fraction of an image scan of scan time interval Ts. Scan time interval Ts of an image patch is between 1 seconds and 5 seconds, depending on the dwell time. In a typical example, the scan time interval of an image patch Ts is about 3 seconds. In an example, a slow variation of the predicted change of error amplitudes, generally called the drift, is separated from a fast, dynamic variation of the predicted development of error amplitudes, generally called the dynamic change. In an example, control unit 800 is configured to predict a change of at least a subset of error amplitudes during a time interval Tr in which the stage moves from the first to a second image patch. The time interval Tr in which the stage moves from the first to a second image patch is between 0.5 seconds and 5 seconds. In an example, control unit 800 is configured to predict a change of at least a subset of error amplitudes during a time Td in which the stage deaccelerates from a fast movement to a stop position. In general, control unit 800 is configured for the extraction of at least one of the plurality of control signals, based on a predictive model of an actuation output of the stage.

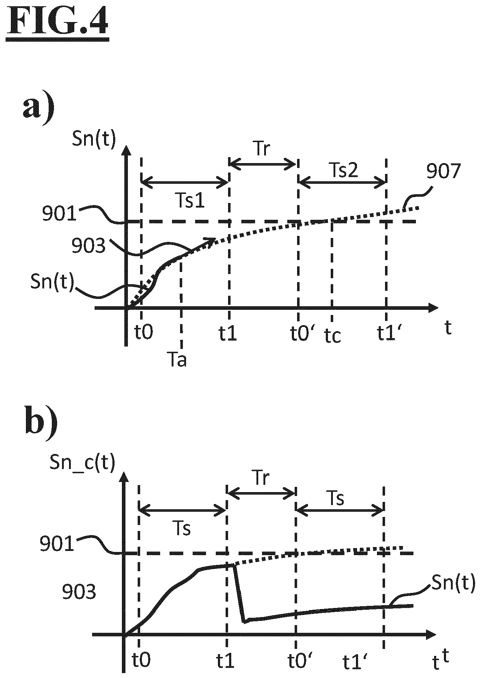

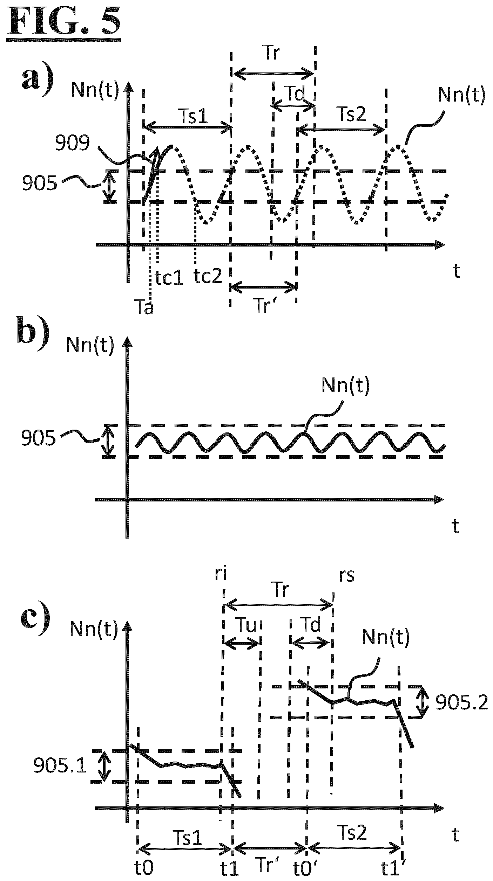

In an example of the embodiments, the development of error amplitudes for the slow varying part, the drift, and for the dynamic varying part or dynamic change of error amplitudes, are extrapolated separately. The drift part, for example, typically shows a linear behavior or asymptotic behavior. For example, thermal effects typically lead to a slow drift with an asymptotic behavior. With a prior knowledge of the development of error amplitudes of time, a development of the drift is derived based on a model function with predetermined asymptotic behavior and the control unit 800 is configured to generate control signals in expectation of predicted error amplitudes. Slowly varying developments or drift of error amplitudes are separated from fast developments, and the drifts of error amplitudes are for example directly forwarded to control the stage 500. **Figure 4** and 5 illustrates the change of a representative error amplitude over time. Figure 4a shows an example of a drift or slowly varying error amplitude Sn(t) with predefined asymptotic behavior of the error amplitude model function 907 over time t. Such behavior is typical for thermal drifts or for drifts of electrostatic or electromagnetic elements, but also other effects have similar development over time. Other sources of drift can be variable electrostriction forces or drifts induced by charging of conductive parts or the wafer during image scan. During operation, control unit 800 is configured to continuously derive the drift error amplitude Sn(t) from the sensor data. The operation time is including the first time interval Ts1 of a first image scan of a first image patch 17.1, the time interval Tr of wafer stage movement from first center position 21.1 of the first image patch 17.1 to the second center position 21.2 of the second image patch 17.2, and in the second time interval Ts2 of a second image scan of a second image patch 17.1 (see figure 2 for reference numbers). For example, at actual time Ta during the first time interval Ts1, a temporal gradient 903 of the error amplitude Sn(t) is determined or the model function 907 is approximated to the measured error amplitude Sn(t). With the error amplitude model function 907 or the gradient vector 903, the development of the error amplitude Sn(t) is predicted and it is predicted that at a future time tc during the second time interval Ts2, the drift part of the error amplitude Sn(t) is reaching a predetermined threshold value Sn_max, indicated by line 901. The threshold is for example predetermined from the specification of the image quality parameter related to the error vector Sn(t). In the time interval Tr between two subsequent image scans of two image patches 17.1 and 17.2, control unit 800 is configured to change control values of compensators accordingly and the drift component of error amplitude Sn(t) is reduced by adjusting active elements of the multi-beam charged particle microscope 1. The active elements can comprise slowly acting compensators, for example magnetic elements or the stage. In an embodiment of the invention, a lateral drift of the line of sight 53 or image coordinate system 51 is compensated for example by adding an offset to the lateral position of the wafer stage 500, and a drift in focal position is compensated for example by adding an offset to the z-position of wafer stage 500. In an embodiment of the invention, a drift of the imaging magnification of the plurality of primary charged particle beamlets 3 would cause a change of the pitch of the plurality of primary charged particle beamlets 3 and is for example compensated by adding an offset current to a dedicated magnetic lens element of objective lens 102. In an embodiment of the invention, a rotation drift of the plurality of primary charged particle beamlets 3 as described in figure 3 is compensated by either a corresponding rotation of the stage 500 around the z-axis or a correction of the rotation of the plurality of primary charged particle beamlets 3 is generated by adding an offset current to a second dedicated magnetic lens element for example of objective lens 102. The result is illustrated in figure 4b. By this adjustment, the corrected slowly varying drift error amplitude $Sn(t)$ is controlled well beyond the error amplitude threshold $Sn\_max$. Since the drift part is slowly varying in time, it is possible to adjust and compensate error amplitude $Sn(t)$ at least partially during the time $Tr$ between to subsequent image scans. Thereby, a method of wafer inspection with a multi-beam charged particle microscope with following steps is given:

- a first image acquisition step of a first image patch during a first time interval $Ts1$,
- a movement of the wafer stage from the position of the first image patch to a second image patch during a time interval $Tr$,
- and a second image acquisition step of the second image patch during a second time interval $Ts2$, whereby,
- during the first time interval $Ts1$, at least a first error amplitude is computed from a plurality of sensor signals,
- during the first time interval $Ts1$, the development of the first error amplitude is predicted at least over the first time interval $Ts1$, the movement time interval $Tr$ and the second time interval $Ts2$,
- and, at least during the movement time interval $Tr$ a control signal is provided to control units of the multi-beam charged particle microscope for keeping the predicted development of error amplitude during the second time interval $Ts2$ below a predetermined threshold.

In an example, the prediction of the development of the first error amplitude is generated according a prediction model or an extrapolation.
In an example, a control signal is provided to control units of the multi-beam charged particle microscope for keeping the predicted development of an error amplitude below the predetermined threshold also during an image scan of time interval $Ts1$ or $Ts2$. For example, if a slow drift of an image coordinate system is predicted, the drift of image coordinate system can be compensated by a slow compensating movement of stage 500 such that $Sn(t)$ is controlled during image acquisition well below threshold $Sn\_max$.
**Figure 5** illustrates the fast, dynamic change of an imaging deviation described by dynamic change of error amplitude $Nn(t)$. Such a dynamic change of an imaging deviation can for example be introduced by internal sources of noise, such as vacuum pumps or other, internal sources of noise, such as vibration induced by fast acceleration and deceleration of the wafer stage. Other sources of noise can be external sources.
The dynamic change $Nn(t)$ shows a simplified periodical behavior with a half period smaller than one scan time interval $Ts1$ or $Ts2$ of one image patch. In an embodiment of the invention, the control unit 800 is configured to derive the dynamic change of error amplitude $Nn(t)$ and to determine a control signal for fast active elements of the multi-beam charged particle microscope 1 with high speed. Such active elements are for example the electrostatic beam deflection scanners or electrostatic correctors, which can be adjusted with high speed. During an image scan of a first image patch with scan time $Ts$, the uncontrolled error amplitude $Nn(t)$ exceeds at least two times $tc1$ and $tc2$ a predetermined error amplitude window $DNn$, indicated by reference number 905. The error amplitude window 905 with an upper and a lower threshold for the error amplitude $Nn(t)$ represents the specification requirement for the image quality parameter represented by error amplitude $Nn(t)$. Control unit 800 is further configured to provide the dynamic control signals to control units of the fast active elements, such that the corrected dynamic deviation or error amplitude $Nn(t)$, illustrated in figure 5b, is controlled between upper and lower threshold of predetermined error amplitude window 905. Control operator 800 is configured with a fast control loop, for example an open control loop, allowing an adjustment and control with bandwidth exceeding the image scan frequency or frame rate $1 / Ts$ of about 0.3Hz by at least a factor of 50, preferably at least a factor 100, or even more preferably a factor 1000. In an example, a computation of an error vector and an extraction of a control signal for compensation if imaging aberrations is performed at least one time each line scan with a control frequency of about 2.5kHz or more. Electrical control signal therefore comprises a signal having a bandwidth in a range of 0.1 kHz to 10 kHz or more.
It should be noted that depending on the frequency response of the control loop of the control operator 800, the frequency of the corrected error amplitude $Nn(t)$ illustrated in figure 5b can be different to the frequency of the uncorrected error amplitude $Nn(t)$ illustrated in figure 5a.
In an example, control unit 800 is configured to predict the dynamic change of the error amplitude $Nn(t)$. For example, by derivation of local gradient 909 at time $Ta$ of the error amplitude $Nn(t)$, control unit 800 is configured to derive control signals for fast active elements for dynamic control during an image scan of time interval Ts1.

A driving error source of misalignment or drift of the wafer stage is the time interval Tr provided to move the stage from a first image patch 17.1 to a second image patch 17.2. Especially, a misalignment or drift of the wafer stage depends on the number of adjustment iterations and the time Td required to decelerate the stage from a movement velocity to stop position in proximity of the second image patch 17.2. In an embodiment of the invention, the time gap between to image acquisition steps of a first image patch 17.1 and a second image patch 17.2 is significantly reduced and throughput is increased. By the embodiment of the invention, a charged particle microscope and a method of operating a charged particle microscope is provided, in with a sequence of image patches is imaged in a sequence of image acquisition steps, comprising a first image acquisition of a first image patch 17.1 in a first time interval Ts1 and a second image acquisition of a second image patch 17.2 in a second time interval Ts2, and further comprising a third time interval Tr for moving the wafer stage 500 from a first center position 21.1 of the first image patch 17.1 to a second center position 21.2 of the second image patch 17.2, such that at least one of the first and second time interval Ts1 or Ts2 has an overlap with the third time interval Tr. The total time interval from start of the first time interval Ts1 to the end of the second time interval Ts2 is shorter than the sum of the three time intervals Ts1, Tr and Ts2 and the throughput is increased and a fast inspection mode is achieved. Figures 5a and 5c illustrates this embodiment of the fast inspection mode with high throughput. In the first example of **Figure** 5a, the image acquisition of a second image patch 17.2 is initiated before the wafer stage 500 has completely stopped. During time interval Td, in which wafer stage is decelerated to an end position, the image acquisition is started and time interval Ts2 of image acquisition overlaps with time interval Td of deceleration of the stage 500. Deceleration time interval Td comprises iterations of the adjustment of the stage and the time required to stop the stage completely. After fast movement, the stage can drift or swing or vibrate, and the time interval Td of deceleration of the stage comprises the time required to retard the stage until its position in coincidence with the line of sight of the multi-beam charged particle microscope with an accuracy below a first predetermined threshold and a dynamic positional stability below a second predetermined threshold. The control unit 800 is configured to monitor or to predict the expected lateral positions XI(t), YI(t) and the movement speed of the wafer stage 500 during time Td. Control unit 800 derives control signals for the scanning deflections units of the charged particle microscope to compensate the residual movement of the wafer stage during deceleration time Td by a variable offset Dx(t), Dy(t) of the line of sight 53. Control unit 800 is configured to compute from the predicted movement speed of the wafer stage a start time of image acquisition of the second image patch 17.2. For example, the start time of time interval Ts2 of image acquisition of the second image patch 17.2 is determined as the time when the predicted speed of wafer stage is below a predetermined threshold, such that the residual movement of the wafer stage during deceleration time interval Td can be compensated. Control unit 800 is configured to start image acquisition by scanning imaging the second image patch 17.2 and provide a temporal function of offset coordinates to the deflection units to compensate the residual movement of the wafer stage during at least a part of the deceleration time interval Td, which overlaps with time interval Ts2 of the second image acquisition. Consequently, the time interval Tr' between a first image scan during first time interval Ts1 and a second image scan during second time interval Ts2 is reduced.

**Figure 5c** illustrates a second example of this embodiment in more detail. In this example, control unit 800 is configured to derive a start time r1 of wafer stage acceleration during the time interval Ts1 of the first image acquisition of the first image patch such that a compensation of a wafer movement by scanning deflectors is within the maximum range of the scanning deflectors of the charged particle microscope. During image acquisition and during at least a part of the time interval Tu for accelerating the wafer stage, control unit 800 is configured to provide control signals to the deflection units, and the error amplitude Nn(t), in this example a lateral position offset of the coordinate systems as described above, is well within the specified threshold range 905.1 for the lateral position offset of the first image patch, and image acquisition is continued after start time ri of wafer movement until the end time t1 of time interval Ts1 of the first image acquisition. During wafer movement in time interval Tr, the control unit 800 is configured to derive a start time t0' of the second time interval Ts2 of the second image acquisition of the second image patch such that a compensation of a wafer movement by scanning deflectors is within the maximum range of the scanning deflectors of the charged particle microscope and the lateral position offset of the coordinate systems is well within the specified threshold range 905.2 for the lateral position offset of the second image patch. The second image acquisition is started at start time t0' during wafer movement with end time r2, when the wafer stage reaches the proximity of its target position. Consequently, the time interval Tr' between a first image scan during first time interval Ts1 and a second image scan during second time interval Ts2 is reduced. The overlapping time interval between the start of a second image acquisition t0' and the deceleration of the wafer stage until the end time rs of the movement time interval Tr of the wafer stage is typically larger than the overlapping time interval between the end of a first image acquisition t1 and the acceleration of the wafer stage starting at time ri of the movement time interval Tr of the wafer stage. In an example, the deceleration time interval Td of the wafer stage comprises at least one iteration of precision alignment of the wafer stage during image acquisition of the image patch at the respective inspection site, whereby the wafer movement is controlled by the control unit synchronously with the deflection units, and the predicted and monitored positions of wafer stage during wafer stage movement are compensated by a sequence or a function of offset coordinates provided to the deflection unit corresponding to the positions of wafer stage. An iteration of precision alignment of the wafer stage is an iterative readjustment of the wafer stage position from a first position with a larger deviation from a target position to a second position with a deviation from the target position below a predetermined threshold. In an example, the threshold is determined according a reduction of the overlapping areas between two adjacent image patches, and is determined for example below 100nm, below 50nm or even below 30nm. Thereby, throughput is enhanced by reduction of the time interval between subsequent image acquisitions and by reduction of the overlap areas between adjacent image patches. In an example, the time interval between to subsequent image acquisitions between a first and a second image patch is reduced by a factor of two, and the throughput or frame rate of the multi-beam charged particle microscope is increased from about 10 to about 14 frames per minute. In a further example, the time interval between to subsequent image acquisitions between a first and a second image patch is reduced by a factor of three, and the throughput or frame rate of the multi-beam charged particle microscope is increased from about 10 to more than 15 frames per minute, and with the method of control of image quality during wafer movement according the embodiment, the throughput is increased by more than 50%. Generally, the method provided allows an image acquisition of at least two distant image patches 17.1 and 17.2 within a shorter time interval TG compared to the time intervals Ts1 and Ts2 required for acquiring each of the two distant image patches 17.1 and 17.2 and the time Tr required for moving the sample from the first to the second inspection site with TG < Ts1 + Ts2 + Tr.

The development or separation of error amplitudes into drift and dynamic change is achieved for example by a Fast Fourier analysis or a moving average computation method. Other methods known in the art are possible. In an example, a predetermined threshold for a maximum gradient of a change of an error amplitude is applied, and a decomposition into the linear drift with maximum gradient and a residual dynamic change with the error amplitude part exceeding the maximum gradient is obtained. A linear part of an error amplitude below the maximum gradient is subtracted, and the dynamic change is obtained by the development of error amplitudes subtracted by the linear drift. The maximum gradient of error amplitude is determined according a maximum speed of a compensator to compensate the linear drift. Such slowly acting compensators can for example be magnetic elements of the multi-beam charged particle microscope. In another example, a predetermined threshold for a maximum frequency of change of an error amplitude is applied, and the drift part is determined by low pass filtering of the development of error amplitudes. In an example, for the separation into the drift part and the dynamic part, the dwell time, the line scan rate and the frame rate is considered. With a dwell time of for example 50ns, the line scan rate is about 2.5kHz. Changes or deviations of the imaging performance with a frequency range of about 10kHz or more can be compensated by control unit 800 and fast compensators of the multi-beam charged particle microscope. It is therefore possible to control fast and dynamic changes or deviations from the imaging performance during a scan of the plurality of lines with the plurality of primary charged particle beamlets. Therefore, during an image acquisition of time interval Ts of about 3s, dynamic changes are compensated a plurality of times, for example each time of a flyback with a control frequency of about 2.5kHz, or even during each linescan with a control frequency exceeding 2.5kHz, for example 5kHz or 10kHz or more. Slow drifts on time intervals of seconds are compensated for example during the time interval Tr' between two successive image scans, for example by slow compensators within time interval Tr' of about below 0.5s. In order to synchronize the compensators with different response time, for example delay lines can be included in the control unit.

The prediction of the development of error amplitudes is computed according an approximation with a polynomial expansion and an extrapolation, for example a linear extrapolation, but also other, higher order extrapolation methods such as second order or higher order extrapolation methods are possible. An example of polynomial extrapolation of higher order is given the Runge-Kutta method. In the example of a slowly varying compensator, such as the moving wafer stage, a prediction of the development of an error amplitude, for example a stage position, is achieved by controlling and monitoring the calibrated performance of the slowly varying compensator such as the wafer stage. The prediction of the development of the error amplitudes can also follow a model, a so-called model-based predictor generates expected error amplitudes according model functions of expected developments of error amplitudes. Such predetermined model functions are for example generated by simulation or by representative test operations of the multi-beam charged particle microscope and are stored in a memory of control unit 800. In an example, such predetermined model functions are individual for each individual multi-beam charged particle microscope. In many examples, the estimation of an error behavior following a predictive model comprises a frequency analysis, a low pass filtering and a polynomial approximation.

The development and extrapolation methods described above, such as the separation of error amplitudes into drift and dynamic change or the application of model functions from a prior knowledge, can be selected different for the different deviations of image performance parameters described by temporal development of the error amplitudes. In an example, the control unit 800 is configured to perform a series of operational steps during an image acquisition of a sequence of image patches, including to

A) expand a data stream forming a plurality of sensor data into set of error amplitudes,
E) extract a set of drift control signals and a set of dynamic control signals, and
F) provide the set of drift control signals to slowly acting compensators, and
G) provide the set of dynamic control signals to fast acting compensators.

In an embodiment, the control unit 800 is further configured to include a step B of approximating a temporal development to at least one of the error amplitudes. In an embodiment, the control unit 800 is further configured to include a step C of predicting a slowly varying drift of at least one of the error amplitudes. In an embodiment, the control unit 800 is further configured to include a step D of predicting a rapidly varying dynamic change of at least one of the error amplitudes.

In an example, the configuration of control unit 800 is comprising the performance of step G of providing the set of dynamic control signals to fast acting compensators in a time interval Ts1 of an image scan of a first image patch of a sequence of image patches.

In an example, the configuration of control unit 800 is comprising the performance of step F of providing the set of drift control signals to slowly acting compensators in time intervals Tr between a first image scan of a first image patch and a second, subsequent image scan of a second image patch of the sequence of image patches. The time interval Tr is defined by the time interval required to move wafer stage 500 from the first center position of the first image patch to the second center position of the second, subsequent image patch to be obtained by scanning imaging with the multi-beam charged particle microscope 1. In an example, the configuration of control unit 800 is comprising the performance of step F of providing the set of drift control parameters to slowly acting compensators in a time interval Ts of one image scan of one image patch.

In an example, the configuration of control unit 800 is comprising the performance of step G in a time interval Ts1 or Ts2 of an image scan of an image patch in at least one overlapping time interval, which is overlapping with time interval Tr for stage movement. In an example, the at least one overlapping time interval is at least a part of the time interval Tu for acceleration of the wafer stage, or at least a part of the time interval Td for deceleration of the wafer stage, or both time intervals.

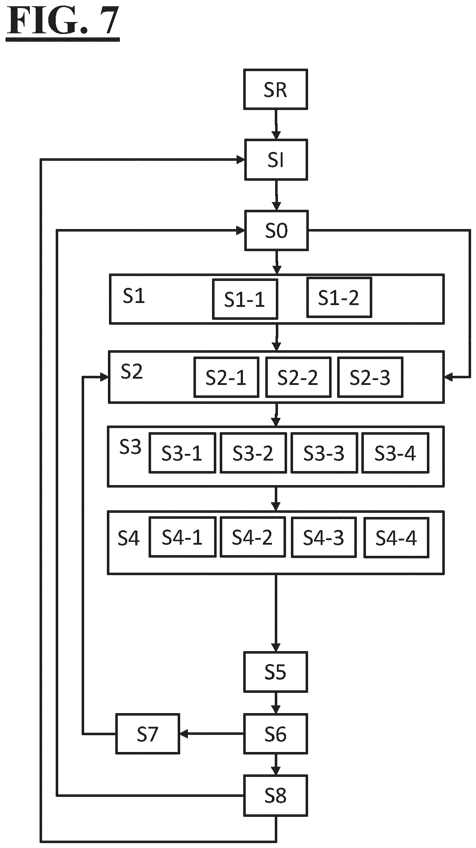

An embodiment of the invention is a method of operation of a multi-beamlet charged-particle microscopy system 1 to perform a wafer inspection task, and a software product for such a wafer inspection task. The method of performing the wafer inspection task comprises software code to perform above mentioned steps A to G. The method is further explained at Figure 7 below in more detail.

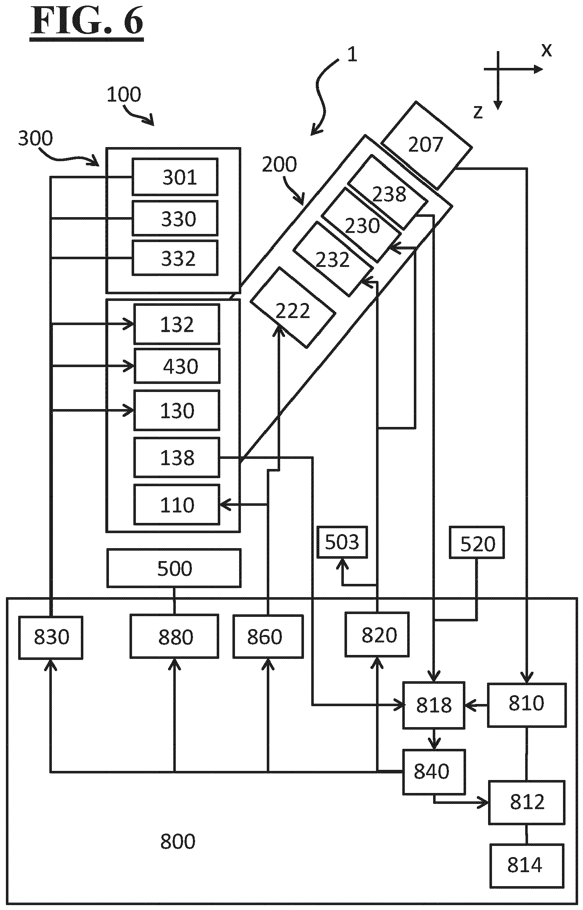

In an embodiment of the invention, the multi-beamlet charged-particle microscopy system 1 for wafer inspection has therefore several measures to compensate drifts, dynamic effects and residual and unwanted stage movements. An example is illustrated in **Figure 6.** Same reference numbers are used as in the previous figures and reference is made to the previous figures. The multi-beam charged particle microscope (1) for wafer inspection comprises a charged-particle multi-beamlet generator (300) for generating a plurality of primary charged particle beamlets (3) and an object irradiation unit (100) comprising a first deflection system (110) for scanning a wafer surface (25) arranged in an object plane (101) with the plurality of primary charged particle beamlets (3) for the generation of a plurality of secondary electron beamlets (9) emitting from the wafer surface (25). The plurality of secondary electron beamlets (9) is imaged by a detection unit (200) with a projection system (205) and a second deflection system (222) for imaging the plurality of secondary electron beamlets (9) onto the image sensor (207) and for acquisition during use a digital image of a first image patch (17.1) of the wafer surface (25). The multi-beam charged particle microscope (1) further comprises a sample stage (500) with a stage position sensor (520) for positioning and holding the wafer surface (25) in the object plane (101) during the acquisition of the digital image of the first image patch (17.1).

The multi-beam charged particle microscope 1 includes a set of compensators comprising at least the first and the second deflection system (110, 222), and slowly acting compensators, such as magnetic elements or mechanical actuators. In an example, the slowly acting compensators comprise the wafer stage 500. The set of compensators further includes a set of fast acting compensators (132, 232, 332) such as electrostatic elements, or mechanical actuators of low mass. The multi-beamlet charged-particle microscopy system 1 is configured with a plurality of detectors comprising the stage position sensor (520) and the image sensor (207), configured to generate during use a plurality of sensor data. The plurality of sensor data includes position and orientation data of the sample stage (500) provided by stage position sensor (520).

The multi-beam charged particle microscope 1 further comprises a control unit (800), wherein the control unit (800) is configured to generate a first set of P control signals $C_p$ from the plurality of sensor data to control the set of compensators during the acquisition of the digital image of the first image patch (17.1), such that during use an operation control is achieved and the specifications mentioned above are maintained during an image acquisition of a sequence of image patches.

During stage movement of stage 500, stage movement is monitored by stage position sensor 520. Stage position sensor 520 are known in the art, and can comprise a Laser interferometer, a grating sensor, or a confocal lens array sensor. During a time interval Ts of an image scan of one image patch of the sequence of image patches, the relative position of wafer stage 500 is preferably controlled with high stability, for example below 1nm, preferably below 0.5nm. As described above, between a first and a second image scan of a first and a second, subsequent image patch, stage 500 is triggered by control unit 800 to move from a first inspection site to a second inspection site. At the second inspection site, a new local wafer coordinate system is defined and stage 500 is controlled by stage control module 880 to be located at its predicted position and the relative position to the line of sight is controlled with high stability. Stage position sensor 520 measures stage position and movement in six degrees of freedom with accuracy below 1nm, preferably below 0.5nm. In an example (not shown), stage position sensor 520 is connected directly to stage control module 880 for a direct feedback loop for control of stage position and movement. However, such a direct feedback loop and control of a wafer stage with high mass is typically slow and does not provide enough accuracy during an image scan. A feedback loop might induce an unwanted stage jitter or lag. According the embodiments of the invention, stage position sensor 520 is therefore connected to sensor data analysis system 818 of control unit 800.

According an example of the embodiment, the control unit (800) comprises an image data acquisition unit (810) which is configured to reduce during use the image sensor data from the image sensor (207) to an image sensor data fraction representing for example less than 10% of the image sensor data and to provide the image sensor data fraction to the sensor data analysis system (818). During use, the electron sensitive image sensor 207 receives a large image data stream of image sensor data of the plurality of secondary electron intensity values and feeds image data to image data acquisition unit 810 of control unit 800. The huge amount of image data is not used directly to monitor the image operation of the multi-beamlet charged-particle microscopy system 1. A small fraction of the image data stream is branched off the image data stream, and an image sensor data fraction is guided to sensor data analysis system 818. For example, image data acquisition unit 810 is configured to branch off a subset of the secondary charged particle signals generated at predefined scan positions of the plurality of charged particle beamlets, or signals generated during flyback of the scanning charged particle beams 3 are extracted and forwarded to sensor data analysis system 818. The predefined scan positions can for example be the line start positions of a subset of scanning lines for example each fifth scanning line, or the center position of each. In an example, an image data of a subset of primary charged particle beamlets, for example only of one beamlet at spot position 5.11 (see Figure 2), is used to generate the image sensor data fraction. US 9,530,613, which is hereby incorporated by reference, shows an example of a dedicated subset of primary charged particle beamlets arranged in the periphery for providing sensor signals for control of a multi-beam charged particle microscope. US 9,536, 702, which is hereby incorporated by reference, shows an example of branching off a dedicated subset of image data of each of the plurality of subfields for the generation of a live view image. At least a part of the live view image data can be applied as image sensor data fraction. By branching off the signal from a predetermined subset of charged particle beamlets, or by using the signals at predetermined scan positions of charged particle beamlets, the image sensor data fraction forwarded to the sensor data analysis system 818 is significantly reduced to a small fraction of the image data stream of about less than 2%, less than 1%, preferably less than 0.5%, even more preferably less than 0.1% or even less than 0.01%. In an embodiment, the image sensor 207 comprises a first, slow and high-resolution image sensor and a second, fast image sensor, as described above in conjunction with Figure 1. In this embodiment, the image sensor data fraction is formed by the sensor data provided by the first slow image sensor and image data acquisition unit 810 is configured to provide the sensor data provided by the first, slow image sensor to the sensor data analysis system 818 and to provide the sensor signal of the second, fast image sensor to the image stitching unit 812.

The image sensor data fraction and the stage position data from stage sensor 520 are combined in sensor data analysis system 818. The sensor data analysis system 818 analyses the image sensor data fraction from image sensor 207 and position information from stage sensor 520 and extracts position information of the wafer stage with respect to the actual image coordinate system of the plurality of primary charged particle beamlets 3, as explained at the example of figure 3.

The control unit (800) of the multi-beam charged particle microscope (1) comprises a sensor data analysis system (818) configured to derive a sensor data vector DV of length L from the plurality of sensor data and to analyze the sensor data vector DV and to extract error functions such as image displacement, image rotation, change of focus position and image plane tilt from the sensor data vector DV. The sensor data analysis system 818 is configured to compute during use a set of K amplitudes $A_k$ of K error vectors, with $K \leq L$. In general, sensor data analysis system 818 is configured to analyze a plurality of sensor signals and decompose the plurality of sensor signals into a set of normalized error functions by known methods in the art, for example by a fit operation of the set of normalized error functions to the plurality of sensor signals.

The control unit (800) further comprises a control operation processor (840) for computing the first set of control signals $C_p$ from the set of amplitudes $A_k$ of error vectors. In the example of a dynamic change of the lateral displacement of image points 5, the control operation processor 840 is configured to derive a correction or control signal for a dynamic change of an error amplitude. The control unit (800) is configured to compensate a change of a position or an orientation of the sample stage (500) by computing and providing at least one of the control signals of the first set of control signals $C_p$ to the first and the second deflection unit (110, 222). Sensor data from the image sensor 207 is synchronized and combined with an information from the stage position sensor 520. A relative lateral displacement vector 55 between the local wafer coordinate system at the inspection site and the image coordinate system, defined by the line of sight, is derived by the sensor data analysis system 818. Control operation processor 840 is configured to provide the correction or control signal to deflection control module 860, which controls operation of the first scanning deflector 110 of the multi-beamlet charged-particle microscopy system 1. As a result, first electrostatic scanning deflector 110 controls the scanning operation of the primary charged particle beamlets 3 in synchronization with unwanted dynamic change of wafer stage 500 in lateral direction, here the x- and y-direction. In parallel, deflection control module 860 also controls operation of the second scanning deflector 222, such that the positions of the plurality of secondary electron beamlets 9 on image sensor 207 are kept constant. Thereby, control unit 800 is configured to compensate a dynamic change of the position of stage 500 in lateral direction by a correction of the scanning operations of primary and secondary charged particle beamlets by first and second deflectors 110 and 222, and image acquisition with high image fidelity and high image contrast is maintained well within the requirements or specifications of the wafer inspection task. The control unit 800 is therefore configured to compute and apply at least an additional voltage signal to the beam deflector 110 in the primary charged particle beam-path 13 for generating during use an additional displacement or rotation of the plurality of primary charged particle beamlets 3 for at least partly compensating the lateral displacement or rotation of the stage relative to the line of sight. The control unit 800 is therefore configured to compute and to apply at least a second additional voltage signal to the beam deflector 222 in the secondary electron beam-path 11 for at least partly compensating the additional displacement or rotation of the plurality of secondary electron beamlets originating from the beam spots 5 of the plurality of primary charged particle beamlets 3 during the adjusted scanning.

Next, an example of an error function is illustrated in which the wafer stage 500 drifts in vertical or z-direction. The set of compensators of the multi-beam charged particle microscope (1) comprises at least one of the compensators (332) of the charged-particle multi-beamlet generator (300), a fast compensator of the object irradiation unit (132) and a compensator (230, 232) of the detection unit (200). Again, an image sensor data fraction is analyzed by sensor data analysis system 818 together with stage position data from stage position sensor 520. The sensor data analysis system 818 analyses the image sensor data fraction from image sensor 207 and position information from stage sensor 520 and extracts position information of the wafer with respect to the actual scanning position and the line of sight of the plurality of primary charged particle beamlets 3. Control operation processor 840 extracts a control signal for focus control of the plurality of primary and secondary charged particle beamlets 3 and 9. Control operation processor 840 of control unit 800 is therefore connected via primary beam path control module 830 to at least one fast compensator 332 of multi-beamlet generator 300, for example an electrostatic focusing lens of the primary charged particle beam path 13, such as electrostatic field lens 308 (see figure 1), or fast compensator 132 of the object irradiation unit, which controls focus position of the plurality of primary charged particle beamlets 3. Control operation processor 840 is also connected to projection system control module 820 to control at least one fast compensator 232 of the detection unit 200, for example electrostatic focusing lens 206 (see figure 1), such that the focus position of the plurality of secondary electron beamlets 9 on image sensor 207 is kept constant. Thereby, primary beam path control module 830 and projection system control module 820 compensates a stage drift of stage 500 in vertical or z-direction, and image acquisition with high contrast and high resolution is maintained well within the requirements or specifications of the wafer inspection task.

In an example, the sensor data analysis system (818) of the multi-beam charged particle microscope (1) is configured to predict a temporal development of at least one amplitude $A_n$ of the set of amplitudes $A_k$ of error vectors. Some of the imaging lenses, for example objective lens 102 or beam splitter element 420 (see figure 1) are magnetic elements, which induce a rotation to the beam paths of the primary and secondary electron beamlets 3 and 9. A static image rotation or drift of image rotation is compensated by for example by magnetic focusing elements of object irradiation unit 100. The control unit (800) is further configured to generate a third signal for positioning the wafer surface (25) by the wafer stage (500) in the object plane (101) for image acquisition of a digital image of a second image patch (17.2), and wherein the control unit (800) is further configured to provide a second set of drift control signals from the plurality of sensor data to control the set of compensators during positioning of the wafer stage (500) to the position of the second image patch (17.2). In an example, control operation processor 840 is connected to primary beam path control module 830. Primary beam path control module 830 is connected to at least one slow compensator 130 of the object irradiation unit 100, or magnetic element 430 of beam splitter 400 (see figure 1), to correct the drift or slowly varying part of rotation of the set of primary charged particle beamlets 3. In an example, a static image rotation is further compensated by a predefined rotation of image sensor 207. Control operation processor 840 is further connected to projection system control module 820, which is in control of slow compensators 230 of secondary electron beam path, for example a magnetic lens. However, magnetic elements can compensate a drift part of the rotation with limited speed.

In an example, the charged-particle multi-beamlet generator (300) further comprises a fast compensator (332), and the control unit (800) is configured to compensate a rotation of the sample stage (500) by computing and providing at least one of the control signals of the first set of control signals $C_p$ to the fast compensator (332) to induce a rotation of the plurality of primary charged particle beamlets. For example, dynamic changes in the wafer stage rotation lead to a fast change and deviation from a predefined orientation of the plurality of primary charge particle beamlets relative to the wafer stage. In the example, the dynamic change of rotation is compensated with high speed. Control operation processor 840 is connected to primary beam path control module 830. Primary beam path control module 830 is further connected to fast compensators 332 of multi-beamlet generator 300, for example active multi-aperture plate 306.3 (see figure 1), which comprises in this example an electrostatic deflector array to individually and fast deflect each of the primary charged particle beamlets to compensate an unwanted dynamic change of rotation of the set of primary beamlets 3 with respect to the local wafer coordinate system. Projection system control module 820 is connected to fast compensators 232 of the detection unit 200, which comprise for example a second multi-aperture plate with an array of electrostatic deflectors to compensate an unwanted dynamic change of rotation of the plurality of secondary electron beamlets 9. Thereby, image rotation during an image scan of an image pitch of a sequence of image pitches is compensated and high image fidelity and image contrast is maintained well within the specifications of a wafer inspection task.

In an example, the stage position sensor 520 comprises a position and a rotation-sensitive sensor, such as for example a double interferometer for each of the x- and y-axis.

In an example, the compensation of the wafer stage rotation is performed during the time interval Tr of movement of the wafer stage from a first image patch to a second image patch, as described above in conjunction with Figure 5a and 5c. Thereby, throughput is increased.

In an embodiment, control operation processor 840 is further connected to image stitching unit 812. Image stitching unit 812 receives the large image data stream from image data acquisition unit 810 and performs a transformation of the image data stream into a 2D image by time-sequential deconvolution of the data stream and image stitching of the image subfields 27 to obtain one image patch 17 (see figure 2). Several image patches, for example first and second image patches 17.1 and 17.2 are stitched together to obtain a 2D image representation of an area of the wafer surface 25. To compensate fast image rotation for example by stage jitter and fast rotation of wafer 7 with respect to image coordinate system, control operation processor 840 is configured to extract a residual rotation of the plurality of image spots 5 during scanning and feeds the residual rotation of spots 5 to image stitching unit 812. Image stitching unit 812 is configured to compensate the residual rotation of spots 5 by known digital image processing methods to obtain the 2D image from the data stream of one image patch with high image fidelity. The final image is finally compressed and stored in image data memory 814.

In an example, control operation processor 840 of control unit 800 is configured to compensate image rotation by drift and dynamic compensation in parallel. Since the compensation of image rotation by a multi-aperture plate configured as deflector array is of limited range, a slowly varying drift offset can be continuously changed by the drift compensators (130, 230, 330) comprising magnetic lenses, and thereby the range for fast varying dynamic compensation is reduced and is achieved by the multi-aperture plates configured as deflector arrays in primary charged particle beam path 13 as well as in the secondary electron beam path 11.

Next, an example of an error function is illustrated in which the plurality of image spots 5 is formed in an image plane which is tilted with respect to the wafer surface. In this example, control operation processor 840 is configured to derive a signal to correct image tilt, which is forwarded to primary beam-path control module 830. Primary beam-path control module 830 is configured to control fast compensators 332 of multi-beamlet generator 300, for example an active multi-aperture plate 306 (see figure 1), which is configured to change focus position of each of the primary charged particle beamlets 3 to effectively achieve a tilted focus plane surface of the plurality of focus spots 5. Thereby, each of the primary charged particle beamlets 3 is in focus at the wafer surface 25 even if the wafer stage 500 is tilted or changes its tilt angle. Control operation processor 840 is further connected to projection system control module 820, which controls fast compensators 232 of the detection unit 200, including for example multi-aperture corrector 220. Fast compensators 232 of the detection unit 200 corrects focus position of each or the secondary electron beamlets 9 such that the beam spots 15 are kept constant in focus position at image sensor 207. Thereby, control operation processor 840, primary beam-path control module 830 and projection system control module 820 are configured to compensate an image tilt, and image acquisition with high contrast and high resolution is maintained throughout an image patch 17.

In an example of the invention and in analogy to the examples above, a direct feedback loop is provided within the control unit 800 between the stage position sensor 520 and first deflection system 110, and the control unit 800 is configured to receive a stage position signal from the stage position sensor 520 and provide at least a first offset signal to the first deflection system 110 to compensate movements of the wafer stage 500 and deviations from target position of the wafer stage 500 by controlling the first deflection system 110. Control unit 800 is further configured to provide at least a corresponding second offset signal to the second deflection system 222. Thereby, fast compensation of position errors or movement of the wafer stage is provided and throughput is increased while maintaining the requirement specifications of a wafer inspection task.

The examples described above off course not only occur in isolation but happen in parallel. The apparatus and error correction methods described above are not limited to the examples described above. Control operation processor 840 is configured to derive control signals in parallel, either by direct feedback or predictive correction or model-based correction as described above, for a set of error amplitudes of a set of imaging deviations. In an example, projection system control module 820 is also connected to sample voltage supply 503 to control the extraction field for extraction of secondary charged particles and thereby to control the collection efficiency of secondary electrons and thereby the intensity of the secondary electron beamlets 9 as well as kinetic energy of the secondary electrons. The kinetic energy is responsible for several other properties, such as the image contrast. In an example, projection system control module 820 is connected to further active elements 230 and 232 of the detection unit 200, such as third deflection systems 218, or correctors such as multipole lenses 216 (see figure 1). In an example, sensors 238 of the secondary electron beam path provides additional sensor signals to sensor data analysis system 818, such as sensor on an aperture element. In an example, a multipole sensor is arranged in the circumference of aperture element 214, which is located at cross over 212 of secondary charged particle beam path 11 (see figure 1). With the signal provided from the multipole sensor, a telecentricity condition of the secondary charged particle beam path 11 is measured. In another example, active and fast elements such as beam steering multi aperture plate 390 (see figure 1) are included in the charged particle microscope 1, for example for a telecentricity correction of the plurality of primary charged particle beamlets 3. Beam steering multi aperture plate 390 is connected to primary beam-path control module 830, which receives controlled signals by control operation processor 840. In an example, sensors 138 included in object irradiation unit 100 provide additional sensor signals to sensor data analysis system 818, such as sensor in proximity of aperture elements or on multi-aperture plates. In an example, an array of coils is included to measure electromagnetic noise in different orientations. In an example, primary beam-path control module 830 is connected to source 301 and is configured to control a source power or charged particle dose provided by source 301. Thereby, a constant charged particle dose is maintained throughout a sequence of image scans of a set of image patches. In an example, vibration sensors such as accelerometers or gyroscopes are attached to elements of the charged particle microscope, for example the wafer stage 500. The vibration sensors measure vibrations and provide the signal to sensor data analysis system 818. Temperature sensors, such as for example a temperature sensor in the magnetic lenses or in the return run of the cooling fluid provide indicators of the status of elements of the system and the about expected drift behavior of some image qualities. All sensor signals can be for example calibrated at simulated inspection tasks at test samples to provide representative sensor data of a wafer inspection task. The representative sensor data can be used to configure the sensor data vector and to extract the amplitudes of the normalized error vectors form the sensor data vector of a real wafer inspection task.

In general, control operation processor 840 of control unit 800 is configured to derive correction signals from the error amplitudes to compensate slow varying developments of error functions such as for example a slow drift of stage 500. Control operation processor 840 derives from the dynamic changes of error amplitudes a correction strategy for fast compensation of dynamic changes and distributes control signals to primary beamlet control module 830, projection system control module 820 and deflection control module 860 to compensate the fast or dynamic change of error amplitudes as for example fast vibration of the stage 500. Drift and dynamic changes of error amplitudes are computed by sensor data analysis system 818 of control unit 800, and can either be directly derived, based on an extrapolation, or based on a model-based control. The correction strategy can follow a look-up table, or the error amplitudes are decomposed by a linear decomposition into predetermined correction functions provided by the different active elements of the charged particle microscope 1. Control operation processor 840 therefore also monitors the actual status and the status changes of the active elements of charged particle microscope 1. In an example, control operation processor 840 is configured to accumulate the history of provided control signals to active elements such as secondary electron path active element 230, 232, primary beam-path active elements 330 and 332, deflector units 110 or 222, and thereby predict the actual status of the active elements of charged particle microscope 1.

An aspect of the invention is the derivation of the error vectors, and the drive signals to drive the compensators to optimize the image quality parameters during use of the multi-beam charged particle microscope, as illustrated at figure 1 in conjunction with **figure 6.** The aspect is illustrated at the primary beam path, similar considerations are applied in analogy to the elements of the detection unit 200. In Figure 1 and 6, a typical subset of the elements of the primary beam path of the charged particle microscope is illustrated, with charged particle source 301, first and second collimating lenses 303.1 and 303.2, a first and a second active multi-aperture plate arrangement 306.1 and 306.2 (only one shown), first field lens 308, second field lens 307, third field lens 103.1 and forth field lens 103.2, beam steering multi aperture plate 390, first and second objective lenses 102.1 and 102.2 (only one shown), and sample voltage supply 503 and stage 500. Control unit 800 is configured to provide to all these elements during use at least one control signal, for example a voltage or a current, or both. Multi-aperture arrangements are provided with a plurality of voltages, for example at least an individual voltage for each of the plurality of primary charged particle beamlets. For a multi-beamlet charged-particle microscopy system with 100 primary charged particle beamlets, approximately about 50 different driving signals are applied during use to the global elements, and about 200 to 800 different voltages are applied to each of the multi-aperture arrangements, and the number of individual voltages or currents can exceed approximately 10 times the number of primary charged particle beamlets. Prior to the operation of the multi-beamlet charged-particle microscopy system according the embodiments of the invention, a set of image qualities is defined according the specification of the wafer inspection task. Some of the specifications are described above. The set of image qualities are forming an image quality vector, and the amount of deviation of an imaging quality corresponds to the amplitudes of an error vectors. For convenience, the set of error vectors is normalized to form a set of normalized error vectors. The sensitivity, i.e. the amount of change of the set of imaging qualities with respect to changes of a driving signal applied each of the set of elements of the primary beam path is determined, for example by simulation or by a calibration measurement. For example, in calibration measurements, the representative sensor data set is measured by the set of sensors or detectors, and a sensor data vector is generated for each sensitivity. A sensitivity matrix of the sensitivities of the elements of the primary beam path is formed. The sensitivity matrix forms a linear perturbation model of the multi-beam charged particle microscope with respect to the set of imaging qualities relevant for wafer inspection task and is typically not orthogonal. The sensitivity matrix is analyzed for example by singular value decomposition or similar algorithms, and, for each image quality, at least a basis set of driving signals is selected as control signal for compensators for compensating deviations or aberrations of an image quality and thereby reducing the amplitude of the corresponding error vector. In an example, the sensitivity matrix is decomposed by splitting the matrix into two, three or more kernels or subsets of independent sensitivity kernels, corresponding to specific subsets of the set of image qualities. Thereby, complexity of computation is reduced, and nonlinear effects or higher order effects are reduced.

In an example, at least a kernel of the sensitivity matrix depends from the temperature of the multi-beam charged particle microscope. For example, a temperature change of the column or elements of the column of the multi-beam charged particle microscope results in focus drift, magnification drift or stigmation drift. The detectors provided in the multi-beam charged particle microscope comprise temperature sensors, for example temperature sensors in the cooling water or attached to mechanical components, multi-aperture plates, or inside of magnetic elements. Thereby it is possible to perform an orthogonalization of the respective kernel of the sensitivity matrix at a plurality of representative temperatures and use a temperature corrected sensitivity matrix for the computation of corresponding drive signals for the compensators depending on the temperature signals. The consideration of the actual temperature and the application of a temperature corrected sensitivity matrix and corresponding drive signals are of special relevance for the repeated step of calibration of the multi-beam charged particle microscopy system as described below. In a simplified example, the plurality of temperature sensors is reduced, and an expected temperature is predicted from an operation history of the of the multi-beam charged particle microscopy system.

In an example, a first basis set of driving signals is selected for fast compensators, for example comprising electrostatic compensators and deflectors, such as fast compensators 332 of the multi-beamlet generator, first deflection system 110, fast compensator 132 of the object irradiation unit 100 and a second basis set of driving signals is selected for slowly acting compensators comprising for example magnetic elements, such as slow compensators of object irradiation unit 130 of figure 6. In an example, each basis set of driving signals is thereby minimized to a minimal number of driving signals, such that the number of control operators of individual elements are reduced, and computation time is reduced, and the set of image qualities can be controlled within a requirement specification of a wafer inspection task.

Each basis set of driving signals is stored in the memory of control unit 800, for example in a memory of the primary beam path control module 830. The control operation processor 840 derives a set of control signals from the set of amplitudes of error vectors. The primary beam path control module 830 derives a set of driving signals from the basis set of driving signals, for example by multiplication with the set of control signals computed by the control operation processor 840. The secondary beam path control module 820 derives a set of driving signals from the basis set of driving signals, for example by multiplication with the set of control signals computed by the control operation processor 840.

A method of preparing the operation of a multi-beam charged particle microscope configured for wafer inspection comprises therefore the definition of a set of image qualities and a set or normalized error vectors describing deviations from the set of image qualities in conjunction with a sensor data vector. A set of thresholds for the amplitudes of the set or normalized error vectors is determined in accordance with the imaging specifications of the wafer inspection task as described above, and a preselection of a set of compensators of the multi-

beam charged particle microscope is performed. The set of compensators comprise a first deflection unit of the multi-beam charged particle microscope for scanning and deflecting the plurality of primary charged particles and a second deflection unit for scanning and deflecting the plurality of secondary electrons generated during use of the multi-beam charged particle microscope. The method of preparing the operation of the multi-beam charged particle microscope for wafer inspection further comprises the determination of a sensitivity matrix according to a linear and / or nonlinear perturbation model by variation of at least a drive signal for each of the compensators of the set of compensators. The sensitivity matrix is analyzed for example by singular value decomposition or similar algorithms. In an example, the sensitivity matrix is decomposed by splitting the into two, three or more kernels or independent subsets of image qualities. Thereby, complexity of computation is reduced, and nonlinear effects or higher order effects are reduced. The method of preparing the operating of the multi-beam charged particle microscope for wafer inspection further comprises the derivation of a set of normalized drive signals for compensating each of the set of normalized error vectors. The normalized error vectors, the normalized drive signals and the set of thresholds are stored in a memory of a control unit of the multi-beam charged particle microscope, forming the predetermined error vectors and predetermined drive signals.

During use, for example during a wafer inspection, the method of operating the multi-beam charged particle microscope comprises further the step of receiving a plurality of sensor data from a plurality of sensors of the multi-beam charged particle microscope forming a sensor data vector. In an example, the plurality of sensor data comprises at least one of a position or speed information of the actual position and actual velocity of a wafer stage for holding a wafer during inspection with the multi-beam charged particle microscope. The set of sensors for generating plurality of sensor data is prepared and configured such that the predetermined error vectors can be derived unambiguously, and, during use, a set of actual amplitudes of normalized error vectors is derived from the sensor data vector, representing an actual state of the set of image qualities of the multi-beam charged particle microscope. A set of control signals is derived from the set of actual amplitudes and a set of actual drive signals is derived from the predetermined normalized drive signals, for example by multiplication with the control signal. A control unit controls the compensators of the multi beam charged particle microscope and provides the set of actual drive signals to the set of compensators such that set of actual amplitudes is kept below the set of thresholds and operation of the wafer inspection task is maintained well within the imaging specifications. In **Figure 7,** a method of operation according an embodiment of the invention is explained in more detail. Same reference numbers of Figures 1- 6 are used for illustration. For wafer inspection, a multi-beam charged particle microscope (1) includes a plurality of detectors comprising an image sensor (207) and a stage position sensor (520) and set of compensators comprising at least a first and a second deflection system (110, 222). In a memory of the control unit 800 of the multi-beam charged particle microscope (1), the thresholds for the amplitudes of error vectors and at least set of normalized drive signals are stored.

In a first step SR, the wafer inspection task is registered, for example by an operator or instructions are provided by an external operating system. The loaded wafer is aligned and registered in a predefined global wafer coordinate system of the multi-beam charged-particle microscopy system 1. A wafer inspection task comprises a sequence of inspection sites (for example 33, 35 of figure 2). From the sequence of inspection sites, a sequence of image acquisition tasks of a plurality of wafer areas at at least a first and a second inspection site 33 and 35 is generated. At least one inspection site can comprise at least a first and a second imaging patch 17.1 and 17.2. Each of the imaging patches of a lateral dimension PX is imaged a multi-beam charged particle microscope 1 by a plurality of primary charged particle beamlets 3, configured in a raster array, wherein each of the plurality of primary charged particle beamlets 2 is scanned over each of the subfields 31 of lateral dimension SX. The plurality of subfields scanned by the plurality of primary charged particle beamlets 3 is stitched together to form the image patch 17. The lateral dimension SX of a subfield is typically $10\mu m$ or less, the image dimension PX of one image patch 17 is typically about $100\mu m$ or more. The number of primary beamlets 3 is typically 10 x 10 beamlets or even more beamlets, like 300 beamlets, or 1000 beamlets. Preferred raster configurations are for example a hexagonal raster, a rectangular raster, a circular raster with beamlets arranged on at least on circle, but other raster configurations are possible as well.

The first and second patch center positions 21.1 and 21.2 of the image patches 17.1 and 17.2 are computed from a list of inspection task comprising the positions of the inspection site 33 on the wafer surface and the area of the inspection task. If a lateral dimension of the area of an inspection site exceeds an image patch, the area of the inspection site is divided into at least two image patches 17.1, 17.2 with the at least first and second patch center positions 21.1, 21.2. The first and second center patch positions 21.1, 21.2 are transformed in wafer coordinates and define the first and second local wafer coordinate systems relative to the global wafer coordinate system. Thereby, a list of a plurality of local wafer coordinate systems for acquisition of corresponding image patches 17.1 and 17.2 is generated.

It is understood that each time a plurality of members is explained by a first and a second member, the plurality can contain more than two members, for example an inspection task can contain a plurality of 50, 100 or more inspection sites, and each inspection site can contain a plurality of 2, 4, or more image patches.

In Step SI the status of the multi-beamlet charged-particle microscopy system is determined for example from an operation history or from an initialization of the multi-beamlet charged-particle microscopy system 1. The initialization of the multi-beamlet charged-particle microscopy system 1 can comprise a calibration of the system, if a corresponding trigger signal is provided. A selected beamlet of the plurality of charge particle beamlets 3 can be used for the calibration of the system. At least one reference sample attached to a dedicated holder on the wafer stage 500 or a second metrology stage can be used for calibration of the system and for the determination of the line of sight 53 of the charged particle microscope and wafer stage position. Two or more reference samples at different positions can be used for calibration of different image performance functions, such as magnification, distortion, or astigmatism.

Step S0 includes positioning and aligning a wafer surface (25) of a wafer with a position of a local wafer coordinate system (551) with a line of sight of the multi-beam charged particle microscope (1). The wafer is positioned and aligned with the next local wafer coordinate system 551 underneath the optical axis or line of sight 53 of multi-beamlet charged-particle microscope 1. The next local wafer coordinate system 551 can be either the first or any subsequent local wafer coordinate system 551 from the list of local wafer coordinate systems generated in step SR.

The wafer stage 500 is triggered to move the wafer such that the local wafer coordinate systems 551 is aligned with the line of sight 53 of the charged particle microscope. The alignment of each local wafer coordinate systems by movement of the wafer stage is performed optionally by help of patterns formed or visible on the wafer surface. The adjustment is stopped, when the difference vector between the image coordinate system 51 with the line of sight 53 as z-axis of the multi-beam charged particle microscope 1 and a local wafer coordinate system 551 is below a threshold. The difference vector 55 is for example a vector comprising the six degrees of freedom for movement of the stage, including displacement and rotation or tilt. For a fine adjustment, the difference vector can be below 50nm in lateral direction or even less, and below 100nm in direction of the line of sight or focus direction. A threshold for an image rotation at the z-axis is typically 0.5mrad, and the threshold for a tilt with respect to the x-y-plane image coordinate system is typically 1mrad. The fine adjustment can include a least an imaging step of the inspection site and several iterations of stage movements.

In an embodiment of the invention, a fast operation mode of wafer inspection task is selected, and the requirement to the precision adjustment is relaxed by and increased threshold by a factor of 2 or even a factor of 10, or even more, and the residual difference vector exceeding the threshold is compensated by the set of compensators of the multi-beam charged particle microscope 1. For that purpose, a plurality of offset error vector amplitudes is generated by the control unit 800 and provided to step S2 below.

In step S1, an image acquisition is performed to acquire a digital image of a first image patch (17.1) of the wafer surface (25) and a plurality of sensor data from the plurality of detectors is collected. An inspection task from the sequence of inspection sites is performed. Step S1 comprises at least:

- In step S1-1, the process of image acquisition by scanning imaging of a first image patch 17.1 is started. Each image patch 17 is preferably imaged with a stage 500 adjusted in coincidence with the line of sight 53 of the multi-beam charged particle microscope 1 according step S0, or with a stage moving at low velocity as described above.
- In step S1-2, and parallel with step S1-1, a plurality of sensor data is generated by a plurality of detectors. The plurality of detectors comprises at least the stage position sensors 520 and the image sensor 207. In an example, the plurality of detectors comprises in addition other detectors of the multi-beamlet charged-particle microscope, such as sensors 238 and 138, which generate sensor data during image acquisition. The plurality of sensor data can also comprise the currents or voltages applied to electrostatic and magnetic elements. Other examples of sensors providing sensory data are for example temperature sensors, for example a temperature sensor monitoring the temperature in the cooling fluid, or of magnetic elements.

The imaging of step S1-1 comprises the collection of the plurality of secondary electrons created at the positions where the plurality of primary charged particle beamlets 3 interacts with the wafer surface 25. From the secondary electrons, a plurality of secondary electron beamlets 9 is formed. Each of the plurality of secondary charged particle beamlets 9 is separately detected, and thereby a digital image of the image patch 17 at the respective local wafer coordinate system 551 is obtained.

During step S2, the plurality of sensor data is evaluated in the sensor data analysis system 818. Step S2 comprises at least:

- In S2-1, the plurality of sensor data from the different sensors is combined to a sensor data vector DV(i) of length L at the actual time $T_a$, and expanded sensor data vector DV(i) in a set of K predefined error vectors $E_k(i)$ of length L. The set of predefined error vectors $E_k(i)$ is representative for deviations of the set of image quality parameters of the image acquisition, as described above. A set of K error amplitudes $A_k$ of the set of predefined error vectors $E_k(i)$ is computed such that

$$DV(i) = \sum_k A_k \cdot E_k(i) + \varepsilon$$

with residual error vector ε below a predetermined threshold. During the computation of the error amplitudes $A_K$, the plurality of offset error vector amplitudes or the predicted temporal behavior of offset error vector amplitudes generated in step S0 is considered. In an example, K has the size of six, representing the six degrees of freedom of differences between the local wafer coordinate system and the line of sight, but in general, K is larger than 6, for example the set of error vectors comprises K = 14 error vectors including six degrees of freedom of differences between the wafer stage position, the local wafer coordinate system and the line of sight, magnification change, anamorphic distortion change, astigmatism, field curvature, third order distortion and chromatic aberration. In general, K is smaller compared to L, i.e. K < L. The number L of sensor data forming the sensor data vector DV(i) can be 10 or more, but L is preferably a reduced number to increase computation speed, for example K < L < 4 K. For example, if K = 14, L is preferably below 50. By reduction of the plurality of sensor data to error vectors of reduced length L and K error vector amplitudes, the amount of data is reduced, and computation time is increased.

- In S2-2, a subset of development amplitudes of at least a subset of the set of actual amplitudes is predicted according an expected development of the multi-beam charged particle microscope in a prediction time interval. A temporal development of at least a subset of n error amplitudes $A_n$ is derived and the subset of the error amplitudes is considered as time-dependent functions $A_n(t)$. An example of a derivation of the temporal development of an error amplitudes $A_n(t > Ta)$ in the prediction time interval after actual time $T_a$ is an extrapolation from the history of an error amplitude $A_n(t < T_a)$, either by linear or higher order extrapolation as described above. Therefore, during use at least a subset of the set of actual amplitudes of the multi-beam charged particle microscope is recorded for generating a history of the subset of the set of actual amplitudes. Another example of a derivation of the temporal development of an error amplitudes $A_n(t > T_a)$ is an approximation of the history of an error amplitude An(t) to a predefined set of model functions $M_n(t)$.

- In S2-3, the temporal development of at least a subset of error amplitudes $A_n(t)$ is separated in a drift part $S_n(t)$ and a dynamic change $N_n(t)$ of the temporal development of amplitude $A_n(t) = S_n(t) + N_n(t)$.

In an example, the predefined error vectors comprise image aberrations introduced in the primary charged particle beam path. Aberrations in the primary charged particle beam path comprise distortions such as a magnification errors, anamorphic distortions such as keystoning, or third and higher order distortions. Other aberrations are for example field curvature, astigmatism or chromatic aberrations.

In an example, the predefined error vectors comprise image aberrations introduced in the secondary electron beam path 11. Aberrations in the secondary electron beam path 11 for example reduce the collection efficiency of secondary electrons and for example induce reduced image contrast and increased noise.

In an example, the combination of the plurality of sensor data to the sensor data vector DV(i) comprises the computation of the difference of several sensor data, for example the difference between positional coordinates of the line of sight of the multi-beam charged particle microscope and the position and orientation data of the stage position sensor.

In an example, a filter is applied to at least one of the temporal developments of error amplitudes $A_n(t)$ such that a specific signature of a selected error amplitude is subtracted from the temporal development of error amplitude $A_n(t)$. Thereby, the specific signature of a temporal development of error amplitude $A_n(t)$ which does not affect the image quality is subtracted and the amount of control operations is reduced.

In an example, the set or error vectors is derived from the capabilities of a set of compensators available in the multi-beam charged particle microscope, such that the set or error vectors can be compensated by control of the actuation of the set of compensators. In an example, a possible set of error vectors is derived from imaging experiments, and the multi-beam charged particle microscope is provided with a set of compensators capable for compensation of the set of error vectors.

In an example, the amplitudes or the development of amplitudes of the set of error vectors are compared to a predetermined set of thresholds, which is stored in the memory of the control unit 800.

During a wafer inspection task, a set of predictive control signals is determined from the development of the amplitudes and a set of predictive drive signals from the set of predictive control signals, and the set of predictive drive signals are provided to the set of compensators in time sequential manner, thereby reducing during the prediction time interval the subset of actual amplitudes below the respective of thresholds.

In step S3, a set of P control signals $C_p$ is derived from the set of error amplitudes $A_k$. The deviations and amplitudes of error amplitudes $A_k$, including the temporal development of error amplitudes $A_n$ of error functions $E_n$, are analyzed and mapped to a set of P control signals $C_p$ by a control operation processor 840 with a predefined mapping function MF:

MF: $A_k \rightarrow C_p$

The mapping with predefined mapping function MF of the set of K error amplitudes to the set of P control signals is for example achieved by look-up tables, matrix inversion, or numerical fit operations such as singular value decomposition.

In an example, different groups of error vectors are treated in parallel in different error vector categories.

For example, coordinate system drifts of two coordinate systems defined by the line of sight and a local wafer coordinate system are treated separately in a coordinate error category. Higher order imaging aberrations or telecentricity aberrations are treated in respective error vector categories. Thereby, the set of control signals for a set of error vectors is computed in parallel and with high speed.

In step S3-1, a set of deflection control signals is derived from the set of control signals $C_p$.

In step S3-2, a set of primary control signals is derived from the set of control signals $C_p$. The primary control signals are selected to control compensators of the primary beam-path to compensate imaging aberrations such as defocus, image plane tilt, field curvature, magnification, astigmatism, chromatic aberration, telecentricity aberration, or other, higher order aberrations.

In step S3-3, a set of secondary control signals is derived from the set of control signals $C_p$.

In step S3-4, a set of image processing control signals is derived from the set of control signals $C_p$. The set of image processing control signals comprises a subset of image stitching components $IS_p$ to be considered during image stitching.

In an optional step S3-5 (not shown), a set of stage control signals is derived from the set of control signals $C_p$.

In step S4, the set of control signals $C_p$ is provided to at least one control module of the set of control modules comprising projection system control module 820, primary beam-path control module 830, deflection control module 860, stage control module 880, and image stitching unit 812. Each of the control modules derive from the set of control signals $C_p$ a set of actuation values or drive signals, for example sequences of voltages or currents, to be supplied to at least on compensator of the set of compensators to compensate an imaging aberration represented by an error vector of the set or error vectors. A first of control signal is provided during step S1 of image acquisition to a set of compensators. A second subset of control signals is stored in a memory and provided to step S0 for application during positioning and aligning the next local wafer coordinate system.

In step S4-1, a set of deflection control signals is provided to deflection control module 860. In order to compensate a set of error vectors representing image aberrations, first the lateral position of the focus points 5 of the plurality of primary charged particle beamlets 3 are corrected, such that the focus points are formed on the wafer surface 25 at the predefined lateral positions, defined by the local wafer coordinate system 551 and the predefined raster configuration with a lateral position accuracy of below 10nm or even less. The lateral alignment of the focus points 5 with the predefined positions is controlled by the first deflection unit 110, deflecting the plurality of primary charged particle beamlets 3. Thereby, for example a change of a position or an orientation of the sample stage (500) is compensated by providing con-

trol signals $C_p$ to the first and the second deflection unit (110, 222).

An example of a control signal $C_p$ of the set of deflection control signals is therefore a primary offset signal provided to deflection control module 860. The deflection control module 860 derives a first offset signal for the first deflection unit 110, comprising an electrostatic deflection scanner and the plurality of primary charged particle beamlets 3 is scanned over the wafer surface 25 with scanning paths 27 with an offset position. Thereby, a lateral displacement vector 55 between local wafer coordinate system 551 and line of sight 53 of the multi-beam charged particle microscope 1 is compensated and a correction of the line of sight 53 is achieved such that it deviates from the local wafer coordinate system 551 by less than a predefined threshold or for example 10nm, 5nm or even 2nm, or even below 1nm.

Further, by providing a second offset signal to the second deflection unit 222, the focus points 15 of secondary electron beamlets 9 are kept at constant position at the image detector 207 and a high image contrast and image fidelity is achieved. In order to keep the positions of the focus points 15 of the plurality of secondary electron beamlets 9 at constant positions at the image sensor 207, the plurality of secondary electron beamlets 9 pass the first deflection unit 110 and a second deflection unit 222. After changing the scanning paths 27 of the plurality of primary charged particle beamlets 5 on the wafer surface 25 with an offset position, the second, independent deflection unit 222 is provided with a second offset signal of the set of deflection control signals, and the offset position of focus points 5 on the wafer surface 5 is compensated by the second deflection unit 222 such that the focus points 15 of the plurality of secondary electron beamlets 9 is kept constant at the image sensor 207.

The offset position can change over time, and the offset control signals are changed during an image scan of an image patch 17. Thereby, for example a lateral drift or jitter of sample stage 500 is compensated.

In step S4-2, a set of primary control signals is provided to primary beam-path control module 830. In order to compensate a set of error vectors representing image aberrations, the longitudinal position of the focus points 5 of the plurality of primary charged particle beamlets 3 are corrected, such that the focus points are formed on the wafer surface 25 with an accuracy below the depth of field of the multi-beam charged particle microscope. A multi-beam scanning electron microscope typically has a depth of field of about 10nm-100nm, and the specification of the maximum focus spot deviation from an image plane is below 10nm, or preferably below 5nm. The image aberration of the focus points 5 of the plurality of primary charged particle beamlets 3 comprise defocus, image plane tilt and field curvature.

For example, a primary control signal to correct image plane tilt is provided to primary beam-path control module 830, and primary beam-path control module 830 derives a set of focus correction voltages for an active multi-aperture plate arrangement 306, for example a multi-aperture lens array. Thereby, each of the focus positions of each individual primary charged particle beamlet 3 is changed individually and an image plane tilt is achieved in order to compensate for example a tilt of the sample stage 500 with respect to the image coordinate system 51.

In another example, a primary control signal to correct defocus is provided to primary beam-path control module 830, and primary beam-path control module 830 derives a voltage change for a field lens 306 to change the image plane position in z-direction as a whole. Thereby, the focus positions of the plurality of primary charged particle beamlets 3 is changed in order to compensate for example a movement of sample stage 500 in the z-direction, the propagation direction of the primary beamlets 3.

In another example, a primary control signal to correct a rotation between image coordinate system 51 and local wafer coordinate system 551 is provided to primary beam-path control module 830, and primary beam-path control module 830 derives a set of deflection voltages for the active multi-aperture plate arrangement 306, for example a multi-aperture deflector array. Thereby, each individual primary charged particle beamlet 3 is deflected individually and a rotation of the image coordinate system 51 is achieved in order to compensate for example a rotation of the sample stage 500 with respect to the image coordinate system 51.

Other control signals to correct other image aberrations of the primary beam-path are provided accordingly. Imaging aberrations of the primary beam path comprise aberrations such as magnification change, astigmatism, chromatic aberration. The set of primary control signals comprises control signals to control compensators of the primary beam path, including compensators of the charged-particle multi-beamlet generator 300 and the object irradiation unit 100.

In step S4-3, a set of secondary control signals is provided to projection system control module 820. To compensate a set of error vectors representing image aberrations, the imaging aberrations of the secondary beam path or of the detection unit are corrected.

For example, a secondary control signal to correct image plane tilt is provided to projection system control module 820, and projection system control module 820 derives a set of focus correction voltages for multi-aperture corrector 220, for example a multi-aperture lens array. Thereby, each of the focus positions of each individual secondary electron beamlet 9 is changed individually and an image plane tilt is achieved to compensate for example a tilt of the sample stage 500 with respect to the image coordinate system 51 and an imaging of the secondary electron beamlets 9 from the tilted wafer surface 25 on the image detector 207 is maintained.

In another example, a secondary control signal to correct defocus is provided to projection system control module 820, and projection system control module 820 derives a voltage change for an electrostatic lens 206 to change the image plane position as a whole. Thereby, the focus positions of the plurality of secondary electron beamlets 9 is changed to compensate for example a movement of sample stage 500 in the z-direction, the propagation direction of the primary beamlets, and an imaging of the secondary electron beamlets 9 from the defocused wafer surface 25 on the image detector 207 is maintained.

In another example, a secondary control signal to correct a rotation between image coordinate system 51 and local wafer coordinate system 551 is provided projection system control module 820, and projection system control module 820 derives a set of deflection voltages for the multi-aperture corrector 220, for example a multi-aperture deflector array. Thereby, each individual secondary electron beamlet 9 is deflected individually and a rotation of the image coordinate system 51 is compensated to image the plurality of secondary electron beamlets 9 on the image detector at constant, predefined positions.

The examples illustrate the compensation of image aberrations in the primary beam path 13 and the secondary electron beam 13 in conjunction. Some primary control signals to correct for example image aberrations of the primary beam-path, such as an astigmatism or field curvature are provided to the primary beam-path control module 830 and the image aberration is compensated in the primary beam path 13 alone. Some secondary control signals to correct for example image aberrations of the secondary beam-path are provided accordingly to projection system control module 820 and the image aberration is compensated in the secondary beam path 11 alone.

In step S4-4, a set of image processing control signals is provided to image stitching unit 812. The set of image processing control signals $IS_p$ is either directly applied or stored together with the image data stream for application in the image processing and image stitching operations performed by image stitching unit 812.

In optional step S4-5 (not shown), a set of stage control signals is provided to stage control module 880. In an example, a slow drift of the sample stage 500 is detected in step S2 and is compensated by a stage control signal.

In an example, at least subset of the set of control signals $C_p$ is divided into a subset of drift control components $CS_p$ and a subset of dynamic control components $CN_p$ according the separation of the temporal development of at least a subset of error amplitudes $A_n(t)$ in a drift part $S_n(t)$ and a dynamic change $N_n(t)$. The subset of drift control components $CS_p$ is provided to a set of compensators or active elements of the multi-beamlet charged-particle microscopy system. In an example the drift control components $CS_p$ are provided to a subset of slowly varying active components including magnetic elements and the slowly varying active components are driven to change their status. In an example the drift con-

trol components $CS_p$ are provided to the rapidly varying active elements such as electrostatic deflectors, electrostatic multi-pol correctors, or electrostatic multi-aperture elements. In an example the drift control components $CS_p$ are provided to both subsets of compensators. The subset of dynamic control components $CN_p$ is provided to rapidly varying active elements of the multi-beamlet charged-particle microscopy system, and the rapidly varying active components are driven to change their action on the charged particle beamlets. Rapidly varying active elements are electrostatic elements, such as electrostatic deflectors, electrostatic multi-pol correctors, electrostatic lenses, or electrostatic multi-aperture elements.

In general, the number of control signals P can exceed the number K of error amplitudes $A_k$, and $P \geq K$. Each of the control signals $C_p$ can change over time, and at least some of the control signals $C_p$ are changed during an image scan of an image patch 17. Thereby, for example a lateral drift of sample stage 500 is compensated during an image acquisition of one image patch. In an example, at least one control signal is a function depending on time and representing a predicted development of an error amplitude in a subsequent time interval. Thereby, a continuous control operation for compensation of a predicted imaging deviation is achieved.

In step S5, the set of control signals $C_p$ including the subsets of drift control components $CS_p$ and dynamic control components $CN_p$ are monitored and accumulated to record the history of the changes to the multi-beam charged particle microscope.

In step S6, an actual system status of the multi-beam charged particle microscope is estimated based on the history of the changes.

In optional step S7, the temporal development model functions Mn(t) are adapted to the history of the changes and the actual system status of the multi-beam charged particle microscope and provided to step S2.

In step S8, the actual system status of the multi-beam charged particle microscope is analyzed and the development of the system status is predicted during a subsequent image scan. If the prediction of systems status indicates that a development of an error vector reaches a value which is unable to be compensated, for example because the range of an actuator for compensation is likely to be reached during a subsequent image scan, a recalibration and reset of actuators of the multi-beam charged particle microscope is triggered before the subsequent image scan. In this case, a trigger signal is provided to step SI. If the prediction of systems status indicates that a next imaging task is possible, the method continues with step S0 to step S7 with the image acquisition of a subsequent image patch at next local wafer coordinate system from the list of inspection tasks.

In an example, in step S8, a drift component of a control signal is computed for example by prediction of the development of an error amplitude and provided to step S0. In step S0, the drift component is compensated by actuation of a compensator during the stage is moved from the first image patch to the next, second image patch or a next inspection site. Therefore, in step S0 control unit 800 provides a control signal to the stage control module 880 to move stage 500 from a first to a subsequent local wafer coordinate system, and further provides the drift component of the control signal to at least one of the control modules comprising the primary beam-path control module 830, the projection system control module 820 or the deflection control module 860.

As will be clear from the description, steps S1 to S7 of the method of operation run in parallel and are performed and interacting with each other in real time during an image acquisition of an image patch. A person of skill in the art will be able to recognize that variations and modifications of the method described above are possible.

In an embodiment of the invention, a change of object plane 101 or focus position of the plurality of primary charged particle beamlets is enabled while maintaining the specification requirements of a wafer inspection task. The reason for change of object plane 101 can for example be a predefined change of an imaging setting for image acquisition, for example a change of magnification or a change of numerical aperture, a change of the desired resolution or a drift of elements arranged in the primary beam path 13 or secondary beam path 11, such as monitored in step S7 or step S8. The change of the focal plane by magnetic objective lens 102 of a multi beam charged particle microscope 1 has the effect of a rotation to the plurality of primary charged particle beamlets 3. If the focus plane or object plane 101 is changed, the raster configuration of the plurality of primary charged particle beamlets is rotated with respect to the optical axis 105 of the multi beam charged particle microscope 1, as illustrated in Figure 3, and a rotation of the image coordinate system 51 with respect to a local wafer coordinate system 551 is produced. The semiconductor structures arrange on a wafer surface 25 are typically structures arrange orthogonal to each other. With a rotation of the image coordinate system or the scan paths 27 of the primary charged particle beamlets 3 with respect to the arrangement of the semiconductor structures as illustrated in figure 3b, at least some of the specification requirements of a high throughput wafer inspection task cannot be achieved. In addition, other image performance parameters are changed such as the telecentricity of the plurality of primary charged particle beamlets, or the magnification or pitch of the plurality of primary charged particle beamlets. The plurality of secondary electrons, emitted at the changed positions of the plurality of primary charged particle beam spots is collected by the adjusted objective lens 102, and the change of image performance parameters is increased. In the embodiment, the unwanted change of image performance parameters induced by change of the image plane or focus plane is compensated by control unit 800. Control unit 800 is configured to predict control signals to compensate the error amplitudes induced by change of an image plane position or focus position from a first image plane position to a second image plane position. Control unit 800 is configured to provide the control signals to compensators in the primary beam patch 13 and in the secondary beam path 11, and to the wafer stage. Compensators of the primary beam path comprise for example a second objective lens (not show in figure 1), field lenses 103.1 or 103.2, multi-aperture deflector array 306.3, or multi-aperture deflector array 390 arranged in proximity of the intermediate image plane 321. Compensators of the secondary beam path comprise for example a magnetic lens, a stigmator, or a multi-aperture array element. After a change of an image plane or focus position from a first to a second position is triggered, control unit 800 controls a plurality of elements including the compensators of primary and secondary beam path or the wafer stage in combination.

In an example, the control unit 800 or the multi-beam charged particle microscope 1 is configured to derive from a plurality of sensor data an error vector describing a deviation of the orientation of semiconductor structures from the image coordinate system 51 or the direction of the scan paths 27 or the plurality or primary charged particle beamlets, and is further configured to derive a set of control signals and provide the set of control signals to the control modules. The control modules are configured to effect at least one of a rotation of the plurality of primary charged particle beamlets, a rotation of the plurality of secondary electron beamlets, and a rotation of the sample stage 500. For example, control unit 800 is configured to provide control signals to step 0 of the method described above to cause a rotation by slow acting compensators including the wafer stage 500 or the objective lens 102. For example, control unit 800 is further configured to provide control signals to cause a rotation to fast acting compensators such as electrostatic deflector arrays arranged in the primary charged particle or in the secondary electron beam path or in both.

In an embodiment, the method of operating a multi-beam charged particle microscope configured for wafer inspection, is comprising a step a) of loading a set of predetermined normalized error vectors describing deviations from a set of image qualities in a memory; a step b) of loading a set of predetermined thresholds for the amplitudes of the set of predetermined normalized error vectors in a memory; and a step c) of loading a set of predetermined normalized drive signals for compensating each of the set of normalized error vectors in a memory. During the wafer inspection task is performed, the method of operating a multi-beam charged particle microscope comprises a step d) of receiving a plurality of sensor data from a plurality of sensors of the multi-beam charged particle microscope forming a sensor data vector. In an example, the plurality of sensor data comprises at least one of a position or speed information of the actual position and actual velocity of a wafer stage for holding a wafer during inspection with the multi-beam charged particle microscope. During the wafer inspection task is performed, the method of operating the multi-beam charged particle microscope is further comprising a step e) of determining a set of actual amplitudes of predetermined normalized error vectors from the sensor data vector, representing an actual state of the set of image qualities of the multi-beam charged particle microscope; a step f) of deriving during a wafer inspection a set of control signals from the set of actual amplitudes and a set of actual drive signals from the set of predetermined normalized drive signals; and a step g) of providing during a wafer inspection the set of actual drive signals to a set of compensators, thereby reducing during operation of the multi-beam charged particle microscope the subset of actual amplitudes below the subset of thresholds determined in step b). In an example, the method of operating the multi-beam charged particle microscope is further comprising a step h) of predicting during a wafer inspection a subset of development amplitudes of at least a subset of the set of actual amplitudes according an expected development of the multi-beam charged particle microscope in a prediction time interval. In an example, the expected development of the multi-beam charged particle microscope in the prediction time interval is determined according to one of a prediction model function or a linear, second order or higher order extrapolation of the history of a set of actual amplitudes. The method of operating the multi-beam charged particle microscope is further comprising a step i) of deriving during a wafer inspection a set of predictive control signals from the set of development amplitudes and a set of predictive drive signals from the set of predictive control signals; a step j) of providing during a wafer inspection the set of predictive drive signals to the set of compensators in time sequential manner, thereby reducing during operation of the multi-beam charged particle microscope in the prediction time interval the subset of actual amplitudes below the subset of thresholds; and a step k) of recording during a wafer inspection at least a subset of the set of actual amplitudes of the multi-beam charged particle microscope for generating a history of the subset of the set of actual amplitudes.

The method of operation of the multi-beam charged particle microscope is prepared before the operation by the steps of selecting the set of compensators of the multi-beam charged particle microscope. In an example, the set of compensators comprise a first deflection unit of the multi-beam charged particle microscope for scanning and deflecting the plurality of primary charged particles and a second deflection unit for scanning and deflecting the plurality of secondary electrons generated during use of the multi-beam charged particle microscope. The method of operation of the multi-beam charged particle microscope is further prepared previous to the operation by the steps of determining the set of predetermined normalized error vectors describing deviations from a set of image qualities, and determining a sensitivity matrix according a linear perturbation model by variation of at least a drive signal for each of the compensators of the set of compensators, and determining the set of predetermined normalized drive signals from the sensitivity matrix for compensating each of the set of predetermined normalized error vectors.

It is understood that the components of the multi-beam charged particle microscope described in conjunction with Figure 6 and the method steps described in conjunction with Figure 7 are simplified examples to illustrate the configuration and method of operation of the multi-beam charged particle microscope for wafer inspection according the invention. At least some of the method steps or components can be combined, for example control operation processor 840 and sensor data analysis system 818 can be combined in one unit, or the primary beam-path control module 820 can be combined in control operation processor 840.

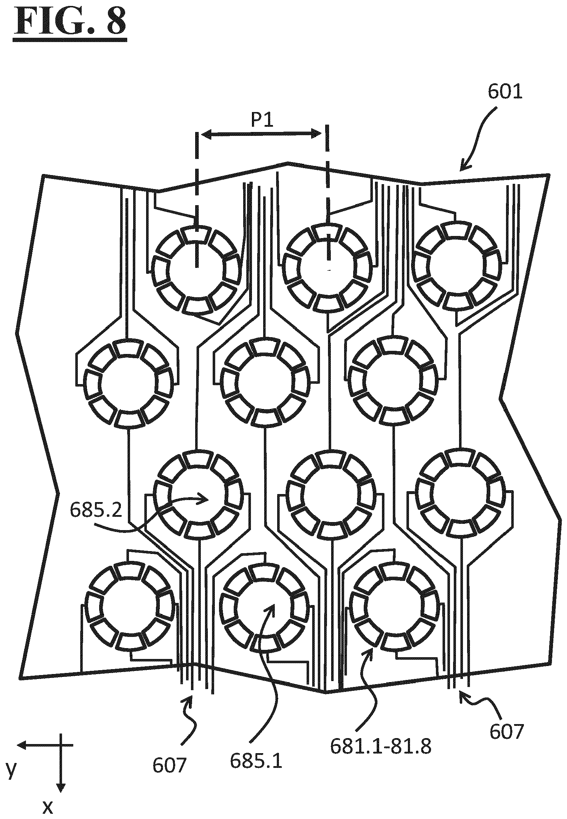

At least one of the compensators used in embodiments described above are multi-beam active array elements. With an electrostatic micro-lens array, electrostatic stigmator array or electrostatic deflector array in the primary charged particle beam path, each of the individual primary charged particle beamlet of the plurality of primary charged particle beamlets is influenced individually. By example, such a multi-aperture array 601 is illustrated in figure 8. The multi-aperture array 601 comprises a plurality of apertures arranged in the raster configuration of the plurality of primary charged particle beamlets - in this example a hexagonal raster configuration. Two of the apertures are illustrated with reference numbers 685.1 and 685.2. In the circumference of each of the plurality of apertures, a plurality of electrodes 681.1-681.8 is arranged, in this example the number of electrodes is eight, but other numbers such as one, two, four or more are possible as well. The electrodes are electrically insulated with respect to each other and with respect to a carrier of the multi aperture array 601. Each of the plurality of electrodes is connected by one of the electrically conductive lines 607 to a control module. By application of individual and predetermined voltages to each of the electrodes 681, different effects can be achieved for each the plurality of primary charged particle beamlets passing each of the apertures 685. Since only electrostatic effects are used, the charged particle beamlet transmitting an aperture 685 can be adjusted or changed individually with high speed and high frequency. For example, the effect can be a deflection, a change of focus plane, a correction of astigmatism of a primary charged particle beamlet. In an example, a plurality of for example two or three of such multi aperture plates is arranged in sequence. With an electrostatic micro-lens array, electrostatic stigmator array or electrostatic deflector array in the secondary electron beam path, each of the individual secondary electron beamlet of the plurality of secondary electron beamlets can be influenced individually in an analog way.

Next, a further embodiment of the invention is explained in more detail. A multi-beam charged particle microscope and a method for operating such microscope, configured for wafer inspection is described with reference to figure 1. As is understood from the description above, during acquisition of a digital image of for example the first image patch 17.1, the plurality of primary charged particle beamlets 3 and the plurality of secondary electrons 9 are jointly scanning deflected by the first deflection system 110 in the common beam path, and the plurality of secondary electrons 9 is further scanning deflected by the second deflection system 222 in the secondary beam path 11 in the detection unit 200. Thereby, the focus spots 15 of the plurality of secondary electron beamlets 9 on the image sensor 207 are kept at constant positions during the image scan. The detection unit 200 comprises an aperture 214, by which the plurality of secondary electron beamlets 9 is filtered. The aperture filter 214 thereby controls the topography contrast of the secondary electron beamlets provided to the image sensor 207. Due to deviations of the detection unit 200, for example due to a shift of the center of the cross over 212 of the plurality of secondary electron beamlets 9, or deviations of the second deflection system 222, the image contrast is changed. According to the embodiment, the unwanted changes of the topography contrast are detected and compensated. The detection unit 200 therefore comprises a third deflection system 218, and by the combined action of the first, the second and the third deflection units 110, 222, and 218, the center of the cross over 212 of the plurality of secondary electron beamlets 9 is kept in coincidence with the aperture stop position of aperture stop 214, and the positions of the secondary charged particle image spots 15 are kept constant on the image sensor 207. Thereby, wafer inspection according the specification requirements of a wafer inspection task is enabled. A constant image contrast is maintained for each of the plurality of secondary electron beamlets over the scan-paths 27.11...27.MN and within the different subfields 31.11...31.MN of an image patch 17.1. The position of the second and third deflection systems 222 and 218 in the projection system 205 of the detection unit 200 are illustrated in figure 1 by way of example, and other positions of the second and third deflection systems 222 and 218 in the projection system 205 are possible to achieve a constant image contrast as well a constant position of the focus points 15 of plurality of secondary electron beamlets 9 on the image sensor 207. For example, both second and third deflection systems 222 and 218 can be arranged in front of the aperture filter 214. The control unit 800 is configured to derive from a sensor data vector an amplitude of an error vector representing the contrast variation over the plurality of secondary electron beamlets 9 and is further configured to derive a first control signal and provides the first control signal to the deflection control module 860. The deflection control module 860 is configured to derive a deflection drive signal to the deflection systems including the second and third deflection systems 222 and 218, arranged in the secondary beam path 11 of the detection unit 200. In an example, the control module 800 is further configured to derive a second control signal and provides the second control signal to projection system control module 820. The projection system control module 820 is configured to derive a second drive signal to control further fast compensators 232 of the projection system 205, for example electrostatic lenses or stigmators of multi-array active element 220. Thereby, image contrast is maintained well within the performance specification of a wafer inspection task with high throughput. In a further example, the first deflection system 110 for scanning deflection of the plurality of primary charged particle beamlets 3 if preferably located in proximity to a first beam cross over 108 of the plurality of primary charged particle beamlets 3. However, due to deviations in the primary beam path 13, the position of the first beam cross over 108 can deviate from its design position and a telecentricity error for the plurality of primary charged particle beam lets 3 is introduced. The control unit 800 is configured to derive from the sensor data an amplitude of an error vector representing the deviation from a telecentric illumination of the wafer surface 25 by the plurality of primary charged particle beamlets 3, derive a control signal from the deviation, and provide a drive signal for example to a multi-aperture deflector 390 in proximity of an intermediate image plane 321. Thereby, a telecentric illumination of the wafer surface with the plurality of primary charged particle beamlets 3 is maintained. By telecentric illumination an illumination is meant in which each of the plurality of primary charged particle beamlets 3 impinges on the wafer surface 25 in parallel and almost perpendicular to the wafer surface 25, for example with an angle deviation from the surface normal below 25mrad.In the embodiments, the actual error amplitudes derived from the sensor data vector are representing image performance specification of a wafer inspection task, such as at least one of a relative position and orientation of the wafer stage with respect to the line of sight of the multi-beam charged particle microscope and an image coordinate system of the multi-beam charged particle microscope, a telecentricity condition, a contrast condition, an absolute position accuracy of the plurality of charged particle beamlets, a magnification or pitch of the multi-beam charged particle microscope, or a numerical aperture of the primary charged particle beamlets of the multi-beam charged particle microscope. Other deviations of the image performance specification of a wafer inspection task such as higher order aberrations such as distortion of the plurality of charged particle beamlets, astigmatism and chromatic aberrations can be monitored and compensated as well during an image scan. An amplitude of an error vector representing astigmatism, for example, can be derived from a data fraction of the image sensor and compensated by electrostatic compensators. An amplitude of an error vector representing chromatic aberration of the primary charged particle beamlets can for example be compensated by additional magnetic lens 420 of the beam splitter unit 400 and voltage supply unit 503. With a multi beam charged particle microscope according the embodiments or examples given above, a fast scanning of a wafer surface is enabled, and a high throughput examination of integrated semiconductor features is provided with the resolution of at least the critical dimension of down to few nm, for example below 2nm during the development or during manufacturing or for reverse engineering of semiconductor devices.

A plurality of primary charged particle beamlets is scanned in parallel over the surface of the wafer, and secondary charged particles are generated and are forming a digital image of an image patch of for example $100\mu m$ - $1000\mu m$ diameter. After acquisition of a first digital image of the first image patch, the substrate or wafer stage is moved to a next, second image patch position and the second digital image of the second image patch is obtained by again scanning of the plurality of primary charged particle beamlets. During operation and during each of the image acquisitions, a plurality of sensor data is generated by a plurality of detectors, including the image sensor and the stage position sensor, and a set of control signals is generated. The control signals are provided to control modules, which control the action of active elements such as deflection units for scanning of the plurality of primary and secondary charged particle beamlets, electrostatic lenses, magnetic lenses, stigmators, or active multi-aperture arrays or other compensators. For example, in between the acquisition of the first and second digital image and while the stage is moved from the first image patch to the second image patch, at least a subset of imaging aberrations is compensated for example by slow compensators such as magnetic elements. During the image acquisition of the digital images first or second image patch, a subset of control signals is provided to control modules including the deflection units. Thereby, for example a position error or a drift of the wafer stage relative to the line of sight of the multi-beam charged particle microscope is compensated during an image scan. Other aberrations or deviations from an imaging performance specification are determined and predicted from the sensor data and respective control signals to fast actuators are generated and provided in real time. Thereby, digital images with high image fidelity and high accuracy and a high resolution below 5nm or 2nm or 1nm resolution are formed by stitching multiple image subfields or patches together. The stage is moved between first and second image patches or to the next position of interest, for example the next PCM or an adjacent image field, with high speed and for example reduced times for iterative precision stage alignment.

As will be clear from the description, combinations and various modifications to the examples and embodiments are possible and can be applied in analogy to the embodiments or examples. Charged particle of the primary beam can for example be electrons, but also other charged particles such as He-Ions. Secondary electrons comprise secondary electrons in its narrow sense, but also any other secondary charged particle created by interaction of the primary charged particle beamlets with the sample, such as backscattered electrons or secondary electrons of second order, which are generated by backscattered electrons. In another example, secondary ions can be collected instead of secondary electrons.

Some embodiments might be further described by using following sets of clauses. The invention shall however not be limited to any of the sets of clauses:

**First set of Clauses**

Clause 1: A method of operating a multi-beam charged particle microscope (1) with high throughput and high resolution, comprising

- a first image acquisition of a first image patch 17.1 in a first time interval Ts1 and
- a second image acquisition of a second image patch 17.2 in a second time interval Ts2, and
- a third time interval Tr for moving the wafer stage (500) from a first center position (21.1) of the first image patch (17.1) to a second center position (21.2) of the second image patch 17.2, such that at least one of the first and second time interval Ts1 or Ts2 has an overlap with the third time interval Tr.

Clause 2: A method of operating a multi-beam charged particle microscope (1) according clause 1, wherein the second image acquisition of the second image patch 17.2 is initiated before the end of the third time interval Tr, when the wafer stage (500) has completely stopped.

Clause 3: A method of operating a multi-beam charged particle microscope (1) according clause 1 or 2, wherein the third time interval Tr of wafer movement is initiated before the end of the time interval Ts1, when an image acquisition of the first image patch 17.1 is finalized.

Clause 4: A method of operating a multi-beam charged particle microscope (1) according any of the clauses 1 to 3, further comprising the computation of a start time of the third time interval Tr of wafer movement during the first time interval Ts1 of image acquisition of the first image patch 17.1, such that a position deviation of the first center position of the first image patch 17.1 from a line of sight (53) of the multi-beam charged particle microscope (1) or a movement velocity of the wafer stage (500) are below a predetermined threshold.

Clause 5: A method of operating a multi-beam charged particle microscope (1) according any of the clauses 1 to 4, further comprising the computation of a start time of the second time interval Ts2 of the second image acquisition during the time interval Tr of wafer stage movement, such that a position deviation of the second center position 21.2 of the second image patch 17.2 from a line of sight (53) of the multi-beam charged particle microscope (1) or a movement velocity of the wafer stage (500) are below a predetermined threshold.

Clause 6: A method of operating a multi-beam charged particle microscope (1) according any of the clauses 1 to 5, further comprising the step of

- predicting a sequence of wafer stage positions during the time interval Tr of movement of the wafer stage (500)
- computing at least a first and a second control signal from the predicted wafer stage positions,
- providing the first control signal to a first deflection system (110) in the primary beam path (13) and the second control signal to a second deflection system (222) in the secondary beam path (11) of the multi-beam charged particle microscope (1).

Clause 7: A multi-beam charged particle system (1) with high throughput and high resolution, comprising

- a charged-particle multi-beamlet generator (300) for generating a plurality of primary charged particle beamlets (3),
- an object irradiation unit (100) comprising a first deflection system (110) for scanning a wafer surface (25) arranged in an object plane (101) with the plurality of primary charged particle beamlets (3) for the generation of a plurality of secondary electron beamlets (9) emitting from the wafer surface (25) at spot positions (5) of the plurality of primary charged particle beamlets (3),
- a detection unit (200) with a projection system (205), a second deflection system (222) and an image sensor (207) for imaging the plurality of secondary electron beamlets (9) onto the image sensor (207), and for acquisition during use a digital image of a first image patch (17.1) and a second image patch (17.2) of the wafer surface (25),
- a sample stage (500) comprising a stage motion controller, wherein the stage motion controller comprises a plurality of motors configured to be independently controlled, the stage configured for positioning and holding the wafer surface (25) in the object plane (101) during the acquisition of the digital image of the first image patch (17.1) and the second image patch (17.2),
- a plurality of detectors comprising the stage position sensor (520) and the image sensor (207), configured to generate during use a plurality of sensor data, the sensor data including position data of the sample stage (500),
- a control unit (800), configured for performing during use a first image acquisition of the first image patch 17.1 in a first time interval Ts1 and a second image acquisition of the second image patch 17.2 in a second time interval Ts2, and configured to trigger the sample stage (500) in a third time interval Tr for moving the sample stage (500) from a first center position (21.1) of the first image patch (17.1) to a second center position (21.2) of the second image patch 17.2, such that at least one of the first and second time interval Ts1 or Ts2 has an overlap with the third time interval Tr.

Clause 8: The system according clause 7, wherein the control unit is further configured for determining of a start time of the third time interval Tr of wafer movement during the first time interval Ts1 of image acquisition of the first image patch 17.1, such that a position deviation of the first center position of the first image patch 17.1 from a line of sight (53) of the multi-beam charged particle microscope (1) or a movement velocity of the wafer stage (500) are below a predetermined threshold.

Clause 9: The system according clauses 7 or 8, wherein the control unit is further configured for determining of a start time of the second time interval Ts2 of the second image acquisition during the time interval Tr of wafer stage movement, such that a position deviation of the second center position 21.2 of the second image patch 17.2 from a line of sight (53) of the multi-beam charged particle microscope (1) or a movement velocity of the wafer stage (500) are below a predetermined threshold.

Clause 10: The system according any of the clauses 7 to 9, wherein the control unit is further configured for predicting a sequence of wafer stage positions during the time interval Tr of movement of the wafer stage (500), and for computing at least a first and a second control signal from the predicted wafer stage positions, and for providing the first control signal to a first deflection system (110) in the primary beam path (13) and the second control signal to a second deflection system (222) in the secondary beam path (11) of the multi-beam charged particle microscope (1).

Clause 11: A method of operating a multi-beam charged particle system (1) with high throughput and high resolution, comprising:

- a first image acquisition of a first image patch 17.1, a second image acquisition of a second image patch 17.2 and moving the wafer stage (500) from a first center position (21.1) of the first image patch (17.1) to a second center position (21.2) of the second image patch 17.2, all within a time interval TG wherein
- the first image acquisition of a first image patch 17.1 is in a first time interval Ts1
- the second image acquisition of a second image patch 17.2 is in a second time interval Ts2, and
- moving the wafer stage (500) from a first center position (21.1) of the first image patch (17.1) to a second center position (21.2) of the second image patch 17.2 is in a third time interval Tr; and wherein

the time interval TG is smaller as the sum of Ts1, Ts2 and Tr: TG < Ts1 + Ts2 + Tr.

Clause 12: A multi-beam charged particle microscope (1) for wafer inspection, comprising:

- a charged-particle multi-beamlet generator (300) for generating a plurality of primary charged particle beamlets (3),
- an object irradiation unit (100) comprising a first deflection system (110) for scanning a wafer surface (25) arranged in an object plane (101) with the plurality of primary charged particle beamlets (3) for the generation of a plurality of secondary electron beamlets (9) emitting from the wafer surface (25) at the scanning spot positions (5) of the plurality of primary charged particle beamlets (3),
- a detection unit (200) with a projection system (205), a second deflection system (222) and an image sensor (207) for imaging the plurality of secondary electron beamlets (9) onto the image sensor (207), and for acquisition during use a digital image of a first image patch (17.1) and a second image patch (17.2) of the wafer surface (25),
- a sample stage (500) with a stage position sensor (520) for positioning and holding the wafer surface (25) in the object plane (101) during the acquisition of the digital image of the first image patch (17.1) and for moving the wafer surface from the first image patch (17.1) to the second image patch (17.2),
- a plurality of detectors comprising the stage position sensor (520) and the image sensor (207), configured to generate during use a plurality of sensor data, the sensor data including position data of the sample stage (500),
- a first compensator in the object irradiation unit (100) configured for displacing or rotating the scanning spot positions (5) of the plurality of primary charged particle beamlets (3) on the wafer surface (25),
- a second compensator in the projection system (205), configured for compensating the displacing or rotating scanning spot positions (5) of the plurality of primary charged particle beamlets (3) and keeping constant the spot positions (15) of the plurality of secondary electron beamlets (9) on the image detector (207),
- a control unit (800) configured to generate a first set of control signals Cp from the plurality of sensor data to synchronously control the first compensator in the object irradiation unit (100) and the second compensator in the projection system (205) during the acquisition of the digital image of the first image patch (17.1) or the second image patch (17.2).

Clause 13: A multi-beam charged particle microscope (1) according clause 12, wherein the control unit (800) is configured to compensate a change of a position or a change of an orientation of the sample stage (500) by computing and providing the first set of control signals $C_p$ to the first and the second compensators.

Clause 14: A multi-beam charged particle microscope (1) according any of clauses 12 or 13, wherein the control unit (800) is configured to compensate a change of a position of a line of sight (53) of the object irradiation unit (100) by computing and providing the first set of control signals $C_p$ the first and the second compensators.

Clause 15: A multi-beam charged particle microscope (1) according any of clauses 12 to 14, wherein the control unit (800) is configured to compensate a difference of a change of a position or a change of an orientation of the sample stage (500) and a change of a position of a line of sight (53) of the object irradiation unit (100) by computing and providing the first set of control signals $C_p$ to the first and the second compensators.

Clause 16: A multi-beam charged particle microscope (1) according any of thes clause 12 to 15, wherein the control unit (800) is configured to compensate a movement velocity of the sample stage (500) during the acquisition of the digital image of the first image patch (17.1) or the second image patch (17.2) by computing and providing the first set of control signals $C_p$ to the first and the second compensators.

Clause 17: A method of wafer inspection with a multi-beam charged particle microscope with following steps is given:

- a first image acquisition step of a first image patch during a first time interval Ts1,
- a movement of the wafer stage from the position of the first image patch to a second image patch during a time interval Tr,
- and a second image acquisition step of the second image patch during a second time interval Ts2, whereby,
- during the first time interval Ts1, at least a first error amplitude is computed from a plurality of sensor signals,
- during the first time interval Ts1, the development of the first error amplitude is predicted at least over the movement time interval Tr and the second time interval Ts2,
- and, at least during the movement time interval Tr a control signal is provided to control units of the multi-beam charged particle microscope for keeping the predicted development of error amplitude during the second time interval Ts2 below a predetermined threshold.

Clause 18: A method according clause 17, wherein the prediction of the development of the first error amplitude is generated according a prediction model or an extrapolation.

Clause 19: A method according clause 17 or 18, wherein the first error amplitude represents at least one of a displacement of a line of sight, a displacement of a wafer stage, a rotation of a wafer stage, rotation of a line of sight, a magnification error, a focus error, an astigmatism error, or a distortion error.

Clause 20: A method according any of the clause 17 to 19, wherein the control signal is provided to control units of the multi-beam charged particle microscope for controlling components comprising at least one of a wafer stage, a first deflection unit, a second deflection unit, a fast compensator of a multi-beamlet generation unit or a fast compensator of a detection unit.

Clause 21: A method of operation of a multi-beam charged particle microscope with a control unit, the method comprising a series of operational steps during an image acquisition of a sequence of image patches comprising a first image patch and a second, subsequent image patch, including

- expand a data stream forming a plurality of sensor data into set of error amplitudes,
- extract a set of drift control signals and a set of dynamic control signals, and
- provide the set of drift control signals to slowly acting compensators, and
- provide the set of dynamic control signals to fast acting compensators.

Clause 22: The method of clause 21, wherein the step of extracting the set of drift control signals and the set of dynamic control signals is performed during a time interval Ts1 of an image acquisition of a first image patch; and the step of providing the set of drift control signals to slowly acting compensators is performed during a time interval Tr of a movement of a substrate by using a substrate stage from the first image patch to the second image patch.

Clause 23: The method of clause 21 or 22, wherein the step of providing the set of dynamic control signals to fast acting compensators in performed in the time interval Ts1.

Clause 24: The method of clause 22 or 23, wherein the step of providing the set of dynamic control signals to fast acting compensators is further performed in a time interval Ts2 of an image scan of the second image patch.

Clause 25: The method of any of the clauses 21 to 24, further comprising a step of predicting a temporal development of at least one of the error amplitudes.

Clause 26: The method of clause 25, comprising predicting a slowly varying drift of at least one of the error amplitudes and predicting a rapidly varying dynamic change of at least one of the error amplitudes.

Clause 27: A non-transitory computer readable medium comprising a set of instructions that is executable by one or more processors of an apparatus to cause the apparatus to perform a method, wherein the apparatus includes a charged-particle source to generate a plurality of primary charged-particle beamlets and the method comprising:

- determining a lateral displacement of a stage, wherein the stage is movable in at least one of X-Y axes;
- determining a lateral displacement of a line of sight of an object irradiation unit; and
- instructing a controller to apply a first signal to deflect the plurality of primary charged-particle beamlets incident on the sample to at least partly compensate for the lateral displacements.

**Second set of Clauses**

Clause 1: A multi-beam charged-particle beam system comprising:

- a movable stage configured to hold a sample;
- an object irradiation unit configured to illuminate a surface of the sample with a plurality of focus spots of a plurality of primary charge particle beamlets
- a charged particle beam generator, configured for generating a plurality of primary charged-particle beamlets from a charged-particle source;
- a stage sensor configured for determining a lateral displacement or a rotation of the stage;
- an image sensor configured for determining a lateral displacement of a line of sight of the object irradiation unit; and
- a control unit configured for generating and applying at least an additional voltage signal to a first beam deflector in the object irradiation unit configured for generating during use an additional displacement or rotation of the plurality of primary charged particle beamlets for at least partly compensating the difference between a lateral displacement of the line of sight and the lateral displacement or rotation of the stage.

Clause 2: The system according clause 1, wherein the control unit is further configured to compute the lateral displacement or rotation of the stage corresponding to a difference between a current position of the stage and a target position of the stage during scanning of the plurality of primary charged-particle beamlets on the sample surface.

Clause 3: The system according clauses 1 or 2, wherein the control unit is further configured to compute the lateral displacement of the line of sight corresponding to a difference between a current position of the line of sight and a target position of the line of sight during scanning of the plurality of primary charged-particle beamlets on the sample surface.

Clause 4: The system according clauses 2 or 3 , wherein the control unit and the first beam deflector are further configured for dynamically adjusting at least one driving voltage signal during scanning of the primary charged-particle beamlets on the sample.

Clause 5: The system according any of the clauses 1 to 4, further comprising a second beam deflector in the secondary electron beam-path, configured for at least partly compensating the additional displacement or rotation of the plurality of secondary electron beam lets originating from the beam spot positions of the plurality of primary charged particle beamlets during scanning.

Clause 6: The system according any of the clauses 1 to 5, wherein the control unit is further comprising a stage motion controller, wherein the stage motion controller comprises a plurality of motors configured to be independently controlled by a control signal.

Clause 7: The system according any of the clauses 1 to 6, wherein the control unit comprises a processor which is configured for deriving a plurality of error vector amplitudes based on a plurality of sensor signals and extracting at least one of the plurality of control signals from the plurality of error vector amplitudes.

Clause 8: A method for irradiating a sample disposed on a stage in a multi-beam charged-particle beam system, the method comprising:

- generating a plurality of primary charged-particle beamlets from a charged-particle source;
- determining a lateral displacement or a rotation of the stage, wherein the stage is movable in a x-y plane; and
- determining a line of sight of the multi-beam charged particle system;
- determining a displacement vector from the lateral displacement or rotation of the stage and the position of the line of sight;
- applying at least an additional voltage signal to the beam deflector in the primary charged particle beam-path for generating during use an additional displacement or rotation of the plurality of primary charged particle beamlets for at least partly compensating the displacement vector corresponding to the lateral displacement or rotation of the stage relative to the position of the line of sight.

Clause 9: The method of clause 8, wherein the lateral displacement or rotation of the stage corresponds to a difference between a current position of the stage and a target position of the stage, and wherein the rotation displacement varies during scanning of the plurality of primary charged-particle beamlets on the sample surface.

Clause 10: The method of any one of clauses 8-9, further comprising dynamically adjusting at least one of the voltage signals during scanning of the primary charged-particle beamlets on the sample.

Clause 11: The method of any one of clauses 8 - 10, further comprising

- applying at least a second additional voltage signal to the beam deflector in the secondary electron beam-path for at least partly compensating the additional displacement or rotation of the plurality of secondary electron beamlets originating from the beam spot positions of the plurality of primary charged particle beamlets during scanning.

Clause 12: The method of any one of clauses 8-11, further comprising applying a control signal to a stage motion controller, wherein the stage motion controller comprises a plurality of motors configured to be independently controlled by the control signal.

Clause 13: The method of any one of clauses 8-12, further comprising

- deriving a plurality of error vector amplitudes based on a plurality of sensor signals; and extracting at least one of the plurality of control signals from the plurality of error vector amplitudes.

**Third set of Clauses**

Clause 1: A multi-beam charged particle microscope (1) for wafer inspection, comprising:

- a charged-particle multi-beamlet generator (300) configured for generating a plurality of primary charged particle beamlets (3) in a raster configuration (41),
- an object irradiation unit (100) configured for irradiating a wafer surface (25) arranged in an object plane (101) with the plurality of primary charged particle beamlets (3) for the generation of a plurality of secondary electron beamlets (9) emitting from the wafer surface (25) at scanning spot positions (5) of the plurality of primary charged particle beamlets (3),
- a detection unit (200) with a projection system (205) and an image sensor (207) configured for imaging the plurality of secondary electron beamlets (9) onto the image sensor (207), and configured for acquisition of a digital image of a first image patch (17.1) of the wafer surface (25),
- a sample stage (500) with a stage position sensor (520) configured for positioning and holding during use a wafer surface (25) in an object plane (101) of the object irradiation unit (100),
- a first compensator (132, 110) in the object irradiation unit (100) configured for additionally displacing or rotating during use the scanning spot positions (5) of the plurality of primary charged particle beamlets (3) on the wafer surface (25),
- a second compensator (232, 222) in the projection system (205), configured for compensating during use the additionally displacement or rotation of the scanning spot positions (5) of the plurality of primary charged particle beamlets (3) and thereby keeping the spot positions (15) of the plurality of secondary electron beamlets (9) constant on the image detector (207); and
- a control unit (800), configured to compensate a displacement of the wafer surface (25) induced by a movement of the sample stage (500) with at least the first compensator (132,110) and the second compensator (232, 222).

Clause 2: A multi-beam charged particle microscope (1) according clause 1, wherein the first compensator (132, 110) is comprising one of an electrostatic lens, electrostatic deflector, electrostatic stigmator, electrostatic micro-lens array, electrostatic stigmator array, or an electrostatic deflector array.

Clause 3: A multi-beam charged particle microscope (1) according any of the clauses 1 or 2, wherein the control unit (800) is configured to generate a first set of control signals $C_p$ to synchronously control the first compensator (132, 110) in the object irradiation unit (100) and the second compensator (232) in the projection system (205) during the acquisition of the digital image of the first image patch (17.1).

Clause 4: A multi-beam charged particle microscope (1) according any of the clauses 1 to 3, further comprising a third compensator (330, 332) in the charged-particle multi-beamlet generator (300) configured for additionally displacing or rotating during use the scanning spot positions (5) of the plurality of primary charged particle beamlets (3) on the wafer surface (25).

Clause 5: A multi-beam charged particle microscope (1) according clause 4, wherein the control unit (800) is configured to generate a first set of control signals $C_p$ to synchronously control any of the first compensator (132, 110) in the object irradiation unit (100), the second compensator (232, 222) in the projection system (205) or the third compensator (330, 332) in the charged-particle multi-beamlet generator (300) during the acquisition of the digital image of the first image patch (17.1).

Clause 6: A multi-beam charged particle microscope (1) according any of the clauses 1 to 5, further comprising a plurality of detectors comprising the stage position sensor (520) and the image sensor (207), configured to generate during use a plurality of sensor data.

Clause 7: A multi-beam charged particle microscope (1) according clause 6, wherein the control unit (800) is configured to derive from the plurality of sensor data a driving signal for the first compensator (132, 110) in the object irradiation unit (100) to achieve an additional displacement of the scanning spot positions (5) of the plurality of primary charged particle beamlets (3) synchronized with a displacement of the wafer surface (25).

Clause 8: A multi-beam charged particle microscope (1) according clause 7, wherein the additional displacement comprises a rotation of the raster configuration (41) of the plurality of primary charged particle beamlets (3).

Clause 9: A multi-beam charged particle microscope (1) according any of the clauses 6 to 8, wherein the control unit (800) is configured to compensate the additional displacement of the spot positions (5) on the displaced wafer surface (25) by the second compensator (232, 222) in the projection system (205), wherein the second compensator (232, 222) in the projection system (205) is configured to operate synchronized with the first compensator (132, 110) in the object irradiation unit (100), thereby keeping constant the spot positions of the plurality of secondary electron beamlets (9) on the image detector (207).

Clause 10: A multi-beam charged particle microscope (1) according any of the preceding clauses, wherein the first compensator in the object irradiation unit (100) is the first deflection system (110), and wherein the control unit (800) is configured to compensate a displacement or a rotation of the sample stage (500) relative to a line of sight (53) of the object irradiation unit (100) by computing and providing a control signal for an additional displacement or rotation of the scanning spot positions (5) of the plurality of primary charged particle beamlets (3) to the first deflection system (110).

Clause 11: A multi-beam charged particle microscope (1) according any of the preceding clauses, wherein the second compensator the projection system (205) is the second deflection system (222), and wherein the control unit (800) is configured to compensate the additional displacement or rotation of the scanning spot positions (5) of the plurality of primary charged particle beamlets (3) on the displaced wafer surface (25) by computing and providing a control signal to the second deflection system (110).

Clause 12: A multi-beam charged particle microscope (1) according any of the preceding clauses, comprising at least one of a further compensator of the charged-particle multi-beamlet generator (300), a further compensator of the detection unit (200), or a further compensator of the object irradiation unit (100).

Clause 13: A multi-beam charged particle microscope (1) according any of the preceding clauses, wherein the control unit (800) comprises a sensor data analysis system (818) configured to analyze during use the plurality of sensor data and to compute during use a set of K amplitudes Ak of K error vectors.

Clause 14: A multi-beam charged particle microscope (1) according clause 13, wherein the control unit (800) comprises an image data acquisition unit (810) which is configured to reduce during use the image sensor data from the image sensor (207) to an image sensor data fraction representing less than 10%, preferably less than 2% of the image sensor data and to provide the image sensor data fraction to the sensor data analysis system (818).

Clause 15: A multi-beam charged particle microscope (1) according clause 14, wherein the image data acquisition unit (810) is configured to reduce during use the image sensor data from the image sensor (207) to an image sensor data fraction comprising digital image data of a plurality of secondary electron beamlets at a reduced sampling rate.

Clause 16: A multi-beam charged particle microscope (1) according clause 14, wherein the image data acquisition unit (810) is configured to reduce during use the image sensor data from the image sensor (207) to an image sensor data fraction comprising digital image data of a reduced set of secondary electron beamlets (9).

Clause 17: A multi-beam charged particle microscope (1) according any of the clauses 13 to 16, wherein the sensor data analysis system (818) is configured to predict a temporal development of at least one amplitude An of the set of amplitudes Ak of error vectors.

Clause 18: A multi-beam charged particle microscope (1) according any of clauses 13 to 17, wherein the control unit (800) further comprises a control operation processor (840) for computing the first set of control signals Cp from the set of amplitudes Ak of error vectors.

Clause 19: A multi-beam charged particle microscope (1) according any of clauses 13 to 18, wherein the sensor data analysis system (818) is configured to derive a sensor data vector DV of length L from the plurality of sensor data, with L >= K.

Clause 20: A multi-beam charged particle microscope (1) according any of clauses 4 to 19, wherein the control unit (800) is configured to compensate a rotation of the sample stage (500) by computing and providing at least one of the control signals of the first set of control signals Cp to the third compensator (330, 332) to induce a rotation of the raster configuration (41) of plurality of primary charged particle beamlets (3).

Clause 21: A multi-beam charged particle microscope (1) according any of clauses 1 to 20, wherein the control unit (800) is further configured to generate a control signal for moving the wafer surface (25) by the wafer stage (500) to a second center position of a second image patch (17.2) in the object plane (101) for image acquisition of a digital image of a second image patch (17.2).

Clause 22: A multi-beam charged particle microscope (1) according clause 21, wherein the control unit (800) is further configured to compute a second set of P control signals Cp from the plurality of sensor data to control of any of the compensators during the time interval Tr of movement of the wafer stage (500) to the second center position of the second image patch (17.2).

Clause 23: A multi-beam charged particle microscope (1) according any of the clauses 21 to 22, wherein the control unit (800) is further configured to compute a start time of the image acquisition of the second image patch (17.2) during time interval Tr and to start the image acquisition of the second image patch (17.2) during a deceleration time interval Td of the wafer stage (500), and wherein the control unit (800) is further configured to provide at least an offset signal of a predicted offset position of the wafer stage (500) during time interval Td to the first and second compensators.

## Fourth set of Clauses

Clause 1: A multi-beam charged-particle beam system comprising:

- a stage configured to hold a sample and is movable in at least one of X-Y and Z axes;
- a position sensing system configured to determine a lateral and vertical displacement or rotation of the stage; and
- a controller configured to: apply a first signal to deflect a plurality of primary charged-particle beamlets incident on the sample to at least partly compensate for the lateral displacement of the stage; and apply a second signal to deflect a plurality of secondary electron beamlets to at least partially compensate the displacement of the plurality of secondary electron beamlets originating from the deflected primary charged-particle beamlet position on the sample.

Clause 2: The system of clause 1, wherein the first signal comprises an electrical signal affecting how the plurality of primary charged-particle beamlets is deflected in the at least one of X-Y axes.

Clause 3: The system of clause 2, wherein the electrical driving signal comprises a signal having a bandwidth in a range of 0.1 kHz to 10 kHz.

Clause 4: The system of any one of clauses 1 to 3, wherein the lateral displacement corresponds to a difference between a current position of the stage and a target position of the stage in the at least one of X-Y axes.

Clause 5: The system of any one of clauses 1 to 4, wherein the controller is further configured to dynamically adjust at least one of the first signal or the second signal during scanning of the plurality of primary charged-particle beamlets on the sample.

Clause 6: The system of any one of clauses 1 to 5, further comprising a stage motion controller, wherein the stage motion controller comprises a plurality of motors configured to be independently controlled by a third signal.

Clause 7: The system of clause 6, wherein each of the plurality of motors are independently controlled to adjust a tilt of the stage, such that the stage is substantially perpendicular to an optical axis of the primary charged-particle beam.

Clause 8: The system of any one of clauses 6 or 7, wherein the plurality of motors comprises at least one of a piezoelectric motor, piezoelectric actuator, or an ultrasonic piezomotor. Clause 9: The system according any of the clause 1 to 8, further comprising: a first component configured to form a plurality of error vector amplitudes based on a plurality of sensor signals; and a second component configured to extract at least one of the plurality of control signals from the plurality of error vector amplitudes.

Clause 10: The system according clause 9, wherein the first component is configured to form the plurality of error vector amplitudes based on the lateral displacement of the stage and of an actual position of a line of sight of the multi-beam charged-particle beam system.

Clause 11: The system of clause 9 or 10, wherein the extraction of at least one of the plurality of control signals is based on a predictive model of the plurality of error vector amplitudes.

Clause 12: The system of any one of clauses 9 or 11, wherein the extraction of at least one of the plurality of control signals is further based on a predictive model of an actuation output of the stage.

Clause 13: The system of any one of clauses 1-12, wherein the position sensing system determines the lateral and vertical displacement and rotation of the stage using any of a laser interferometer, a capacitive sensor, a confocal sensor array, a grating interferometer or a combination thereof.

**Fifth set of clauses**

Clause 1: A method for irradiating a sample disposed on a stage in a multi-beam charged-particle beam system, the method comprising:

- generating a plurality of primary charged-particle beamlets from a charged-particle source;
- determining a lateral displacement and rotation of the stage, wherein the stage is movable in at least one of X-Y and Z axes;
- applying a first signal to deflect the plurality of primary charged-particle beamlets incident on the sample to at least partly compensate for the lateral displacement or rotation of the stage; and
- applying a second signal to deflect a plurality of secondary electron beamlets to at least partially compensate the displacement of the plurality of secondary electron beamlets originating from the deflected primary charged-particle beamlet position on the sample.

Clause 2: The method of clause 1, wherein the first signal comprises an electrical signal affecting how the primary charged-particle beam is deflected in the at least one of X-Y axes.

Clause 3: The method of any one of clauses 1-2, wherein the lateral displacement corresponds to a difference between a current position of the stage and a target position of the stage in the at least one of X-Y axes.

Clause 4: The method of any one of clauses 1 to 3, further comprising dynamically adjusting at least one of the first signal or the second signal during scanning of the plurality of primary charged-particle beam on the sample.

Clause 5: The method of any one of clauses 1 to 4, further comprising

- applying a third signal to a stage motion controller, wherein the stage motion controller comprises a plurality of motors configured to be independently controlled by the third signal.

Clause 6: The method of any one of clauses 1 to 5, further comprising

- deriving a plurality of error vector amplitudes based on a plurality of sensor signals; and extracting at least one of the plurality of control signals from the plurality of error vector amplitudes.

Clause 7: The method of clause 6, further comprising predicating at least one of the control signals based on a predictive model of temporal behavior of the plurality of error vector amplitudes.

Clause 8: The method of any one of clauses 6-7, further comprising predicating at least one of the plurality of control signals based on a predictive model of an actuation output of the stage.

**Sixth set of clauses**

Clause 1: A method of wafer inspection with a multi-beam charged particle microscope (1), with a plurality of detectors comprising an image sensor (207) and a stage position sensor (520), and with a set of compensators comprising at least a first and a second deflection system (110, 222),
the method comprising:

- positioning and aligning a wafer surface (25) of a wafer with a position of a local wafer coordinate system (551) with a line of sight of the multi-beam charged particle microscope (1),
- performing an image acquisition to acquire a digital image of a first image patch (17.1) of the wafer surface (25),
- collecting a plurality of sensor data from the plurality of detectors,
- deriving a set of K error amplitudes Ak from the plurality of sensor data,
- deriving a first set of control signals Cp from the set of error amplitudes Ak,
- providing the first set of control signals during step b of image acquisition to a set of compensators.

Clause 2: A method of wafer inspection with a multi-beam charged particle microscope (1) according clause 2, further comprising

- deriving a sensor data vector DV of length L from the plurality of sensor data, with L>= K.

Clause 3: A method of wafer inspection with a multi-beam charged particle microscope (1) according any of the clauses 1 to 2, further comprising

- deriving a temporal development of at least one amplitude An of the set of amplitudes Ak of error vectors.

Clause 4: A method of wafer inspection with a multi-beam charged particle microscope (1) according any of the clauses 1 to 3, further comprising

- compensating a change of a position or an orientation of the sample stage (500) by providing control signals Cp to the first and the second deflection unit (110, 222).

Clause 5: A method of wafer inspection with a multi-beam charged particle microscope (1) according any of the clauses 1 to 4, further comprising

- deriving a second set of control signals Cp from the set of error amplitudes Ak and providing the second set of control signals during step a) of positioning and aligning a wafer surface (25) of the wafer.

**Seventh set of clauses**

Clause 1: A method of operating a multi-beam charged particle microscope (1) configured for wafer inspection, comprising

- defining a set of image qualities and a set of predetermined, normalized error vectors describing deviations from the set of image qualities;
- determining a set of thresholds for the amplitudes of the set or normalized error vectors;
- selecting a set of compensators of the multi-beam charged particle microscope;
- determining a sensitivity matrix according a linear perturbation model by variation of at least a drive signal for each of the compensators of the set of compensators;
- deriving a set of normalized drive signals for compensating each of the set of normalized error vectors;
- storing the normalized drive signals, the set of thresholds and the normalized error vectors in a memory of a control unit of the multi-beam charged particle microscope.

Clause 2: A method of operating a multi-beam charged particle microscope (1) according clause 1, wherein the set of compensators comprises a first deflection unit (110) of the multi-beam charged particle microscope (1) for scanning and deflecting the plurality of primary charged particles (3) and a second deflection unit (222) for scanning and deflecting the plurality of secondary electron beamlets (9) generated during use of the multi-beam charged particle microscope (1).

**Eighth set of clauses**

Clause 1: A method of operating the multi-beam charged particle microscope (1), comprising

- a step of receiving during use a plurality of sensor data from a plurality of sensors of the multi-beam charged particle microscope (1) and forming a sensor data vector,
- a step of expanding the sensor data vector in a set of normalized error vectors stored in the memory of a control unit, and determining a set of actual amplitudes of normalized error vectors from the sensor data vector,
- a step of comparing the set of actual amplitudes with a set of thresholds stored in the memory of the control unit,

- a step of deriving a set of control signals from the set of actual amplitudes, based on the comparison of the set of actual amplitudes with a set of thresholds stored,
- a step of deriving a set of actual drive signals from a set of normalized drive signals, stored in the memory of the control unit, from the set of control signals,
- a step of providing the set of actual drive signals to a set of compensators of the multi-beam charged particle microscope (1), thereby reducing during operation of the multi-beam charged particle microscope (1) the set of actual amplitudes of the set of normalized error vectors below the set of thresholds.

Clause 2: A method of operating the multi-beam charged particle microscope (1) according clause 1, wherein the plurality of sensor data comprises at least one of a position or speed information of the actual position and actual velocity of a wafer stage (500) for holding or moving a wafer during inspection with the multi-beam charged particle microscope (1).

Clause 3: A method of operating the multi-beam charged particle microscope (1) according clause 1 or 2, wherein the plurality of sensor data comprises at least one of an actual position of a line of sight (52) during a wafer during inspection with the multi-beam charged particle microscope (1).

Clause 4: A method of operating the multi-beam charged particle microscope (1) according any of the clauses 1 to 3, wherein the steps are repeated at least twice, at least ten times, preferably every scanning line during acquisition of an image patch.

Clause 5: A method of operating the multi-beam charged particle microscope (1) according any of the clauses 1 to 4, further comprising a step of predicting during a wafer inspection a subset of development amplitudes of at least a subset of the set of actual amplitudes according an expected development of the multi-beam charged particle microscope in a prediction time interval.

Clause 6: A method of operating the multi-beam charged particle microscope (1) according any of the clauses 1 to 5, further comprising a step of recording during use at least a subset of the set of actual amplitudes of the multi-beam charged particle microscope for generating a history of the subset of the set of actual amplitudes.

Clause 7: A method of operating the multi-beam charged particle microscope (1) according any of the clauses 1 to 6, further comprising the step of deriving during a wafer inspection a set of predictive control signals from the set of development amplitudes and a set of predictive drive signals from the set of predictive control signals, and step of providing during a wafer inspection the set of predictive drive signals to the set of compensators in time sequential manner, thereby reducing during operation of the multi-beam charged particle microscope in the prediction time interval the subset of actual error amplitudes below the set of thresholds.

Clause 8: A multi-beam charged particle microscope with a control unit (800) and software code installed, configured for application of any of the methods according any of the clauses 1 to 7.

**Ninth set of Clauses**

Clause 1: A method of focusing a plurality of primary charged-particle beamlets on a sample, the method comprising:

- irradiating the sample disposed on a stage of a multi-beam charged-particle beam system with the plurality of primary charged-particle beamlets and forming a plurality of focus spots on a surface of the sample;
- adjusting, using at least a first component of the multi-beam charged-particle system, a location and rotation of the plurality of focus spots of the plurality of charged-particle beamlets with reference to the sample; and
- scanning, using a second component of the multi-beam charged-particle system, the focus spots of the plurality of primary charged-particle beamlets along a plurality predetermined primary scanning beam paths with reference to the sample; and
- dynamically manipulating, using either the first, the second or a third component, the predetermined scanning beam paths with reference to the sample.

Clause 2: A method according clause 1, wherein the method comprises adding at least a first deflection voltage to a first scanning voltage for scanning the focus spots of the plurality of primary charged-particle beamlets by using the second component.

Clause 3: A method according clauses 1 or 2, further comprising

- generating the plurality of primary charged particle beamlets by using a charged-particle multi-beamlet generator; and
- adjusting or dynamically manipulating, using a component of the charged-particle multi-beamlet generator, a location and rotation of a plurality of focus spots of the plurality of charged-particle beamlets with reference to the sample.

Clause 4: A method according any of the clauses 1 to 3, further comprising

- generating and collecting a plurality of secondary electron beamlets originating from the surface of the sample at the plurality of focus spot of the plurality of primary charged particle beamlets;
- scanning, using a fourth component of a projection system of the multi-beam charged-particle system, the plurality of secondary electron beamlets along predetermined secondary electron beam paths, such that the focus spots of the plurality of secondary electron beamlets are at constant positions on an image sensor;

- dynamically manipulating, using the forth component or a fifth component of the projection system of the multi-beam charged-particle system, the predetermined secondary electron beam paths with reference to the image sensor.

Clause 5: A method according clause 4, wherein the method comprises adding at least a second deflection voltage to a second scanning voltage for scanning the plurality of secondary charged-particle beamlets by using the fourth component.

Clause 6: A method according any of the clauses 1 to 5, further comprising:

- determining a current position of the stage; and
- determining a lateral displacement or a rotation of the stage from a difference between the current position of the stage and a target position of the stage.

Clause 7: A method according clause 6, further comprising:

- determining the first deflection voltage for compensating the lateral displacement or the rotation of the stage,
- providing the first deflection voltage to at least the first, the second or a third component, for dynamically manipulating the predetermined first scanning beam paths with reference to the sample.

Clause 8: A method according any of the clauses 6 or 7, further comprising:

- determining the second deflection voltage,
- providing the second deflection voltage to at least the fourth of fifth component, for dynamically manipulating the predetermined secondary electron beam paths with reference to the image sensor.

**Tenth set of clauses**

Clause 1: A multi-beam charged-particle beam system comprising:

- an object irradiation unit configured to illuminate a surface of the sample with a plurality of focus spots of a plurality of primary charge particle beamlets
- a first component of the object irradiation unit, configured for adjusting a location and rotation of the plurality of focus spots of the plurality of charged-particle beamlets with reference to the sample; and
- a second component of the object irradiation unit, configured for scanning the focus spots of the plurality of primary charged-particle beamlets along a plurality of predetermined primary scanning beam paths with reference to the sample; and
- a third component, configured for dynamically manipulating the predetermined scanning beam paths with reference to the sample position.

Clause 2: A multi-beam charged-particle beam system according clause 2, wherein the third component is the first component.

Clause 3: A multi-beam charged-particle beam system according clause 2, wherein the third component is the second component.

Clause 4: A multi-beam charged-particle beam system according clause 3, further comprising a control unit configured for adding at least a first deflection voltage configured for dynamically manipulating the predetermined scanning beam paths to a first scanning voltage provided to the second component configured for scanning the focus spots of the plurality of primary charged-particle beamlets.

Clause 5: A multi-beam charged-particle beam system according any of the clause 1 to 4, further comprising a charged-particle multi-beamlet generator configured for generating the plurality of primary charged particle beamlets.

Clause 6: A multi-beam charged-particle beam system according any of the clause 1 to 5, further comprising a control unit configured for adjusting during use a line of sight of the object irradiation unit with the first component.

Clause 7: A multi-beam charged-particle beam system according any of the clause 1 to 6, further comprising

- a projection system configured for collecting and imaging a plurality of secondary electron beamlets originating from the surface of the sample at the plurality of focus spot of the plurality of primary charged particle beamlets;
- an image sensor, configured for detecting a plurality of focus spots of the plurality of secondary electron beamlets;
- a fourth component of the projection system of the multi-beam charged-particle system, configured for scanning the plurality of secondary electron beamlets along predetermined secondary electron beam paths, such that the focus spots of the plurality of secondary electron beamlets are at constant positions on the image sensor;
- a fifth component of the projection system of the multi-beam charged-particle system, configured for dynamically manipulating the predetermined secondary electron beam paths with reference to the image sensor.

Clause 8: A multi-beam charged-particle beam system according clauses 7, wherein the fifth component is the fourth component.

Clause 9: A multi-beam charged-particle beam system according clause 8, wherein the control unit is further configured for adding at least a second deflection voltage configured for dynamically manipulating the predetermined secondary electron beam paths to a second scanning voltage provided to the fourth component for scanning the plurality of secondary charged-particle beamlets.

Clause 10: A multi-beam charged-particle beam system according any of the clause 1 to 9, further comprising a stage sensor configured for determining a lateral displacement or a rotation of the stage.

Clause 11: A multi-beam charged-particle beam system according clauses 10, wherein the control unit is further configured for deriving the first and the second deflection voltage from the lateral displacement or rotation provided by the stage sensor.

Clause 12: The system of any one of clauses 1 to 11, wherein the first component is located upstream of the second component.

**Eleventh set of clauses**

Clause 1: A method of performing a wafer inspection with a multi-beam charged-particle beam apparatus, the method comprising:

- irradiating the sample disposed on a stage with a plurality of primary charged-particle beamlets;
- performing a static adjustment of the focus points of the plurality of primary charged-particle beamlets;
- performing a dynamic manipulation of the focus points of the plurality of primary charged-particle beamlets.

Clause 2: A method according clause 1, further comprising:

- determining a slowly changing variation of the multi-beam charged-particle beam apparatus, comprising determination of a slowly changing variation of an object irradiation unit and detecting a drift of the stage configured to hold the sample;
- determine a first drift compensation signal to compensate the slowly changing variation; and
- applying the first drift compensation signal to at least a component of the object irradiation unit to perform the static adjustment of the focus points of the plurality of primary charged-particle beamlets.

Clause 3: A method according clause 2, wherein the determination of a slowly changing variation of the object irradiation unit comprises the determination of a slowly variation of a line of sight of the object irradiation unit.

Clause 4: A method according any of the clauses 1 to 3, further comprising:

- determining a dynamic variation of the multi-beam charged-particle beam apparatus, comprising determination of a dynamic variation of an object irradiation unit and detecting a vibration of the stage configured to hold the sample;
- determine a first dynamic compensation signal to compensate the dynamic variation; and
- applying the first dynamic compensation signal to at least a component of the object irradiation unit to perform the dynamic manipulation of the focus points of the plurality of primary charged-particle beamlets.

Clause 5: A method according clause 4, wherein the determination of a dynamic variation of the object irradiation unit comprises the determination of a dynamic change of a line of sight of the object irradiation unit.

Clause 6: A method according any of the clauses 2 to 5, further comprising:

- determining a second drift compensation signal to compensate the slowly changing variation; and
- applying the second drift compensation signal to at least a component of a projection unit to compensate the static adjustment of the plurality of secondary electron beamlets, originating from the adjusted focus points of the plurality of primary charged-particle beamlets.

Clause 7: A method according any of the clauses 4 to 6, further comprising:

- determining a second dynamic compensation signal to compensate the dynamic variation; and
- applying the second dynamic compensation signal to at least a component of a projection unit to compensate the dynamic manipulation of the plurality of secondary electron beamlets, originating from the dynamically manipulated focus points of the plurality of primary charged-particle beamlets.

Clause 8: The method of any one of clauses 1 to 7, wherein the determination of the first and second drift compensation signal is based on a predictive model of the temporal behavior of the multi-beam charged-particle beam apparatus.

Clause 9: The method of clause 8, wherein the determination of the first or second drift compensation signal and first or second dynamic compensation signal is based on a frequency analysis of the temporal behavior of the multi-beam charged-particle beam apparatus.

Clause 10: The method of any one of clauses 1 to 9, further comprising receiving a plurality of sensor signals, including sensor signals from a stage position sensor and an image sensor.

Clause 11: The method of clause 10, further comprising determining, using a control unit, the drift and dynamic compensation signal based on the received plurality of sensor signals.

Clause 12: The method of any one of clauses 1 to 11, further comprising

- estimating, using a processor of the control unit, a predictive model of the temporal behavior of the multi-beam charged-particle beam apparatus, and
- determining, using a control unit, the drift and dynamic compensation signal based on the predictive model.

Clause 13: The method of clause 12, wherein the estimating of the predictive model comprises a frequency analysis, a low pass filtering and a polynomial approximation.

Clause 14: The method of clause 12 or 13, further comprising synchronizing, using at least a delay line, the drift and dynamic compensation signals with the predictive model.

Clause 15: The method of any of the clauses 1 to 14, further comprising

- generating a beam deflection signal, based on a dynamic compensation signal,
- modifying a beam scanning signal with the beam deflection signal, and
- providing the modified beam scanning signal to a scanning beam deflection unit.

**Twelfth set of clauses**

Clause 1: A multi-beam charged particle microscope (1) for wafer inspection, comprising:

- a charged-particle multi-beamlet generator (300) for generating a plurality of primary charged particle beamlets (3),
- an object irradiation unit (100) comprising a first deflection system (110) for scanning a wafer surface (25) arranged in an object plane (101) with the plurality of primary charged particle beamlets (3) for the generation of a plurality of secondary electron beamlets (9) emitting from the wafer surface (25) at spot positions (5) of the plurality of primary charged particle beamlets (3),
- a detection unit (200) with a projection system (205), a second deflection system (222) and an image sensor (207) for imaging the plurality of secondary electron beamlets (9) onto the image sensor (207), and for acquisition during use a digital image of a first image patch (17.1) of the wafer surface (25),
- a sample stage (500) with a stage position sensor (520) for positioning and holding the wafer surface (25) in the object plane (101) during the acquisition of the digital image of the first image patch (17.1),
- a plurality of detectors comprising the stage position sensor (520) and the image sensor (207), configured to generate during use a plurality of sensor data, the sensor data including position data of the sample stage (500),
- a set of compensators comprising at least a compensator in the object irradiation unit (100) and a compensator in the projection system (205),
- a control unit (800) configured to generate a first set of control signals Cp from the plurality of sensor data to control the set of compensators during the acquisition of the digital image of the first image patch (17.1),
- wherein the control unit (800) is configured to compensate a displacement of the wafer surface (25) induced by a movement of the sample stage (500).

Clause 2: A multi-beam charged particle microscope (1) according clause 1, wherein the control unit (800) is configured to compensate a change of a position of a line of sight (53) of the object irradiation unit (100) by computing and providing the first set of control signals $C_p$ the first and the second compensators.

Clause 3: A multi-beam charged particle microscope (1) according any of the clauses 1 or 2, wherein the control unit (800) is configured to compensate a difference of a change of a position or a change of an orientation of the sample stage (500) and a change of a position of a line of sight (53) of the object irradiation unit (100) by computing and providing the first set of control signals $C_p$ to the first and the second compensators

**Thirteenth set of clauses**

Clause 1: A multi-beam charged particle microscope (1) for wafer inspection, comprising:

a. a charged-particle multi-beamlet generator (300) for generating a plurality of primary charged particle beamlets (3)

b. an object irradiation unit (100) comprising a first deflection system (110) for scanning a wafer surface (25) arranged in an object plane (101) with the plurality of primary charged particle beamlets (3) for the generation of a plurality of secondary electron beamlets (9) emitting from the wafer surface (25)

c. a detection unit (200) with a projection system (205), a second deflection system (222) and an image sensor (207) for imaging the plurality of secondary electron beamlets (9) onto the image sensor (207), and for acquisition during use a digital image of a first image patch (17.1) of the wafer surface (25),

d. a sample stage (500) with a stage position sensor (520) for positioning and holding the wafer surface (25) in the object plane (101) during the acquisition of the digital image of the first image patch (17.1),

e. a control unit (800),

f. a plurality of detectors comprising the stage position sensor (520) and the image sensor (207), configured to generate during use a plurality of sensor data, the sensor data including position data of the sample stage (500),

g. a set of compensators comprising at least the first and the second deflection system (110, 222),

wherein the control unit (800) is configured to generate a first set of control signals $C_p$ from the plurality of sensor data to control the set of compensators during the acquisition of the digital image of the first image patch (17.1).

Clause 2: A multi-beam charged particle microscope (1) according clause 1, wherein the set of compensators further comprises at least one of a compensator (330, 332) of the charged-particle multi-beamlet generator (300) and a compensator (230, 232) of the detection unit (200).

Clause 3: A multi-beam charged particle microscope (1) according any of clause 1 or 2, wherein the control unit (800) comprises a sensor data analysis system (818) configured to analyze during use the plurality of sensor data and to compute during use a set of K amplitudes $A_k$ of K error vectors.

Clause 4: A multi-beam charged particle microscope (1) according clause 3, wherein the control unit (800) comprises an image data acquisition unit (810) which is configured to reduce during use the image sensor data from the image sensor (207) to an image sensor data fraction representing less than 10%, preferably less than 2% of the image sensor data and to provide the image sensor data fraction to the sensor data analysis system (818).

Clause 5: A multi-beam charged particle microscope (1) according any of clauses 3 or 4, wherein the sensor data analysis system (818) is configured to predict a temporal development of at least one amplitude $A_n$ of the set of amplitudes $A_k$ of error vectors.

Clause 6: A multi-beam charged particle microscope (1) according any of clauses 3 to 5, wherein the control unit (800) further comprises a control operation processor (840) for computing the first set of control signals $C_p$ from the set of amplitudes $A_k$ of error vectors.

Clause 7: A multi-beam charged particle microscope (1) according any of clauses 3 to 6, wherein the sensor data analysis system (818) is configured to derive a sensor data vector DV of length L from the plurality of sensor data, with L > K.

Clause 8: A multi-beam charged particle microscope (1) according any of clauses 1 to 7, wherein the control unit (800) is configured to compensate a change of a position or a change of an orientation of the sample stage (500) by computing and providing at least one of the control signals of the first set of control signals $C_p$ to the first and the second deflection unit (110, 222).

Clause 9: A multi-beam charged particle microscope (1) according any of clauses 1 to 8, wherein the control unit (800) is configured to compensate a change of a position of a line of sight (53) of the object irradiation unit (100) by computing and providing at least one of the control signals of the first set of control signals $C_p$ to the first and the second deflection unit (110, 222).

Clause 10: A multi-beam charged particle microscope (1) according any of clauses 1 to 9, wherein the control unit (800) is configured to compensate a difference of a change of a position or a change of an orientation of the sample stage (500) and a change of a position of a line of sight (53) of the object irradiation unit (100) by computing and providing at least one of the control signals of the first set of control signals $C_p$ to the first and the second deflection unit (110, 222).

Clause 11: A multi-beam charged particle microscope (1) according any of clauses 1 to 10, wherein the charged-particle multi-beamlet generator (300) further comprises a fast compensator (330), and the control unit (800) is configured to compensate a rotation of the sample stage (500) by computing and providing at least one of the control signals of the first set of control signals $C_p$ to the fast compensator (330) to induce a rotation of the plurality of primary charged particle beamlets.

Clause 12: A multi-beam charged particle microscope (1) according any of clauses 1 to 11, wherein the control unit (800) is further configured to generate a third control signal for moving the wafer surface (25) by the wafer stage (500) to a second center position of a second image patch 17.2 in the object plane (101) for image acquisition of a digital image of a second image patch (17.2).

Clause 13: A multi-beam charged particle microscope (1) according clause 12, wherein the control unit (800) is further configured to compute a second set of P control signals $C_p$ from the plurality of sensor data to control the set of compensators during the time interval Tr of movement of the wafer stage (500) to the second center position of the second image patch (17.2).

Clause 14: A multi-beam charged particle microscope (1) according any of the clauses 12 to 13, wherein the control unit (800) is further configured to compute a start time of the image acquisition of the second image patch 17.2 during time interval Tr and to start the image acquisition of the second image patch 17.2 during a deceleration time interval Td of the wafer stage (500), and wherein the control unit (800) is further configured to provide at least an offset signal of a predicted offset position of the wafer stage (500) during time interval Td to the first and second deflection systems (110, 222).

**Fourteenth set of clauses**

Clause 1: A method of improving throughput of a multi-beam charged particle microscope, comprising:

- generating a plurality of beam spots of a plurality of primary charged particle beamlets on a surface of a sample with a raster configuration with a beam pitch d1;
- scanning the plurality of primary charged particles collectively along predefined scan paths;
- controlling the beam pitch d1 of the plurality of primary charged particle beamlets;

wherein the controlling comprises compensating variations in the beam pitch d1 by using a compensator for manipulating the beam spot positions, thereby reducing an overlap area.

Clause 2: A method of clause 1, wherein the controlling comprises providing a control signal to a multi-beam multi-pole deflector device, for dynamically controlling the plurality of beam spot positions on the sample surface with high precision of below 100nm, below 70nm, or even below 30nm.

Clause 3: A method of clause 1 or 2, further comprising a step of sensing the focus spot positions on the sample surface by using an image sensor with high accuracy of below 100nm, below 70nm, or even below 30nm.

Clause 4: A method of any of the clauses 1 to 3, wherein the beam pith d1 is about $10\mu m$.

A non-transitory computer readable medium may be provided that stores instructions for a processor (for example of control unit 800, or sensor data analysis system 818) to carry out wafer inspection, wafer imaging, stage calibrations, displacement error calibration, displacement error compensation, manipulating the electromagnetic field associated with the sample, communicate with image data acquisition unit 810, activating an acceleration sensor, or executing an algorithm to estimate or predict a performance of the multi-beamlet charged-particle microscopy system 1 including the sample stage 500, and control operations of the multi-beamlet charged particle system. Common forms of non-transitory media include, for example, a hard disk, a solid state drive, any optical data storage medium, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge.

The block diagrams in the figures illustrate the architecture, functionality, and operation of possible implementations of systems, methods, and computer hardware or software products according to various exemplary embodiments of the present disclosure. In this regard, each block in a flowchart or block diagram may represent a module, segment, or portion of code, which comprises one or more executable instructions for implementing the specified logical functions. It should be understood that in some alternative implementations, functions indicated in a block may occur out of the order noted in the figures. For example, two blocks shown in succession may be executed or implemented substantially concurrently, or two blocks may sometimes be executed in reverse order, depending upon the functionality involved. Some blocks may also be omitted. It should also be understood that each block of the block diagrams, and combination of the blocks, may be implemented by special purpose hardware-based systems that perform the specified functions or acts, or by combinations of special purpose hardware and computer instructions.

It will be appreciated that the embodiments of the present disclosure are not limited to the exact construction that has been described above and illustrated in the accompanying drawings, and that various modifications and changes may be made without departing from the scope thereof. It will be appreciated that the invention is not limited to the set of clauses, and that various modifications and changes or other combinations of clauses may be made without departing from the scope thereof. It will be appreciated that the invention is not limited to either a method or an apparatus, but will cover any apparatus configured for operating according any method or any method utilizing elements and configurations of any apparatus of the description or the set of clauses.

A list of reference numbers used is provided:

| | |
|---|---|
| 1 | multi-beamlet charged-particle microscopy system |
| 3 | primary charged particle beamlets, forming the plurality of primary charged particle beamlets |
| 5 | primary charged particle beam focus spot |
| 7 | object or wafer |
| 9 | secondary electron beamlet, forming the plurality of secondary electron beamlets |
| 11 | secondary electron beam path |
| 13 | primary beam path |
| 15 | secondary charged particle image spot or focus spot |
| 17 | image patch, for example first or second image patch 17.1, 17.2 |
| 19 | overlapp area |
| 21 | image patch center positions |
| 25 | Wafer surface |
| 27 | scan-path of primary charged particle beamlet |
| 29 | center of an image subfield |
| 31 | image subfield |
| 33 | first inspection site |
| 35 | second inspection site |
| 37 | image subfield after scan rotation |
| 39 | overlap areas of subfields 31 |
| 41 | Raster configuration |
| 51 | image coordinate system |
| 53 | line of sight of the multi-beam charged particle microscope |
| 55 | displacement vector |
| 59 | rotation vector component |
| 61 | individual displacements of image spots |
| 100 | object irradiation unit |
| 101 | object plane |
| 102 | objective lens |
| 103.1, 103.2 | first and second field lens |
| 105 | optical axis of multi-beamlet charged-particle microscopy system |
| 108 | first beam cross over |

| | |
|---|---|
| 110 | first deflection system |
| 130 | slow compensators of object irradiation unit |
| 132 | dynamic of fast compensators of object irradiation unit |
| 138 | object irradiation unit sensors |
| 200 | detection unit |
| 205 | projection system |
| 206 | electrostatic lens |
| 207 | image sensor |
| 208 | imaging lens |
| 209 | imaging lens |
| 212 | second cross over |
| 214 | aperture |
| 216 | active element |
| 218 | third deflection system |
| 220 | multi-aperture corrector |
| 222 | second deflection system |
| 230 | slow compensators of secondary electron beam-path |
| 232 | fast compensators of detection unit |
| 238 | secondary electron beam-path sensors |
| 300 | charged-particle multi-beamlet generator |
| 301 | charged particle source |
| 303 | collimating lenses |
| 305 | primary multi-beamlet-forming unit |
| 306 | active multi-aperture plate arrangement |
| 307 | first field lens |
| 308 | second field lens |
| 309 | diverging electron beam |
| 311 | focus spots of primary electron beamlets |
| 321 | intermediate image plane |
| 330 | slow compensators of the multi-beamlet generator |
| 332 | fast compensators of the multi-beamlet generator |
| 390 | beam steering array or deflector array |
| 400 | beam splitter unit |
| 420 | magnetic focusing lens |
| 430 | slow compensators of beam splitting unit |
| 500 | sample stage |
| 503 | sample voltage supply |
| 520 | stage position sensors |
| 551 | local wafer coordinate system |
| 601 | active multi-aperture array |
| 607 | electrically conductive lines |
| 681 | electrodes |
| 685 | apertures or aperture array |
| 800 | control unit |
| 810 | image data acquisition unit |
| 812 | image stitching unit |
| 814 | image data memory |
| 818 | sensor data analysis system |
| 820 | projection system control module |
| 830 | primary beam-path control module |
| 840 | control operation processor |

| | |
|---|---|
| 860 | deflection control module |
| 880 | stage control module |
| 901 | error amplitude threshold |
| 903 | error amplitude gradient |
| 905 | error amplitude threshold window |
| 907 | error amplitude model function |
| 909 | error amplitude gradient |

**Claims**

1. A multi-beam charged-particle beam system comprising:

   - a movable stage configured to hold a sample;
   - an object irradiation unit configured to illuminate a surface of the sample with a plurality of focus spots of a plurality of primary charge particle beamlets;
   - a charged particle beam generator, configured for generating a plurality of primary charged-particle beamlets from a charged-particle source;
   - a stage sensor configured for determining a lateral displacement or a rotation of the stage;
   - an image sensor configured for determining a lateral displacement of a line of sight of the object irradiation unit; and
   - a control unit configured for generating and applying at least an additional voltage signal to a first beam deflector in the object irradiation unit configured for generating during use an additional displacement or rotation of the plurality of primary charged particle beamlets for at least partly compensating the difference between a lateral displacement of the line of sight and the lateral displacement or rotation of the stage.

2. The system according to claim 1, wherein the control unit is further configured to compute the lateral displacement or rotation of the stage corresponding to a difference between a current position of the stage and a target position of the stage during scanning of the plurality of primary charged-particle beamlets on the sample surface.

3. The system according to claim 1 or 2, wherein the control unit is further configured to compute the lateral displacement of the line of sight corresponding to a difference between a current position of the line of sight and a target position of the line of sight during scanning of the plurality of primary charged-particle beamlets on the sample surface.

4. The system according to claim 2 or 3, wherein the control unit and the first beam deflector are further configured for dynamically adjusting at least one driving voltage signal during scanning of the primary charged-particle beamlets on the sample.

5. The system according to any one of claims 1 to 4, further comprising a second beam deflector in the secondary electron beam-path, configured for at least partly compensating the additional displacement or rotation of the plurality of secondary electron beamlets originating from the beam spot positions of the plurality of primary charged particle beamlets during scanning.

6. The system according to one any of claims 1 to 5, wherein the control unit is further comprising a stage motion controller, wherein the stage motion controller comprises a plurality of motors configured to be independently controlled by a control signal.

7. The system according to any one of claims 1 to 6, wherein the control unit comprises a processor which is configured for deriving a plurality of error vector amplitudes based on a plurality of sensor signals and extracting at least one of the plurality of control signals from the plurality of error vector amplitudes.

8. A method for irradiating a sample disposed on a stage in a multi-beam charged particle beam system, the method comprising:

   - generating a plurality of primary charged-particle beamlets from a charged-particle source;
   - determining a lateral displacement or a rotation of the stage, wherein the stage is movable in a x-y plane; and
   - determining a line of sight of the multi-beam charged particle system;
   - determining a displacement vector from the lateral displacement or rotation of the stage and the position of the line of sight;
   - applying at least an additional voltage signal to the beam deflector in the primary charged particle beam-path for generating during use an additional displacement or rotation of the plurality of primary charged particle beamlets for at least partly compensating the displacement vector corresponding to the lateral displacement or rotation of the stage relative to the position of the line of sight.

9. The method of claim 8, wherein the lateral displacement or rotation of the stage corresponds to a difference between a current position of the stage and a target position of the stage, and wherein the rotation displacement varies during scanning of the plurality of primary charged-particle beamlets on the sample surface.

10. The method of any one of claims 8 to 9, further comprising

   - dynamically adjusting at least one of the voltage signals during scanning of the primary charged-particle beamlets on the sample.

11. The method of any one of claims 8 to 10, further comprising

   - applying at least a second additional voltage signal to the beam deflector in the secondary electron beam-path for at least partly compensating the additional displacement or rotation of the plurality of secondary electron beamlets originating from the beam spot positions of the plurality of primary charged particle beamlets during scanning.

12. The method of any one of claims 8 to 11, further comprising

   - applying a control signal to a stage motion controller, wherein the stage motion controller comprises a plurality of motors configured to be independently controlled by the control signal.

13. The method of any one of claims 8 to 12, further comprising

   - deriving a plurality of error vector amplitudes based on a plurality of sensor signals; and
   - extracting at least one of the plurality of control signals from the plurality of error vector amplitudes.

14. A non-transitory computer readable medium comprising a set of instructions that is executable by one or more processors of an apparatus to cause the apparatus to perform a method, wherein the apparatus includes a charged-particle source to generate a plurality of primary charged-particle beamlets and the method comprising:

   - determining a lateral displacement of a stage, wherein the stage is movable in at least one of X-Y axes;
   - determining a lateral displacement of a line of sight of an object irradiation unit; and
   - instructing a controller to apply a first signal to deflect the plurality of primary charged-particle beamlets incident on the sample to at least partly compensate for the lateral displacements.

# FIG.1

# FIG. 2

# FIG.3a

# FIG.3b

# FIG.4

a)

b)

FIG. 5

# FIG. 6

# FIG. 7

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7244949 B
- US 20190355545 A
- US 20190355544 A
- US 10535494 B
- US 9336982 B
- US 9799485 B
- WO 2020136094 A2
- US 9530613 B
- DE 102019000470
- US 9536702 B
- US 9536702 A